(19) Europäisches Patentamt
European Patent Office
Office européen des brevets

(11) EP 0 564 255 B1

(12) **EUROPEAN PATENT SPECIFICATION**

(45) Date of publication and mention of the grant of the patent: **05.03.1997 Bulletin 1997/10**

(51) Int Cl.[6]: **G03B 27/53**, G03F 9/00

(21) Application number: **93302498.6**

(22) Date of filing: **30.03.1993**

(54) **Stage device and pattern transfer system using the same**

Vorlagenbühne und Musterübertragungssystem hierfür

Porte-original et système de transfert de dessin utilisant celui-ci

(84) Designated Contracting States:
**AT BE CH DE DK ES FR GB GR IE IT LI LU MC NL PT SE**

(30) Priority: **31.03.1992 JP 77559/92**
**22.02.1993 JP 32053/93**

(43) Date of publication of application:
**06.10.1993 Bulletin 1993/40**

(73) Proprietor: **CANON KABUSHIKI KAISHA**
**Tokyo (JP)**

(72) Inventors:
- **Iwamoto, Kazunori, c/o Canon Kabushiki Kaisha Ohta-ku, Tokyo (JP)**
- **Korenaga, Nobushige, c/o Canon Kabushiki Kaisha Ohta-ku, Tokyo (JP)**
- **Fukagawa, Youzou, c/o Canon Kabushiki Kaisha Ohta-ku, Tokyo (JP)**
- **Asano, Toshiya, c/o Canon Kabushiki Kaisha Ohta-ku, Tokyo (JP)**
- **Takahashi, Satoru, c/o Canon Kabushiki Kaisha Ohta-ku, Tokyo (JP)**

(74) Representative:
**Beresford, Keith Denis Lewis et al**
**BERESFORD & Co.**
**2-5 Warwick Court**
**High Holborn**
**London WC1R 5DJ (GB)**

(56) References cited:
**EP-A- 0 294 760**
**EP-A- 0 484 179**
**DE-A- 3 740 561**
**US-A- 4 425 537**
**US-A- 4 814 622**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).



Printed by Jouve, 75001 PARIS (FR)

## Description

This invention relates to a stage device and a pattern transfer system using the same.

In an exposure apparatus, a stage device is used in an alignment system, for example. In an exposure apparatus for manufacture of semiconductor devices, extraordinarily high exposure precision as well as highest throughput for highest productivity are required strongly. As for a stage device to be provided for making stepwise motion of a wafer, high precision positioning as well as quickness to assure highest throughput are required. Moreover, with recent increasing size of a wafer, a larger movable distance (i.e., stroke) is also required.

A known type movable stage device satisfying these requirements uses a linear motor as a driving means. However, in this type of movable stage, while the linear motor satisfies large stroke, high precision and quickness, the efficiency is low and as a result a large heat is produced during the motion. although the quantity of heat generation does not raise a large problem when the stage position is to be held, it causes a serious problem during acceleration in the initial period of motion. In an exposure apparatus such as an X-ray exposure apparatus, the heat generated by the linear motor can be transmitted to a wafer through the stage device. Therefore, if the step-and-repeat motion is made so frequently to improve the throughput, heat is accumulated in the wafer thus causing thermal distortion thereof.

European Patent EP-A-0439052 discloses a positioning stage device comprising:

a base stage and a movable stage supported on said base stage for translational movement with respect to said base stage along a predetermined direction;
coarse motion driving means directly engaging said movable stage for providing a relatively coarse positioning of said movable stage within a first range along said direction, and
fine motion driving means for providing a relatively fine positioning of said movable stage along said direction and within said first range.

With respect to the above prior art, the present invention is characterised in that said fine motion driving means engages directly with said movable stage and with said base stage, such that the moving force exerted by said fine motion driving means is directly applied between said movable stage and said base stage.

Embodiments of the present invention will now be described with reference to the accompanying drawings, in which:-

Figure 1 is a perspective view of a movable stage device according to a first embodiment of the present invention.

Figure 2A is a front view of the movable stage device of Figure 1.

Figure 2B is a sectional view taken on line A-A of Figure 2A.

Figure 3 is a schematic view for explaining the principle of operation of the movable stage device of Figure 1.

Figure 4 is a block diagram of a first example of drive control in the movable stage device of Figure 1.

Figure 5 is a time chart for explaining the operation of the drive control of the Figure 4 example, wherein the portion (a) shows the position of the movable stage with respect to driving time, the portion (b) shows the timing for switching an interchange switch, and the portion (c) shows an applied current to a linear motor.

Figure 6 is a block diagram of a second example of drive control in the movable stage device of Figure 1.

Figure 7 is a time chart for explaining the operation of the drive control of the Figure 6 example, wherein the portion (a) shows the position of the movable stage with respect to driving time, the portion (b) shows the timing for switching an interchange switch, and the portion (c) shows an applied current to a linear motor.

Figure 8 is a block diagram of a third example of drive control in the movable stage device of Figure 1.

Figure 9 is a time chart for explaining the operation of the drive control of the Figure 8 example, wherein the portion (a) shows the position of the movable stage with respect to driving time, and the portion (b) shows an applied current to a linear motor.

Figure 10 is a sectional view of a modified form of the movable stage device of Figure 1.

Figure 11 is a perspective view of a movable stage device according to a second embodiment of the present invention.

Figure 12 is a front view of the movable stage device of Figure 11.

Figures 13A and 13B show first driving means of the movable stage device of Figure 11, wherein Figure 13A is a front view and Figure 13B is a sectional view.

Figure 14 is a perspective view of a movable stage device according to a third embodiment of the present invention.

Figure 15 is a front view of the movable stage device of Figure 14.

Figure 16 is a sectional view, showing an example of second X-axis driving means of the movable stage device of Figure 14.

Figure 17 is a sectional view, showing an example of second Y-axis driving means of the movable stage device of Figure 14.

Figure 18 is a schematic view for explaining the principle of operation of the movable stage device of Figure 14.

Figure 19 is a block diagram of a first example of drive control in the movable stage device of Figure 14.

Figure 20 is a time chart for explaining the operation of the drive control of the Figure 19 example, wherein the portion (a) shows the position of the movable stage with respect to driving time, the portion (b) shows the timing for switching an interchange switch, and the portion (c) shows an applied current to a linear motor.

Figure 21 is a block diagram of a second example of drive control in the movable stage device of Figure 14.

Figure 22 is a time chart for explaining the operation of the drive control of the Figure 21 example, wherein the portion (a) shows the position of the movable stage with respect to driving time, the portion (b) shows the timing for switching an interchange switch, and the portion (c) shows an applied current to a linear motor.

Figure 23 is a block diagram of a third example of drive control in the movable stage device of Figure 14.

Figure 24 is a time chart for explaining the operation of the drive control of the Figure 23 example, wherein the portion (a) shows the position of the movable stage with respect to driving time, and the portion (b) shows an applied current to a linear motor.

Figure 25 is a schematic view for explaining the principle of operation of a modified form of the movable stage device of Figure 14.

Figure 26 is a block diagram of an example of drive control in the movable stage device of Figure 25.

Figure 27 is a time chart for explaining the operation of the drive control of the Figure 26 example, wherein the portion (a) shows the position of the movable stage with respect to driving time, the portion (b) shows the timing for switching an interchange switch, the portion (c) shows an applied current to a linear motor, the portion (d) shows changes in pressure within an air cylinder, the portion (e) shows the timing for switching an interchange valve, and the portion (f) shows changes in rigidity of the air cylinder.

Figure 28 is a perspective view of a movable stage device according to a fourth embodiment of the present invention.

Figure 29 is a front view of the movable stage device of Figure 28.

Figure 30 is a perspective view of a movable stage device according to a fifth embodiment of the present invention.

Figure 31A is a front view of the movable stage device of Figure 30.

Figure 31B is a sectional view taken on line A-A in Figure 31A.

Figure 32 is a schematic view for explaining the principle of operation of the movable stage device of Figure 30.

Figure 33 is a block diagram of a first example of drive control in the movable stage device of Figure 30.

Figure 34 is a time chart for explaining the operation of the drive control of the Figure 33 example, wherein the portion (a) shows the position of the movable stage with respect to driving time, the portion (b) shows the timing for switching a first interchange switch, the portion (c) shows an applied current to a linear motor, the portion (d) shows the timing for switching a second interchange switch, and the portion (d) shows changes counteracting to the linear motor.

Figure 35 is a block diagram of a second example of drive control in the movable stage device of Figure 30.

Figure 36 is a block diagram of a third example of drive control in the movable stage device of Figure 30.

Figure 37 is a time chart for explaining the operation of the drive control of the Figure 36 example, wherein the portion (a) shows the position of the movable stage with respect to driving time, the portion (b) shows the timing for switching an interchange switch, the portion (c) shows an applied current to a linear motor, and the portion (d) shows changes couteracting to the linear motor.

Figure 38 is a front view of a movable stage dcvice according to a sixth embodiment of the present invention.

Figure 39 is a sectional view taken on line A-A of Figure 38.

Figure 40 is a sectional view taken on line B-B of Figure 38.

Figure 41 is a schematic view for explaining the principle of operation of the movable stage device of Figure 38.

Figure 42 is a block diagram of a first example of drive control in the movable stage device of Figure 38.

Figure 43 is a time chart for explaining the operation of the drive control of the Figure 42 example, wherein the portion (a) shows the position of the movable stage with respect to driving time, the portion (b) shows the timing for switching an interchange switch, the portion (c) shows an applied current to a linear motor, the portion (d) shows the timing for switching an interchange clutch, and the portion (e) shows changes counteracting to the linear motor.

Figure 44 is a block diagram of a second example of drive control in the movable stage device of Figure 38.

Figure 45 is a time chart for explaining the operation of the drive control of the Figure 44 example, wherein the portion (a) shows the position of the movable stage with respect to driving time, the portion (b) shows the timing for switching an interchange switch, the portion (c) shows an applied current to a linear motor, the portion (d) shows the timing for switching an interchange clutch, and the portion (e) shows changes counteracting to the linear motor.

Figure 46 is a block diagram of a third example of drive control in the movable stage device of Figure 38.

Figure 47 is a time chart for explaining the operation of the drive control of the Figure 46 example, wherein the portion (a) shows the position of the movable stage with respect to driving time, the portion (b) shows an applied current to a linear motor, the portion (c) shows the timing for switching a clutch, and the portion (d) shows changes couteracting to the linear motor.

Figure 48 is a block diagram of a control system of a seventh embodiment of the present invention.

Figure 49 is a block diagram of a modified form of the control system.

Figure 50 is a schematic view for explaining the concept according to an eighth embodiment of the present invention.

Figure 51 is a block diagram of a control system of the eighth embodiment.

Figure 52 is a graph of stage movement curves.

Figure 53 is a block diagram of a modified form of the control system of Figure 51.

Figure 54 is a schematic and diagrammatic view of a driving system for a vertical type air cylinder.

Figure 55 is a schematic and diagrammatic view of a driving system for a lateral type air cylinder.

Figure 56 is a schematic view for explaining the principle of drive of an air cylinder.

Figure 57 is a block diagram of a control system for an air cylinder.

Figure 58 is a graphic view for explaining drive control of an air cylinder.

Figure 59 is a further graphic view for explaining drive control of an air cylinder.

Figure 60 is a still further graphic view for explaining drive control of an air cylinder.

Figure 61 is a yet further graphic view for explaining drive control of an air cylinder.

Figure 62 is a representation, showing general structure of a tenth embodiment of the present invention.

Figure 63 is an enlarged view, showing details of a portion of the tenth embodiment.

Figure 64 is an enlarged view, showing details of another portion of the tenth embodiment.

Figure 65 is a block diagram of a control system of the tenth embodiment.

Figure 66 is a time chart for explaining the control system of Figure 65.

Figure 67 is a block diagram of a modified form of the control system.

Figure 68 is a time chart for explaining the control system of Figure 67.

Figure 69 is a block diagram of a further modified form of the control system.

Figure 70 is a time chart for explaining the control system of Figure 69.

Figure 71 is a representation, showing general structure of an eleventh embodiment of the present invention.

Figure 72 is an enlarged view, showing details of a portion of the eleventh embodiment.

Figure 73 is a representation, showing general structure of a twelfth embodiment of the present invention.

Figure 74 is an enlarged view, showing details of a portion of the twelfth embodiment.

Figure 75 is a flow chart for explaining semiconductor device manufacturing processes.

Figure 76 is a flow chart for explaining details of a wafer process.

First Embodiment

Initially, a first embodiment of the present invention will be explained with reference to Figures 1, 2A and 2B.

In this embodiment, the invention is applied to an alignment system incorporated into a SOR X-ray exposure apparatus for printing a semiconductor. device manufacturing pattern of a mask 100 on a resist of a wafer 101 by using orbit radiation light (SOR X-ray), for positioning the wafer 101 with respect to the mask 100.

The movable stage device of this embodiment comprises first driving means which includes X linear motors 106A and 106B and Y linear motors 107A and 107B, for fine motion for final positioning in respect to X and Y directions, respectively, as well as second driving means which includes an X motor 108 and Y motors 109A and 109B for relatively rough motion (stepwise motion) in respect to the X and Y directions.

The wafer is held by attraction by a wafer chuck 103 mounted on an X stage 104. Through the fine motion and relatively rough motion by the first and second driving means, the wafer can be positioned and aligned correctly with respect to SR light emitted by a SOR ring (X-ray source) 1 and passed through the mask 100.

The X stage 104 is coupled to the X motor 108, mounted on a Y stage 105, through an X nut 114 and an X screw shaft 110 coupled by a bearing unit 111 which comprises a coupling 112 and a rolling bearing 113. Thus, forward or reverse rotation of the X motor 108 causes motion of the stage in positive or negative X direction. Further, the X stage 104 is coupled to X linear motor coils 117A and 17B, disposed in parallel in the X direction on the Y stage 105, through X linear motor coupling plates 16A and 17A and and X linear motors 16A and 17B disposed above and below it, respectively. Thus, it can be moved in the positive of negative X direction, similarly. X leaf spring means 115 is provided between the X stage 101 and the X nut 114, so that resilient coupling is provided therebetween. This allows that, for the final positioning subsequent to stop of the X motor 108 upon completion of the stepwise motion of the motor 108, the stage is displaced with the drive of the X linear motor 106A or 106B within the range counteractable to the spring force of the X leaf spring means 115. Also, a sensor (strain gauge or gap sensor) is provided to detect the amount of displacement of the X leaf spring 115.

In relation to the Y stage 105, the X stage 104 is provided with a pair of static pressure bearing means which comprises X static pressure bearing pressurizing systems 118A and 118B, X preloading magnets 119A and 119B, and X static pressure pads 120A and 120B (elements 118A, 119A and 120A are not shown).

On the other hand, the Y stage 105 is coupled to the Y motors 109A and 109B, mounted to a stage base 102, through Y screw shafts 121A and 121B and Y nuts (not shown) coupled by similar bearing units as described. Thus, forward or reverse rotation of the Y motors 109A and 109B causes positive or negative motion of the stage.

Mounted on the right-hand and left-hand sides of the Y stage 105 are Y linear motor coupling plates 123A and 123B and Y linear motors 107A and 107B. Through these Y linear motors 107A and 107B. It is coupled to Y linear motor coils 124A and 124B which are provided on a pair of yaw guides 122A and 122b, respectively, disposed in parallel in the Y direction on the stage base 102. Thus, it can be moved in the positive or negative Y direction, similarly.

As regards the Y stage 105, like the X stage 104, Y leaf spring means (not shown) is provided between it and the Y nut. Thus, resilient coupling is provided therebetween. This allows that, for final positioning subsequent to stop of the Y motors 109A and 109B after completion of the stepwise motion of the motors 109A and 109B, the stage is displaced with the drives of the Y linear motors 107A and 107B within the range counteractable to the spring force of the Y leaf spring. A sensor (strain gauge or gap sensor) is provided to detect the amount of displacement of the Y leaf spring.

In relation to the Y yaw guides 122A and 122B, the Y stage 105 is provided with a pair of static pressure bearing means which comprises Y static pressure pads 125A and 125B, Y static pressure bearing pressurizing systems 126A and 126B and Y preloading magnets 127B.

X-axis laser interferometer unit 128 and Y-axis laser interferometer unit 129 shown in Figure 1 are provided to measure the position of the X stage 104 in the X and Y directions, respectively, in response to reception of laser light reflected from a square mirror 130 on the X stage 104.

The principle of positioning in this embodiment will be explained with reference to Figure 3.

The structure of this embodiment described above is such as shown in Figure 3 wherein a spring member 303 is disposed between a second driving means 302 and a movable stage 300.

For stepwise motion and positioning, for example, first an energy such as voltage for the stepwise motion of the stage is applied to the second driving means 302. In response, the second driving means produces a drive corresponding to the received energy, which drive is transmitted to the movable stage 300 through the spring member 303, whereby the movable stage 300 is moved stepwise. At this time, the output of a first driving means 301 is intercepted by a switch so that it produces no drive or, alternatively, it produces a limited, very small drive. Therefore, heat generation is sufficiently suppressed to a level that can be neglected. Also, the second driving means 320 does not generate heat or, if it generates heat, a cooling means is provided. Thus, substantially no thermal energy is transmitted to the movable stage 300.

During the stepwise motion, a control system for the second driving means executes open-loop control wherein the position is not directed fed back, or a semi-closed loop control wherein displacement of the second driving means 302 is fed back, whereby stable stepwise motion is assured.

Closing to completion of the stepwise motion, the switch having intercepted the output of the first driving means 301 is tuned to a side, connecting the output. In response, the first driving means 301 begins to produce a drive for the positioning (as a trigger for turning the switch, the stage position or the time may be used) or, alternatively, the drive having been limited to a very low level becomes contributable to the positioning. On the other hand, up to this moment, the second driving means 302 has become substantially stationary. However, due to the provision of the spring member 303 between the movable stage 300 and the second driving means 302 the position of the movable stage 300 can be controlled by the first driving means 301' within the range counteractable to the spring force of it. Since control system executes closed-loop control wherein the stage position is fed back and since the first driving means 301 comprises a linear motor, a high mechanical rigidity system can easily be assured and high gain (high precision) and stable position control is ensured.

As regards heat generation during the positioning operation, the second driving means 302 does not generate heat or it is cooled. Moreover, the stepwise motion has already been finished. Therefore, heat generation if any is very low as compared with that during the stepwise notion. While the first driving means 301 needs a force effective to counteract to any disturbance, vibrating the movable stage 300, and effective to flex the spring member 303, since the amount of displacement during the positioning operation is very small (e.g., about 0.1 micron), heat generation resulting from production of such force is very small. Thus, it does not have an adverse effect on the stage 300.

Now, drive control for the first driving means (X linear motors 106A and 106B, and Y linear motors 107A and 107B) and the second driving means (X motor 108 and Y motors 109A and 109B) will be explained.

Since essentially the same explanation applies to the drive control in both of the X and Y directions, only the drive control in the X direction will now be explained.

First, referring to Figures 4 and 5, an example wherein drive control is executed with reference to the movement distance of the X stage 104 in the X direction, will be explained.

Figure 4 is a block diagram of drive control means of this example. Figure 5 is a time chart, showing an example of control operation of the drive control means of Figure 4, wherein the portion (a) shows the movement distance of the X stage 104 with respect to time, the portion (b) shows the timing of switching an interchange switch 403, and the portion (c) shows applied currents to the X linear motors 106A and 106B.

The drive control means of this example comprises two filters 401 and 402, two current amplifiers 402 and 405, an interchange switch 403 and a comparator 406.

An instruction signal corresponding to the movement distance of the X stage 104 to a target position (destination) is applied to the X motor 108 via the filter 404 and the current amplifier 405. In response, a drive of the X motor 208 is transmitted to the X stage 104 via the X screw shaft 110 and the X leaf spring 115, whereby the X stage 104 is moved.

The interchange switch 403 is a switch for turning on/off the application of drive current to the X linear motors 106A and 106B. When the switch 403 is connected, the instruction signal described above is applied to the X linear motors 106A and 106B through the filter 401 and the current amplifier 402.

The comparator 406 serves to discriminate whether the difference between the target position and the current position of the X stage 104, being moved by the X motor 108 is within a predetermined tolerable range or not and, if so, the switch 403 is turned into the connected state. The tolerable range is set in accordance with the spring force of the X leaf spring 115.

In the drive control means of this example, the X stage 104 is moved into the predetermined tolerable range of the target position through the stepwise motion thereof by the X motor 108. After this, the X linear motors 106A and 106B are driven to execute the final positioning. Since the tolerable range for the target position is set in accordance with the spring force of the X leaf spring 115, motion by the X linear motors 106A and 106B for the final positioning can be done easily.

Here, while couteracting to the spring force, the X linear motors 106A and 106B should also provide a force effective to absorb any disturbance tending to cause vibration of the stage 104. In the portion (c) of Figure 5, the offset corresponds to the force acting against the spring force, and the amplitude of the current wave after the switching of the switch 403 corresponds to the force effective to absorb the disturbance. The same applies to some examples to be described later.

Referring now to Figures 6 and 7, an example wherein drive control is executed with reference to the driving time of the X stage 104 in the X direction, will be explained.

Figure 6 is a block diagram of drive control means of this example. Figure 7 is a time chart showing an example of control operation of the drive control means of Figure 6, wherein the portion (a) shows the movement distance with respect to driving time, the portion (b) shows the timing for switching an interchange switch 603, and the portion (c) shows applied currents to the X linear motors 106A and 106B.

The drive control means of this example comprises two filters 601 and 604, two current amplifiers 602 and 605 and an interchange switch 603, like those of the Figure 4 example, as well as a comparator 606.

In this example, the time in which the X stage 104 goes to and reaches a position adjacent to the target position in response to the application of a predetermined drive current to the X motor 108, is set beforehand as a set time. Then, in the comparator 606, the driving time of the X stage 104 by the X motor 108 is compared with the set time and, when the former exceeds the latter, the switch 603 is turned into its connected state. In response, electric currents are applied to the X linear motors 106A and 106B, to execute the final positioning operation.

Next, referring to Figures 8 and 9, an example wherein the X linear motors 106A and 106B are driven continuously until the X stage 104 reaches the target position, will be explained.

Figure 8 is a block diagram of drive control means of this example. Figure 9 is a time chart showing an example of control operation of the drive control means of Figure 8, wherein the portion (a) shows the movement distance with respect to driving time, and the portion (b) shows applied currents to the X linear motors 106A and 106B.

The drive control means of this example comprises two filters 801 and 802 and two current amplifiers 802 and 805, like those of the Figure 4 example, as well as a current limiter 803.

Since the linear motor is controlled by a closed loop wherein the stage position is continuously fed back, if the difference to the target position is large, a current is continuously applied in the direction of acceleration. Also in this case, the applied current to the X linear motors 106A and 106B is restricted by the current limiter 803. When the X stage 104 comes almost to the target position, the X motor 108 then produces substantially no drive and, on the other hand, the X linear motors 106A and 106B having been current-restricted by the current limiter become contributable to the positioning operation. Since the stage position is fed back to the X linear motors 106A and 106B only, in the neighbourhood of the target position it is equivalent to the control only by a closed loop through the X linear motors 106A and 106B. The final positioning operation is made in this state.

In this example, the drive current applied to the X linear motors 106A and 106B is restricted by the current limiter 803 and, therefore, the drive therefrom is very small. However, with the stoppage of the X motor 108, they contribute to the positioning, within the range counteractable to the spring force of the X leaf spring 115.

In this example, the maximum level of the electric current to be applied to the X linear motors 106A and 106B is set approximately at the same level of the sum of (i) the current corresponding to the force absorbing any disturbance, tending to cause vibration of the X stage 104 and (ii) the current corresponding to the force which can be determined by the product of positioning error (a few microns) by the X motor 108 with the spring constant of the leaf spring 115.

As compared with the current for the stepwise motion, this level is very low as can be neglected.

In the embodiment described above, it is possible that the X leaf spring 115 deforms due to continuous application of stress thereto, during the stepwise motion and final positioning of the X stage 104.

In consideration of this possibility, a clutch 131 and a driving plate 132 are provided between the X stage 104 and the X nut 114, engaging with the X screw shaft 110 coupled to the X motor 108, such that the X stage 104 and the X nut 114 are fixed during the stepwise motion period in which a large stress is applied to the X leaf spring 115. This assures that stress is applied to the X leaf spring 115 only during the final positioning operation, thus avoiding deformation of the X leaf spring 115 as well as overshooting of the X stage 104. The same applies to the Y stage 105 side.

Second Embodiment

Referring to Figures 11 - 13, a second embodiment of the present invention will be explained.

Figure 11 is a perspective view of a movable stage device of this embodiment. Figure 12 is a front view of the movable stage device of Figure 11. Figures 13A and 138 show a first driving means of this embodiment, wherein Figure 13A is a front view and Figure 13B is a longitudinal section.

Like the first embodiment, the movable stage device of the present embodiment is incorporated as an alignment device into a SOR X-ray exposure apparatus, for positioning a wafer 1101 with respect to SR light emitted from a SOR ring (X-ray source) 1 and passed through a mask 1100.

In this embodiment, the stage device comprises first driving means including X induction motors 1305A and 1305B, Y induction motors 1308A and 1308B and Θ induction motors 1311A and 1311B, for position adjustment with respect to X, Y and Θ ($w_X$, $w_Y$ and $w_Z$) directions, as well as second driving means including X electric cylinders 1106A and 1106B and Y electric cylinders 1109A and 1109B.

The wafer 1101 is held by attraction by a wafer chuck 1103 which is disposed on an X-Y stage 1104 mounted on an X assist base 1111.

The X assist base 1111 is supported in the Y direction, through Y parallel leaf springs 1115A and 1115B, by Y electric cylinder rods 1110A and 1110B of the Y electric cylinders 1109A and 1109B which are mounted on the bottom of a cylinder mounting base 1105 which in turn is mounted on a stage base 1102.

The X-Y stage 1104 is supported at its opposite sides through X parallel leaf springs 1108A and 1108B by X electric cylinder rods 1107A and 1107B of X electric cylinders 1106A and 1106B mounted to the opposite sides of the cylinder mounting base 1105, respectively.

Mounted on the face of the X-Y stage 1104 contacting with the X assist base 1111, is an X static pressure bearing 1117 having an X static pressure bearing pressurizing system 1116 and an X preloading magnet 1118. Further, mounted to the portions of the X electric cylinder rods 1107A and 1107B contacting to the X-Y stage 1104, are Y static pressure bearings 1120A and 1120B, respectively, having Y static pressure bearing pressurizing systems 1119A and 1119B and Y preloading magnets 1121A and 1121B respectively (elements 1119A, 1120A and 1121A are not shown).

Also in this embodiment, for measurement of the position of the X-Y stage 1104, the movable stage device is provided with a square mirror 1112, an X-axis laser interferometer unit 1113 and a Y-axis laser interferometer unit 1114.

Now, the first driving means of this embodiment will be explained.

The X induction motors 1305A and 1305B, the Y induction motors 1308A and 1308B, and the θ induction motors 1311A and 1311B, constituting the first driving means, are mounted on the face of the X-Y stage 1104 contacting with the stage base 1102.

The X induction motors 1305A and 1305B are of the same structure, and they include first coils 1306A and 1306B and second coils 1307A and 1307B, respectively. Similarly, the Y induction motors 1308A and 1308B comprise first coils 1309A and 1309B and second coils 1310A and 1310B, respectively. The θ induction motors 1311A and 1311B comprise first coils 1312A and 1312B and second coils 1313A and 1313B, respectively.

Mounted at three sites on the face of the X-Y stage 1104 contacting with the stage base 1102, are static pressure bearings having pressurized air discharging pads 1301A, 1301B and 1301C, electromagnet cores 1302A, 1302B and 1302C, and coils 1303A, 1303B and 1303C. Also, in association with these elements, three gap sensors 1304A, 1304B and 1304C are provided. These components cooperate with each other to maintain a predetermined gap to the X-Y stage, in the Z direction.

The final positioning through the induction motors 1305A, 1305B, 1308A, 1308B, 1311A and 1311B of X, Y and θ directions, is executed after the stepwise motion through the electric cylinders 1106A, 1106B, 1109A and 1109B of the X and Y directions. Since they operate substantially in the same manner, only the operation of the X induction motor 1305 will now be explained.

AC current is applied to the first coil 1306A, and AC current having a phase delay of 90 deg. to the current applied to the first coil is applied to the second coil 1307A. In that occasion, the peak of magnetic flux produced at each of the first and second coils 1306A and 1307A advances in the negative X direction. In response, an eddy current is generated in a good conductor of the stage base 1102. Due to cooperative action of this eddy current and the magnetic flux produced in response to the application of AC current to the first and second coils 1306A and 1307A, the X-Y stage 1104 moves in the positive X direction. On the other hand, the motion in the negative X direction is attainable by inverting the phase of the electric current to be applied to the first and second coils 1306A and 1307A.

For controlling the position in the X and Y directions and the angle in the θ direction, the difference between the target position and the current position as well as the angle, as measured by using laser interferometers 1113 and 1114 of the X, Y and θ axes (the one related to the θ axis is not shown), are calculated and fed back to the associated induction motors described above.

While in this embodiment three gap sensors are used for adjusting the gap in the Z direction while detecting the same, an autofocusing type sensor means may be provided between a mask and a wafer so as to directly measure the gap.

Third Embodiment

Referring now to Figures 14 and 15, a third embodiment of the present invention will be explained.

Figure 14 is a perspective view of a movable stage device of this embodiment, and Figure 15 is a front view thereof.

Like the preceding embodiments, in this embodiment the invention is applied to an alignment system in a SOR X-ray exposure apparatus, for positioning a wafer 1401 with respect to SR light emitted from a SOR ring (X-ray source) 1 and passed through a mask 1400.

The movable stage device of this embodiment comprises a first driving means including X linear motors 1406A and 1406B and Y linear motors 1407A and 1407B, of similar structure as of the first embodiment, and a second driving means including two X non-contact air cylinders 1413A and 1413B reciprocally movable in the X direction and a Y non-contact air cylinder 1415 in respect to the Y direction.

Figures 16 and 17 each shows an example of the structure of the X non-contact air cylinder 1413A (1413B) or the Y non-contact air cylinder 1415.

In this embodiment, an X stage 1404 and a Y stage 1405 are moved approximately up to their target positions through stepwise motion of the X non-contact air cylinders 1413A and 1413B and the Y non-contact air cylinder 1415. After this, the X linear motors 1406A and 1406B and the Y linear motors 1407A and 1407B operate to execute the final positioning. Here, while this embodiment does not use leaf spring means such as of the first or second embodiment, resiliency is provided between the X and Y stages 1404 and 1405 due to the airs within the X non-contact air cylinders 1413A and 1413B and the Y non-contact air cylinder 1415. As a result, within a range counteractable to the compressiveness/expansiveness of the air, the X linear motors 1406A and 1406B as well as the Y linear motors 1407A and 1407B can operate to execute the positioning. Namely, the airs in the air cylinders serve as a spring means.

The principle of positioning operation in this embodiment will be explained with reference to Figure 18.

For stepwise motion and positioning, for example, first, an air is supplied to a second driving means 1806 so as to move a movable stage 1805 stepwise. In response, the second driving means produces a drive corresponding to the amount of supplied air, and moves the movable stage 1805 stepwise. Here, the output of a first driving means 1807 is intercepted by a switch so that it does not produce a drive at all or, alternatively, a small drive limited to very low level is produced. Thus, heat generation is suppressed sufficiently to a level that can be neglected. Since the second driving means 1806 is an air cylinder, no heat is generated thereby.

During the stepwise motion, an air cylinder control system provides an open loop control wherein the stage position is not directly fed back or a semi-closed loop control wherein the flow rate of air or the cylinder inside pressure is fed back. Thus, stable stepwise motion is assured. Accelerating an air cylinder needs supply of an air and, on the other hand, decelerating it needs discharge of the air. For this reason, in the air cylinder, an interchange valve 1803 is used to interchange a pressure source and a vacuum source appropriately during the stepwise motion to control the direction of air flow.

As the stepwise motion is coming to the end, the switch having intercepted the output of the first driving means 1807 is tuned to the side connecting that output. In response, the first driving means 1807 begins to produce a drive for the positioning (as a trigger for switching this switch, the stage position or the time may be used). Alternatively, the drive having been limited to a very low level becomes contributable to the positioning. On the other hand, since up to this moment the flow of air into and out of the air cylinder has been reduced substantially to zero, it is possible to control the position of the first driving means 1807 within a range counteractable to the compressiveness/expansiveness of air. Also, the control system executes closed loop control in which the stage position is fed back, and the first driving means 1807 comprises a linear motor. Thus, it is easily possible to provide a system of high mechanical rigidity and to assure high gain (high precision) and stable position control.

As regards the heat generation during the positioning operation, the air cylinder does not generate heat as so during the stepwise motion. While the linear motor needs a force counteractable to disturbance causing vibration of the stage as well as a force counteractable to the compressiveness/expansiveness of the cylinder inside air, since the amount of displacement during the positioning operation is very small (e.g., about 0.1 micron), heat generation resulting from production of such forces is very small. Thus, it does not adversely affect the movable stage 1805.

Further, the force counteractable to the compressiveness/expansiveness of air can be reduced by communicating the air cylinder with a constant pressure large capacity chamber, in the positioning operation.

Next, drive control means for the first driving means (X linear motors 1406A and 1406B and Y linear motors 1407A and 1407B) and the second driving means (X non-contact air cylinders 1413A and 1413B and Y non-contact air cylinder 1415) of the present embodiment will be explained.

Since essentially the same explanation applies to the drive control in both of the X and Y directions, only the drive control in the X direction will now be explained.

First, referring to Figures 19 and 20, an example wherein drive control is executed with reference to the movement distance of the X stage 1404 in the X direction, will be explained.

Figure 19 is a block diagram of drive control means of this example. Figure 20 is a time chart, showing an example of control operation of the drive control means of Figure 19, wherein the portion (a) shows the movement distance of the X stage 1404 with respect to time, the portion (b) shows the timing of switching an interchange switch 1903, and the portion (c) shows applied currents to the X linear motors 1406A and 1406B.

In this example, the stepwise motion is provided by supplying/discharging airs to or out of the X non-contact air cylinders 1413A and 1413B, from a vacuum source 1906 or a pressure source 1907 through an interchange valve 1908 and a control valve 1909. During the stepwise motion, the position of the X stage 1404 is compared with the target position by a comparator 1904 and, as the difference therebetween comes into a predetermined tolerable range, a switch 1903 is turned into its connected state, whereby application of currents to the X linear motors 1406A and 1406B is started.

In this example, the tolerance to the X stage with respect to the target position is determined in accordance with the compressiveness/expansiveness of air inside the X non-contact air cylinders 1413A and 1413B. Thus, the motion for the final positioning by the X linear motors 1406A and 1406B can be done easily. Here, while compressing/expanding the air and couteracting to the reactive force thereof, the X linear motors 1406A and 1406B should also provide a force effective to absorb any disturbance tending to cause vibration of the X stage 1404. In the portion (c) of Figure 20, the offset corresponds to the force acting against the air pressure, and the amplitude of the current wave after the switching of the switch 1903 corresponds to the force effective to absorb the disturbance. The same applies to some examples to be described later.

Referring now to Figures 21 and 22, an example wherein drive control is executed with reference to the driving time of the X stage 1404 in the X direction, will be explained.

Figure 21 is a block diagram of drive control means of this example. Figure 22 is a time chart showing an example of control operation of the drive control means of Figure 21, wherein the portion (a) shows the movement distance with respect to driving time, the portion (b) shows the timing for switching an interchange switch 2103, and the portion (c) shows applied currents to the X linear motors 1406A and 1406B.

In this example, the stepwise motion is provided substantially in the same manner as the preceding example wherein the motion is controlled with reference to the movement distance.

In this example, the switch 2103 is turned to apply drive currents to the X linear motors 1406A and 1406B, in response to discrimination by a comparator 2104 which compares the driving time of the X stage 1404 with a predetermined set time (in which it is expected that the stage reaches the target position) and which discriminates, on the basis of the comparison that the driving time exceeds the set time. This enables transition to the final positioning operation, at the moment whereat the X stage 1404 comes approximately to the target position. Also in this example, the set time is determined in accordance with the compressiveness/expansiveness of air inside the X non-contact air cylinders 1413A and 1413B.

Next, referring to Figures 23 and 24, an example wherein the X linear motors 1406A and 1406B are driven continuously until the X stage 1404 reaches the target position, will be explained.

Figure 23 is a block diagram of drive control means of this example. Figure 24 is a time chart showing an example of control operation of the drive control means of Figure 23, wherein the portion (a) shows the movement distance with respect to driving time, and the portion (b) shows applied currents to the X linear motors 1406A and 1406B.

The drive control means of this example operates in a similar way as the drive control means of the first embodiment, described with reference to Figure 8. During the stepwise motion, drive currents are continuously applied to the X linear motors 1406A and 1406B while the currents are limited by a current limiter 2303. As the X stage 1404 comes approximately to the target position and the stepwise motion is finished, the drives of the X linear motors 1406A and 1406B become contributable to the positioning operation.

Next, a modified form of this embodiment will be explained with reference to Figure 25.

In this example, a constant pressure large capacity chamber 2509 is connected through an interchange valve 2508 to the counter air-cylinder (counter second driving means) side of the movable stage as shown in Figure 18. By opening the valve 2508, the chamber 2509 can be communicated with an air cylinder 2506.

Referring now to Figures 26 and 27, drive control means for air cylinders and linear motors such as those of the movable stage device of the structure described above, will be explained.

Figure 26 is a block diagram of drive control means of this example. Figure 27 is a time chart showing an example of control operation of the drive control means of Figure 26, wherein the portion (a) shows the movement distance of the X stage 1404 with respect to driving time, the portion (b) shows the timing for switching an interchange switch 2603, the portion (c) shows applied currents to the linear motors, the portion (d) shows changes in air cylinder inside pressure, the portion (e) shows the timing for switching an interchange valve 2611, and the portion (f) shows changes in air cylinder inside rigidity.

In the drive control means of this example, switching the interchange switch 2603 for applying drive currents to the X linear motors 1406A and 1406B is controlled essentially in the same manner as in the example wherein it is controlled with reference to the movement distance of the X stage 1404.

Also, the opening of the valve 2611 for providing communication between the chamber 2616 and the X non-contact air cylinders 1413A and 1413B, is made under the control of a comparator 2610 which discriminates whether the stepwise motion is finished or not.

First, when as the stepwise motion proceeds the X stage 1404 comes approximately to the target position and thus the difference comes into a predetermined tolerable range, the switch 2603 is turned into connected state. Thus, drive currents are applied to the X linear motors 1406A and 1406B and, in response, the final positioning operation starts.

During the stepwise motion, the inside pressure of the X non-contact air cylinders 1413A and 1413B rises just after start of the stepwise motion and, after this, is decreases gradually. Also, the rigidity of these air cylinders 1413A and 1413B changes similarly as the pressure change.

As the final positioning operation starts, in response to discrimination of the stop of the stepwise motion in the comparator 2610 the valve 2611 is opened to provide communication between the chamber 2612 and the X non-contact air cylinders 1413A and 1413B. Thus, in each air cylinder, the volume thereof increases apparently. This assures that, of the drive of the linear motors 1406A and 1406B, the reaction force in compressing/expanding the air is neglected. Thus, the currents to be applied to the linear motors 1406A and 1406B need only to correspond to a force capable of absorbing disturbance.

While in this example the timing is so set that the valve 2611 is opened after the switch 2603 is turned, the order may be inverted with substantially the same advantageous effect, provided that the switching of them is made approximately concurrently.

## Fourth Embodiment

Referring to Figures 28 and 29, a fourth embodiment of the present invention will be explained.

Figure 28 is a perspective view of a movable stage device of this embodiment. Figure 29 is a front view of the movable stage device of Figure 28.

Like the preceding embodiment, the movable stage device of the present embodiment is incorporated as an alignment device into a SOR X-ray exposure apparatus, for positioning a wafer 2801 with respect to SR light emitted from a SOR ring (X-ray source) 1 and passed through a mask 2800.

In this embodiment, the stage device comprises first driving means including X, Y and θ induction motors, like those shown in Figure 13, for motion in the X, Y and θ directions, which are provided on the face of an X-Y stage contacting with a stage base 2802. The stage device further comprises second driving means including an X non-contact air cylinder 2814, reciprocally movable in the X direction like that of Figure 16, as well as a Y non-contact air cylinder 2819 like that of Figure 17.

Mounted to end portions of an X non-contact air cylinder rod 2807 engaging with the X non-contact air cylinder 2814 which portions contact with Y assist bases 2806A and 2806B, respectively, are Y-axis static pressure bearings 2809A and 2809B including Y preloading magnets 2817A and 2817B and Y static pressure bearing pressurizing systems 2818A and 2818B (elements 2817A and 1818A are not shown), respectively. This allows that, in the motion of the X-Y stage 2801 in the Y direction, it moves without contact to the Y assist bases 2806A and 2806B.

Similarly, mounted on the face of a Y non-contact non-contact air cylinder rod 2808 engaging with the Y air cylinder 2819 which face contacts with an X assist base 2805, is an X static pressure bearing 2801 including an X preloading magnet 2815 and an X static pressure bearing pressurizing system 2816. For motion of the X-Y stage 2804 in the X direction, it can move without contact to the X assist base 2805.

It is to be noted that drive control for the X and Y non-contact air cylinders 2814 and 2819 and X and Y induction motors can be done essentially in the same way as that of the preceding embodiment.

## Fifth Embodiment

Referring to Figures 30, 31A and 31B, a fifth embodiment of the present invention will be explained.

Figure 30 is a perspective view of a movable stage device of this embodiment. Figure 31A is a front view of the movable stage device of Figure 30, and Figure 31B is a sectional view taken on line A-A of Figure 31A.

Like the preceding embodiments, the movable stage device of the present embodiment is incorporated as an alignment device into a SOR X-ray exposure apparatus, for positioning a wafer 3001 with respect to SR light emitted from a SOR ring (X-ray source) 1 and passed through a mask 3000.

In this embodiment, the stage device comprises first driving means including X linear motors 3010A and 3010B and Y linear motors 3015A and 3015B, like those in the preceding embodiment. Also, it comprises second driving means including first and second moving mechanisms. The first moving mechanism is arranged to hold a Y stage 3005 with Y belts 3006A and 3006B, stretched between two Y drum units 3008A and 3008B, and through equalizer 3009A and 3009B, and also to rotate the Y drum unit 3008B by a drive of a Y motor 3007 to move the Y stage 3005 in the Y direction. The second moving mechanism is so arranged that an X belt stretched between two X drum units 3022A and 3022B is connected to an X stage 3004 and that, with a drive of an X motor 3021, the X drum unit 3022A is rotated to move the X stage 3004 in the X direction.

At the face contacting with a stage base 3002, the X stage 3004 is provided with a static pressure bearing means including an X static pressure pad 3026, an X preloading magnet 3027 and an X static pressure bearing pressurizing system 3028. Similarly, at the face contacting with the Y stage 3005, it is provided with a static pressure bearing means of similar structure. Thus, it can move without contact to the stage base 3002 and to the Y stage 3005.

On the other hand, at the face contacting with Y yaw guides 3013A and 3013B mounted on the stage base 3002, the Y stage is provided with static pressure bearing means including Y static pressure pads 3023A and 3023B, Y static pressure bearing pressurizing systems 3024A and 3024B and Y preloading magnets 3025A and 3025B (elements 302B, 3024B and 3025B are not shown). Further, at the face contacting with the stage base 3002, it is provided with static pressure bearing means of similar structure. Thus, it can move without contact to the stage base 3002 and to the Y yaw guides 3013A and 3013B.

Now, the principle of positioning in the present embodiment will be explained with reference to Figure 32.

For stepwise motion and positioning, for example, first an energy such as voltage for the stepwise motion of the stage is applied to the second driving means 3202. In response, the second driving means produces a drive corresponding to the received energy, which drive is directly transmitted to the movable stage 3000, whereby the movable stage 3200 is moved stepwise. At this time, the output of a first driving means 3201 is intercepted by a switch so that it produces no drive or, alternatively, it produces a limited, very small drive. Therefore, heat generation is sufficiently suppressed to a level that can be neglected. Also, a cooling means is provided for the second driving means 3202 so to absorb any heat. Thus, substantially no thermal energy is transmitted to the movable stage 3200.

During the stepwise motion, a control system for the second driving means executes closed loop control wherein the position is fed back. However, by decreasing the gain, stable stepwise motion is assured.

Closing to completion of the stepwise motion, the switch having intercepted the output of the first driving means 3201 is tuned to a side, connecting the output. In response, the first driving means 3201 begins to produce a drive for the positioning (as a trigger for turning the switch, the stage position or the time may be used) or, alternatively, the drive having been limited to a very low level becomes contributable to the positioning.

Also, at this moment, the second driving means 3202 is shut off the closed loop control and, in place thereof, it is driven by a constant current (in the Y direction, a current effective to provide a torque balancing the weight of the movable stage 3200; whereas in the X direction, it is zero). In response, the force of the second driving means 3202 become ineffective to the movable stage 3200, and thus the position of the movable stage 3200 can be controlled only by the first driving means 3201. Since control system executes closed-loop control wherein the stage position is fed back and since the first driving means 3201 comprises a linear motor, a high mechanical rigidity system can easily be assured and high gain (high precision) and stable position control is ensured.

As regards heat generation during the positioning operation, the second driving means 3202 is cooled and it does not generate heat (essentially it does not generate heat since the current is zero in the X direction). While the first driving means 3201 needs a force effective to counteract to any disturbance, vibrating the movable stage 3200, since the amount of displacement during the positioning operation is very small (e.g., about 0.1 micron), heat generation resulting from production of such force is very small. Thus, it does not have an adverse effect on the stage 3200.

Now, drive control means for driving linear motors and X and Y motors in this embodiment will be explained.

Since essentially the same explanation applies to the drive control in both of the X and Y directions, only the drive control in the X direction will now be explained.

First, referring to Figures 33 and 34, an example wherein drive control is executed with reference to the movement distance of the X stage 104 in the X direction, will be explained.

Figure 33 is a block diagram of drive control means of this example. Figure 34 is a time chart showing an example of control operation of the drive control means of Figure 336, wherein the portion (a) shows the movement distance of the X stage 3004 with respect to driving time, the portion (b) shows the timing for switching a first interchange switch 3303, the portion (c) shows applied currents to X linear motors 3010A and 2010B, the portion (d) shows the timing for switching a second interchange switch 3308, the portion (c) shows changes in resistance to the X linear motors 3010A and 3010B.

In the drive control means of this example, the first interchange switch 3303 for applying drive currents to the X linear motors 3010A and 3010B is tuned into its connecting state in response to discrimination by a comparator 3304 which serves to compare the difference between the position of the X stage 3004 and the target position with a predetermined tolerance and to discriminate, on the basis of the comparison, that the difference comes into the tolerable range.

On the other hand, the application of current to the X motor 3021 is changed, between in the stepwise motion and after the stepwise motion. During the stepwise motion, a drive current corresponding to a supplied instruction signal is applied to the X motor 3021 through a filter 3305, a second interchange switch 3508 and a current amplifier 3309. After the stepwise motion, a constant current is applied to the X motor 3021 from a constant voltage source 3306 through the second switch 3508 and the current amplifier 3309, so as to hold the X stage 3004 at the position assumed at the completion of the stepwise motion. However, in the case of X direction, the applied current may be "zero". In the case of Y direction, because of the weight of the X stage 3005, for example, it is necessary to apply to the Y motor 3007 such constant current balancing thereto.

Switching of current application to the X motor 3021 is made by the second switch 3508, and it control is made by the comparator 3307 which discriminates whether the stepwise motion is completed or not.

In the drive control means of this example, during the stepwise motion, the rotational motion of the X motor 3021 is converted through drum units 3022A and 3022B into rectilinear motion, by which the X stage 3004 is moved in the X direction. The subsequent final positioning operation with the X linear motors 3010A and 3010B, may be done essentially in the same manner as the preceding embodiment. The resisting force to the X linear motors 3010A and 3010B in this operation is substantially "zero" since substantially no force acts on the X stage 3004. Thus, it can be moved easily. Here, in this example, the X linear motors 3010A and 3010B need only to produce. a force absorbing disturbance, tending to cause vibration of the X stage 3004. This force corresponds to the amplitude of current wave, after switching the first switch 3303, shown in the portion (c) of Figure 34.

Referring now to Figure 35, an example wherein drive control is executed with reference to the driving time of the X stage 3004 in the X direction, will be explained.

Figure 35 is a block diagram of drive control means of this example.

In the drive control means of this example, the first interchange switch 3503 for applying drive currents to the X linear motors 3010A and 3010B is switched In response to the moment at which the driving time of the X motor 3021 after start of stepwise motion goes beyond a predetermined set time (in which it is expected that the X stage 3004 reaches the target position). The remaining portion is substantially the same as that of the Figure 33 example. In this example, the driving time is compared with the set time by a comparator 3504 and, on the basis of which, the comparator 3504 controls the switching of the first switch 3503.

Next, referring to Figures 36 and 37, an example wherein the X linear motors 3010A and 3010B are driven continuously until the X stage 3004 reaches the target position, will be explained.

Figure 36 is a block diagram of drive control means of this example. Figure 37 is a time chart showing an example of control operation of the drive control means of Figure 36, wherein the portion (a) shows the movement distance of the X stage 3004 with respect to driving time, the portion (b) shows applied currents to the X linear motors 3010A and 3010B, the portion (c) shows the timing for switching an interchange switch, and the portion (d) shows changes in resisting force to the X linear motors 3010A and 3010B.

In the drive control means of this example, the X linear motors 3010A and 3010B are driven and controlled in a similar manner as by the drive control means of the first embodiment described with reference to Figure 8. Since in the final positioning operation through the linear motors 3010A and 3010B, the resisting force to them becomes substantially "zero" as described, it is easy to move the X stage 3004. Here, in this example, the X linear motors 3010A and 3010B need only to produce a force effective to absorb disturbance, tending to cause vibration of the X stage 3004. This force corresponds to the amplitude of the current wave after the switching of the switch 3608, as shown in the portion (c) of Figure 37.

Sixth Embodiment

Referring to Figures 38 - 40, a sixth embodiment of the present invention will be explained.

Figure 38 is a front view of a movable stage device of this embodiment. Figure 39 is a sectional view of the movable stage device of Figure 38, taken on line A-A. Figure 40B is a sectional view taken on line B-B of Figure 38.

Like the preceding embodiments, the movable stage device of the present embodiment is incorporated as an alignment device into a SOR X-ray exposure apparatus, for positioning a wafer 3801 with respect to SR light projected thereto through a mask, not shown.

In this embodiment, the stage device comprises first driving means including an X linear motor (not shown) and Y linear motors 3810A and 3810B (motor 3810a is not shown), like those in the first embodiment (see Figures 1 and 2A). Also, it comprises second driving means for transmitting drives of an X motor 3804 and Y motors 3805A and 3805B to an X stage 3802 and a Y stage 3803 through an X screw shaft 3812 and Y screw shafts 3809A and 3809B.

The Y stage 3803 is held in suspension, through an equalizer 3813, by two constant tension springs 3808 which are wound around a constant tension spring drum 3817, mounted on a stage base 3806. The constant tension springs 3808 serve to zero-balance the weight of the X stage 3802 and the Y stage 3803, and they continuously produce a constant force in the positive Y direction. The constant tension springs 3808 are taken up or rewound by the drum 3817, with the motion of the Y stage 3803 in the Y direction.

X nut 3802 engaging with the X screw shaft 3812 is rigidly coupled to the X stage 3802 during the stepwise motion, by an X clutch 3822 provided between it and the X stage 3802. For the final positioning, it is disengaged to release the X stage 3802. This is also the case with the relationship between the Y screw shafts 3809A and 3809B and the Y stage 3803, and there are provided Y clutches 3831A and 3831B (clutch 3831A is not shown).

Now, the principle of positioning in the present invention will be explained with reference to Figure 41.

For stepwise motion and positioning, for example, first an energy such as voltage for the stepwise motion of the stage 4100 is applied to the second driving means 4102. In response, the second driving means produces a drive corresponding to the received energy, which drive is transmitted to the movable stage 4100 through the a clutch 4103, whereby the movable stage 4100 is moved stepwise. At this time, the output of a first driving means 4101 is intercepted by a switch so that it produces no drive or, alternatively, it produces a limited, very small drive. Therefore, heat generation is sufficiently suppressed to a level that can be neglected. Also, the second driving means 4102 does not generate heat or, alternatively, a cooling means is provided therefor. Thus, substantially no thermal energy is transmitted to the movable stage 4100.

During the stepwise motion, a control system for the second driving means 4102 executes closed loop control wherein the stage position is fed back. However, by decreasing the gain, stable stepwise motion is assured.

Closing to completion of the stepwise motion, the switch having intercepted the output of the first driving means 4101 is tuned to a side, connecting the output. In response, the first driving means 4101 begins to produce a drive for the positioning (as a trigger for turning the switch, the stage position or the time may be used) or, alternatively, the drive having been limited to a very low level becomes contributable to the positioning.

Also, at this moment, the clutch 4103 disengages to intercept the coupling between the second driving means 3412 and the movable stage 4100. Thus, no force of the second driving means 4102 acts on the movable stage 4100, and only the first driving means 4101 can control the position of the movable stage 4100. Since control system executes closed-loop control wherein the stage position is fed back and since the first driving means 4101 comprises a linear motor, a high mechanical rigidity system can easily be assured and high gain (high precision) and stable position control is ensured.

As regards heat generation during the positioning operation, the second driving means 4102 does not generate heat or it is cooled. Further, the stepwise motion has already been finished. Therefore, heat generation is yet lower than during the stepwise motion. While the first driving means 4101 needs a force effective to counteract to any disturbance, vibrating the movable stage 4100, since the amount of displacement during the positioning operation is very small (e.g., about 0.1 micron), heat generation resulting from production of such force is very small. Thus, it does not have an adverse effect on the stage 4100.

Now, drive control means for driving linear motors and X and Y motors in this embodiment will be explained.

Since essentially the same explanation applies to the drive control in both of the X and Y directions, only the drive control in the Y direction will now be explained.

First, referring to Figures 42 and 43, an example wherein drive control is executed with reference to the movement distance of the Y stage 3803 in the X direction, will be explained.

Figure 42 is a block diagram of drive control means of this example. Figure 43 is a time chart showing an example of control operation of the drive control means of Figure 43, wherein the portion (a) shows the movement distance of the Y stage 3803 with respect to driving time, the portion (b) shows the timing for switching an interchange switch 4203, the portion (c) shows applied currents to Y linear motors 3819A and 3819B, the portion (d) shows the timing for switching Y clutches 3831A and 3831B, and the portion (e) shows changes in resistance to the Y linear motors 3819A and 3819B.

In the drive control means of this example, the interchange switch 4203 for applying drive currents to the Y linear motors 3819A and 3819B is tuned into its connecting state in response to discrimination by a comparator 4204 which serves to compare the difference between the position of the Y stage 3803 and the target position with a predetermined tolerance and to discriminate, on the basis of the comparison, that the difference comes into the tolerable range.

On the other hand, during the stepwise motion, drive currents corresponding to a supplied instruction signal are applied to the Y motors 3805A and 3805B through a current amplifier 4205. Further, a comparator 4206 discriminates whether the stepwise motion is finished or not, and it controls the switching of Y clutches 3831A and 3831B.

With this comparator 4206, the Y clutches 3831a and 3831B are disengaged upon completion of the stepwise motion. This releases the Y stage 3803 at the position as assumed at the time of stop of the stepwise motion (approximately at the target position), and it is held in a balanced state with the weight of the X stage 3802 and the Y stage 3803 by the constant tension springs 3808. Since there is substantially no resisting force to the Y linear motors 3819A and 3819B, motion for the final positioning can be easily done. Here, in this example, the Y linear motors 3819A and 3819B need only to produce a force absorbing disturbance, tending to cause vibration of the Y stage 3803. This force corresponds to the amplitude of current wave, after switching the switch 4203, shown in the portion (c) of Figure 43. The same applies to some examples to be described below.

Referring now to Figures 44 and 45, an example wherein drive control is executed with reference to the driving time after input of an instruction signal, will be explained.

Figure 44 is a block diagram of drive control means of this example. Figure 45 is a time chart showing an example of control operation of the drive control means of Figure 44, wherein the portion (a) shows the movement distance of the Y stage 3803 with respect to driving time, the portion (b) shows the timing for switching an interchange switch 4403, the portion (c) shows applied currents to the Y linear motors 3819A and 3819B, the portion (d) shows the timing for switching the Y clutches 3831A and 3831B, and the portion (e) shows changes in resistance to the Y linear motors 3819A and 3819B.

In the drive control means of this example, the interchange switch 4403 for applying drive currents to the Y linear motors 3819A and 3819B is switched in response to the moment at which the driving time of the Y motors 3805A and 3805B after start of stepwise motion goes beyond a predetermined set time (in which it is expected that the Y stage 3803 reaches the target position). The remaining portion is substantially the same as that of the Figure 42 example. In this example, the driving time is compared with the set time by a comparator 4404 and, on the basis of which, the comparator 4404 controls the switching of the switch 4403.

Next, referring to Figures 46 and 47, an example wherein the Y linear motors 3819A and 3819B are driven continuously until the Y stage 3803 reaches the target position, will be explained.

Figure 46 is a block diagram of drive control, means of this example. Figure 47 is a time chart showing an example of control operation of the drive control means of Figure 46, wherein the portion (a) shows the movement distance of the Y stage 3803 with respect to driving time, the portion (b) shows applied currents to the Y linear motors 3819A and 3819B, the portion (c) shows the timing for switching Y clutches 3831A and 3831B, and the portion (d) shows changes in resisting force to the Y linear motors 3819A and 3819B.

In the drive control means of this example, the Y linear motors 3819A and 3819B are driven and controlled in a similar manner as by the X linear motor drive control means of the first embodiment described with reference to Figure 8. Since in the final positioning operation through the Y linear motors 3819A and 3819B, the resisting force to them becomes substantially "zero" as described, it is easy to move the Y stage 3803.

## Seventh Embodiment

A seventh embodiment will now be explained. Since general structure of the stage device is similar to that of the first embodiment (Figures 1 - 3), description of the structure will be omitted here. An important feature of this embodiment resides in that: the amount of displacement of leaf spring means is detected, and the detected is fed back to the drive control of the stage.

When a linear motor is positioned at a desired position, since the drive control system for the second driving means does not feed back the stage position, there is a possibility that flexure (offset) occurs in the spring element. If this occurs, then the linear motor has to produce a drive to continuously counteract to the force corresponding to this offset and produced by the spring. This causes a possibility of increased heat generation.

In the the present embodiment, in consideration thereof, any displacement of a spring element is detected and the detected is fed back to be added to an instruction signal to the control system of the second driving means, to thereby remove or cancel the offset. As described hereinbefore, the stage device of this embodiment is provided with a sensor (strain gauge or gap sensor) for detecting displacement of each of X and Y leaf springs. Thus, by using this sensor, the amount of displacement of spring means can be detected.

Figure 48 is a block diagram, showing in detail the structure of the control system of this embodiment. By turning on an interchange switch 2, the feedback control is enabled. The timing of trigger for the sensor output feedback may be the moment just when both the positional difference of the control system of the linear motor and the positional difference of the control system of the second driving means come into a certain tolerable range. Alternatively, it may be determined on the basis of the time lapse from generation of a positioning drive by the linear motor. Since the control system of the linear motor is based on high gain feedback, any displacement of the second driving means does not affect the positioning precision. Also, the current flowing to the linear motor reduces with decreasing offset. Thus, it is possible to suppress heat generation sufficiently.

Figure 49 is a block diagram, showing a modified form of the preceding embodiment. A contrast table of the spring displacement versus the corresponding electric current level flowing to the linear motor, is prepared beforehand. Then, the current flowing to the linear motor is detected and, from the detected current and this table, the amount of spring displacement is calculated. The calculated displacement is then fed back to the instruction signal to the second driving means. By this, substantially the same function as of the Figure 48 example is assured. This removes the necessity of using a sensor for detecting the spring displacement.

In accordance with this embodiment wherein the spring displacement is fed back to the control, the linear motor only need to suppress vibration due to disturbance during the positioning operation. Thus, there is an additional advantage of minimized heat generation.

It is to be noted that the concept of this embodiment is not limited to a system having a leaf spring means such as the Figure 1 example, but it is similarly applicable also to a system having an air cylinder such as the third embodiment (Figures 14 - 18) wherein the inside air of the air cylinder corresponds to the spring).

Eighth Embodiment

An eighth embodiment will now be explained. Since general structure of the stage device is similar to that of the first embodiment (Figures 1 - 3), description of the structure will be omitted here.

If during the stepwise motion quick acceleration is provided by the second driving means, there occurs residual vibration since a spring means is interposed. For reducing a force which flexures the spring, use of a smaller spring constant is desirable. However, it causes a high possibility of residual vibration. If residual vibration occurs, it takes a longer time until the vibration is suppressed. Quick suppression results in an increase in heat generation of the linear motor.

In the present embodiment in consideration thereof, an acceleration signal which can be differentiated is applied to the stage, to thereby avoid generation of residual vibration. This will be explained below in more detail. In the model of Figure 3, the equation of motion of the X stage is as follows:

$$m[(d^2x_1)/(dt^2)] = k(x_2 - x_1)$$

wherein $x_1$ is the position of the X stage; $x_2$ is the position of the end of the X screw shaft (representative position of the nut engaging with the screw); k is the spring constant of the leaf spring; and m is the mass of the stage.

Namely, the acceleration $d^2x_1/d$ of the X stage is proportional to the quantity of strain $(x_2-x_1)$ of the X leaf spring. Modifying this equation, the movement displacement $x_2$ of the X screw shaft end can be expressed as follows:

$$x_2 = (m/k)[x_1 + (d^2x_1)/d]$$

$$(x_2)' = (m/k)\{x_1' + [(d^2x_1)/d]'\}$$

$$(x_2)'' = (m/k)\{x_1'' + [(d^2x_1)/d]''\}$$

The quantity $x_2$ is proportional to the amount of rotation of the motor, and it is fed back to a semi-closed control system and is controlled. In order to suppress residual vibration, following to the semi-closed control system, it is necessary that in the equations above at least the screw end speed $(x_2)'$ is continuous. Preferably, $(x_2)''$ should be continuous, too. In order to provide continuous screw end speed $(x_2)'$, it is necessary that the differentiation of stage acceleration as represented by $(d^2x_1/d)'$ is continuous. Namely, it is necessary that the stage acceleration $(d^2x_1/d)$ can be differentiated. This is summarized in Figure 50.

Figure 50 shows an example of control system having an acceleration pattern such as above. First, a stage acceleration instruction signal $(d^2x_1/d)$ is generated and, on the basis of this, the following is produced:

$$x_2 = (m/k)[x_1 + (d^2x_1)/d]$$

Then, this is converted into the amount of rotation of the X motor and, subsequently, the difference between it and the actual amount of rotation of the X motor is detected. On the basis of the detection, the motor is driven by using a control system such as PLL, for example.

Figure 52 shows movement curves of the stage. As illustrated, when the motor stops, the acceleration $d^2x_1/d$ and the speed $dx_1/d)$ of the X stage and the distortion $(x_1-x_2)$ of the X leaf spring becomes zero. Namely, the motor stops, with no kinetic energy for producing vibration and with no distortion energy of the spring element.

There may occur an error in the stop position of movement, of an amount corresponding to the product of the X stage speed at the initiation of movement with the movement time period. Since however the stationary state has been held by the linear motor just before the initiation of movement, the stage speed at the initiation of movement is close to zero such that such a positional error at the time of completion of the movement is almost zero.

The above relates to the control with respect to the X direction, and the control with respect to the Y direction can be done similarly.

Figure 53 is a diagram, showing a modified form of the control system of this embodiment. This example provides a semi-closed control system wherein the amount of flexure or deflection of a spring is controlled in accordance with the following equation:

$$m[(d^2x_1)/d] = k(x_2 - x_1)$$

First, like the preceding embodiment, an acceleration signal ($d^2x_1/d$) to the stage which can be differentiated is generated. Then, in accordance with the equation above, spring flexure instruction pattern ($x_2$-$x_1$) is determined. The stage device of this embodiment is provided with a sensor (strain gauge or gap sensor) for detecting displacement of the spring, as described hereinbefore, and therefore it is possible to measure the amount of deflection continuously.

Here, the differences between the flexure instruction pattern and the amounts of actual deflection as measured successively by the sensor is detected. The result is computed by a control system such as a PLL, for example, and on the basis of which the motor is driven.

The differentiatable function patterns shown in Figures 51 and 53 each is defined on the basis of an exponential function, a trigonometric function or a power series. This function pattern may be memorized beforehand within an inside memory of of the controller, or it may be inputted appropriately from an outside controller.

## Ninth Embodiment

A ninth embodiment will now be explained. Since general structure of the stage device is similar to that of the third embodiment (Figures 14 - 18), description of the structure will be omitted here.

Figures 54 and 55 show a driving system for an air cylinder in examples where the air cylinder of Figure 14 is of vertical type (Y direction) and lateral type (X direction), respectively. In Figures 54 and 55, since as compared with the volume A the volume B can be considered as being very small, it is now assumed that the volume B can be neglected.

Now, the principle of drive of an air cylinder will first be explained. Figure 56 is a model for explaining the principle of driving an air cylinder. While Figure 56 shows an example of vertical type air cylinder, the same principle applies to a lateral type air cylinder. Howevcr, in the case of lateral type, the weight term g is irrelevant and can be neglected. In the drawing, the flow rate Q(t) of inside air of the air cylinder is given by:

$$Q(t) = [MY(t)Y(t) + MY(t)Y(t) + MgY(t) + MY(t)Y(0) + PAY(t)]/RT \quad \text{...(vertical type)}$$

$$Q(t) = [MY(t)Y(t) + MY(t)Y(t) + MY(t)Y(0) + PAY(t)]/RT \quad \text{...(lateral type)}$$

From these equation, the position shift curve of the air cylinder can be differentiated successively three times and, if the initial position of the air cylinder (i.e., the current position thereof) is measured constantly, it is possible to determine the flow rate pattern of air to be supplied to the air cylinder. Further, it is possible to control the air cylinder in accordance with the flow rate pattern, by monitoring the flow rate continuously. Thus, it is possible to move the air cylinder to a desired position correctly.

Figure 57 is a block diagram of a control system for controlling drive of an air cylinder. Figure 58 shows examples of position shift curve of the air cylinder which can be differentiated successively three times. As seen from Figure 58, it is possible to avoid residual vibration due to drive of an air cylinder, by making equal to "zero" each of the speed Y (t), acceleration Y(t) and a change Y(t) of acceleration of the air cylinder at the moment of stoppage of the air cylinder.

Figure 59 shows air flow rate curves in a case where the initial position of the air cylinder changes variously, relative to the position shift curves (Figure 58) of the air cylinder which can be differentiated successively three times. Figures 60 and 61 are graphs corresponding to a case where the flow rate curves of Figure 59 are positive and a case where they are negative. Figures 60 and 61 if combined correspond to the graph of Figure 59.

In accordance with the principle of drive of an air cylinder described above, the manner of driving the air cylinders of Figures 54 and 55 will now be explained. As a common feature, the current position of the air cylinder is measured continuously and, when a position shift curve which can be differentiated successively three times and by which the speed, the acceleration and the acceleration once differentiated of the air cylinder as it is at the target position in the drive, are all made equal to zero are given, the flow rate curve of the air to be supplied to the air cylinder is calculated while taking into account the initial position. Then, by controlling the supply of air into the cylinder in accordance with the flow rate curve, it is possible to drive the air cylinder to the target position. Here, the flow rate to the air cylinder is measured by a flow rate sensor continuously.

First, the timing of opening/closing valves 1 and 2 for driving the air cylinder in accordance with a specified flow rate curve (see Figure 59) will be explained. In the flow rate curve graph (Figure 60), the valve 1 is opened and it is controlled in accordance with the positive flow rate curve. In this occasion, the valve 2 is held closed. Also, when the flow rate curve is negative (Figure 61), the valve 2 is opened and it is controlled in accordance with the negative flow rate curve so that the air is discharged by a pump. In this occasion, the valve 1 is held closed. By opening/closing the valves and controlling them in this manner, it is possible to make the air cylinder drive to its desired value. In order to stop it, both the valves 1 and 2 are closed.

In accordance with this embodiment, when air the cylinder stops, it has no kinetic energy. Further, the linear motor is being stopped or, alternatively, only a drive limited to a very low level acts. Thus, substantially no residual vibration occurs to the movable stage. Consequently, it is possible to provide a high speed stage device of small heat generation.

Tenth Embodiment

A tenth embodiment of the present invention will now be explained. An important feature of this embodiment resides in that a gap or clearance joint having a clearance is provided to connect the second driving means and the stage to each other. Figure 62 shows general structure of the stage device of this embodiment. Figure 63 shows the structure of the second driving means as viewed in the Y direction, and Figure 64 shows the same as viewed in the X direction.

In Figure 62, a stage base 5001 is disposed with its base surface extending vertically (direction of gravity), and a Y stage 5001 of rectangular shape is slidably mounted on the stage base. The stage base 5000 and the Y stage 5001 are guided by a linear air bearing which comprises Y static pressure bearing pressurizing systems 5002 and Y static pressure bearing pads 5003. Y preloading magnet means 5009 is provided so as to hold the stage 5001 on the base 5000 so as to prevent the former from being detached from the latter which is disposed vertically. Mounted through an equalizer mechanism 5004 on the Y stage 5001 is a constant tension spring means 5005 for cancelling the gravity component of the Y stage 5001. the other end of the spring means 5005 is connected to a constant tension spring drum 5006 which is rotatably mounted on the stage base 5000. With this arrangement, the Y stage can be held stationary at a desired position in the Y direction, without being influenced by gravity.

Fixedly mounted on the stage base 5000 are a pair of Y electric cylinders 5007 (second driving means) for moving the Y stage 5001 in the Y direction. Figure 63 shows the structure of the Y electric cylinder. Y motor (drive source) 5100 is provided with an encoder 5101, and it moves a Y rod 5105 in the Y direction through a Y drive screw 5103 which is rotated through a gear 5102. These components are housed in a casing 5106, and constitute the Y electric cylinder 5007. The Y rod 5105 is provided at an end thereof with an actuator side block 5107. Also, it is provided with a stage side block 5108. This block 5108 covers the actuator side block 5107. The thickness of the actuator side block 5107 is slightly smaller than the space of the stage side block 5108 in the Y direction, whereby a gap or clearance joint is provided. With this gap joint, the Y electric cylinder 5007 is connected to the Y stage 5001 with a small clearance.

First driving means in the Y direction comprises a pair of Y linear motor coils 5020 fixedly mounted on the stage base 5000, and a pair of movable magnets mounted on the Y stage 5001 so as to be opposed to these coils. Thus, Y linear motor is provided. Inside the Y stage 5001, an X stage 5010 is supported through a Y linear motor coupling plate 5030.

With respect to the X direction, as shown in Figure 64, the X stage 5010 is guided by a linear air bearing including an X static pressure bearing pressurizing system 5011 and X static pressure pads 5012, with the stage base 5000 and a portion of the inside of the Y stage 5001 functioning as a guide surface. Like the Y stage 5001, the X stage 5010 is held on the stage base 5000 by a preloading magnet 5009 provided on the X stage 5010, so as to prevent the X stage from being detached from the stage base.

The Y stage 5001 has an X motor 5014 (second driving means) mounted thereon to move the X stage 5010 in the X direction. X screw shaft 5016 is connected to this X motor 5014 through a coupling 5015. As shown in an enlarged view of Figure 64, the X screw shaft 5016 mesh engages with an actuator block 5018, and the rotation of the X screw shaft 5016 causes movement of the actuator side block 5018 in the X direction. The actuator side block 5018 and the stage side block mounted to the X stage 5010 are coupled to each other with a clearance therebetween, whereby a gap joint is provided therebetween. Thus, a drive force can be transmitted from the actuator side block 5018 to the stage side block 5019, by which the X stage 5019 is moved in the X direction.

Mounted on the Y stage 5001 is an X linear motor coil 5008 which constitutes an X linear motor (first driving means in the X direction). Mounted on the X stage 5010 are a wafer chuck 5100 and a square mirror 5105 for measurement of the X-Y coordinates through cooperation of laser interferometers.

Where a contact portion of the gap joint such as shown in Figure 63 or 64 is covered by with a thin layer of a rubber material, for example, for absorbing impact, the impact force during acceleration or deceleration of the stage can be reduced. Sealing the gap joint with an elastmeric sealing material such as a bellows may be preferable since generation of dust is minimized.

Now, the positioning control with respect to the X direction in the structure described above, will be explained. Essentially the same explanation applies to the positioning control with respect to the Y direction. First, an electric energy for the stepwise motion of the X stage stage 5010 is applied to the rotary motor 5014 (second driving means). In response, the X screw shaft 5016 rotates to move the actuator block 5018 and presses the same against the stage side block 5019. By this, a drive is applied, and the stage 5010 moves stepwise. At this time, the output of the first driving means (linear motor) is intercepted by a switch so that it produces no drive or, alternatively, it produces a limited, very small drive. Therefore, heat generation is sufficiently suppressed to a level that can be neglected. Closing to completion of the stepwise motion, the first driving means (linear motor) is switched to produce a drive for the positioning. As a trigger for this switching, the stage position or the time may be used.

Here, the clearance of the gap joint is set to be larger than the required positional precision. This is a requisition for keeping the stage out of contact to the gap joint when it is positioned by the first driving means (linear motor). Practically, the clearance may preferably be several microns to several tens microns. With this clearance, the coupling of the stage with the motor and the screw shaft is disconnected, and only the first driving means (linear motor) is connected to the first driving means. In this state, the linear motor is driven through a closed loop control in which the stage position is fed back. Thus, a high mechanical rigidity system is easily assured and high gain (high precision) and stable position control is ensured. As regards heat generation during the positioning operation through the linear motor, the motor and the screw shaft do not generate heat or they are cooled. Moreover, the stepwise motion has already been substantially finished. Therefore, heat generation if any is very low as compared with that during the stepwise motion.

Figure 65 is a block diagram of an example of control system of this embodiment. Figure 66 is a time chart wherein the portion (a) shows the relation between the position and the time after supply of an instruction signal, the portion (b) shows the relation between the position of the switch and the time after the application of the instruction signal, and the portion (c) shows the relation between the linear motor current and the time after the application of the instruction signal.

When an instruction signal is applied, in Figure 65 the switch 1 is open at that moment. Therefore, a drive current is supplied only to the motor of the second driving means illustrated in the lower half of Figure 65. In response, a drive produced by the motor is transmitted through the gap joint to the stage to accelerate the same, whereby it is moved stepwise in accordance with the position vs. time relation such as depicted by a curve in the portion (a) of Figure 66. At this moment, i.e., when in the portion (b) of Figure 66 the switch 1 is at the position disconnecting the linear motor, no current is applied to the linear motor such as shown in the portion (c) of Figure 66.

As the stage comes close to the target position in accordance with the curve shown in the portion (a) of Figure 66 and when the difference from the target position comes into a predetermined tolerance, the switch 1 is closed to the side connecting the linear motor (Figure 66, (b)). In response, a current is supplied to the linear motor (Figure 66, (c)) so that it applies a drive to the stage. On the other hand, the second driving means is positioned by a servo mechanism which is separate from the stage, and it does not contact with the stage. Thus, no drive is transmitted to the stage. Namely, only the linear motor can control the position of the stage. Here, the linear motor need only to produce a force to absorb disturbance, tending to cause vibration of the stage. Such force that absorbs the disturbance corresponds to the amplitude of oscillating wave shown in Figure 66, (c).

Figures 67 and 68 are a block diagram and a time chart, showing a modified form of the preceding embodiment. In this example, the timing for start of drive of the linear motor is changed, to the time period with reference to start of stepwise motion. The remaining portion is the same as the preceding embodiment.

Figures 69 and 70 are a block diagram and a time chart, showing a further modified form. In this example, the linear motor is driven continuously with limited current, and no drive stating switch is defined. The remaining portion is the same as the preceding embodiment.

While some examples of the position control have been explained above, speed control may preferably done in the following manner: For constant speed motion of the X stage in the X direction, for example, it is accelerated to a target speed while keeping the actuator side block pressed against the stage side block. Whether the target speed is reached or not is monitored continuously by using a speed detecting means (not shown). As the target speed is reached, the motor is controlled to keep the actuator side block and the stage side block out of contact to each other. To this end, a proximity sensor may be provided between these blocks and the output of the sensor may be fed back to control the motor. Alternatively, the stage position and the motor position may be detected separately, and both of these positions may be fed back to control the motor. In this state, only an air resistance and shearing resistance from the linear air baring act on the stage. Thus, the linear motor need only to produce a force which absorbs these resistances. This arrangement has an advantage that what is required for the motor control is only to keep the blocks out of contact to each other. This means that a small error in the clearance is allowed: namely, a very high precision is unnecessary for the control. In a conventional system wherein a motor and a stage is continuously connected to each other, the motor speed and the stage speed exactly correspond to each other. Therefore, unless the motor itself is controlled very precisely, the motor may have an influence upon the stage as disturbance. In the system of the the present embodiment wherein the connection between the motor and the stage is intercepted during the constant speed motion, such disturbance to the stage is reduced considerably.

Eleventh Embodiment

Figure 71 shows the structure of an eleventh embodiment which is a modified form of the tenth embodiment (Figures 62 and 63). In the preceding embodiment, a constant tension spring system is used as a means for cancelling the weight of the Y stage, in this embodiment an end of the Y electric cylinder rod and the Y stage are coupled with each other by a coiled spring means 5200 to thereby cancel the gravity. The remaining portion is of the same structure as of the tenth embodiment.

Figure 72 shows details of the coiled spring means 5200. An end of the coiled spring 5200 is connected to the end of the Y rod 5105, and the other end of the spring is connected to the Y stage 5001. In parallel to this coiled spring, a gap joint is provided to couple the Y rod 5105 and the Y stage 5001 with each other. Motor 5100 of the Y electric cylinder continuously produces a torque corresponding to the gravity of the Y stage 5001, to thereby cancel the same.

Twelfth Embodiment

Figure 73 shows general structure of a stage device of a twelfth embodiment. Figure 74 is an enlarged view of an X-axis second driving means. X stage 6001 is mounted through a linear air bearing on a base 6000, slidably in the X direction. Y stage 6002 is mounted, through a linear air bearing, within the X stage 6001 slidably in the Y direction. There are provided two lines of driving systems for the X stage 6001: i.e., first driving means including a linear motor (stationary pieces 6008 and 6009 and a movable piece 6010) and second driving means including an X motor 6003 fixed to the base 6000, a capstan 6004, a driving block 6005 and a guide bar 6006. The driving block 6005 is made slidable in the X direction, along the guide bar 6006 which is fixed to a bar block 6007 on the base 6000. As a rotary drive of the X motor 6003 is transmitted through the capstan 6004, the driving block 6005 moves in the X direction.

As shown in Figure 74, the driving block 6005 has end portions sandwiching the X stage 6004 therebetween, with small clearances. As a result, the driving block 6005 moved in the X direction is coupled to the X stage 6001 with a small clearance.

Also, for driving the Y stage 6002, there are provided two lines of systems: that is, first driving means including a Y linear motor (stationary piece 6012 and movable piece 6013) and second driving means including a Y air cylinder 6011. The Y air cylinder 6011 is of the same structure as described with reference to Figures 28 and 29.

The stage device of this embodiment of the structure described above is controlled with respect to the X direction essentially in the same manner as described with reference to Figures 62 - 64 and, with respect to the Y direction, in the same manner as described with reference to Figures 28 and 29.

Thirteenth Embodiment

Next, description will be made on an embodiment of a semiconductor device manufacturing method wherein an exposure apparatus having a stage device such as describe above is used.

Figure 75 is a flow chart of the sequence of manufacturing a semiconductor device such as a semiconductor chip (e.g. IC or LSI), a liquid crystal panel or a CCD, for example. Step 1 is a design process for designing the circuit of a semiconductor device. Step 2 is a process for manufacturing a mask on the basis of the circuit pattern design. Step 3 is a process for manufacturing a wafer by using a material such as silicon.

Step 4 is a wafer process which is called a pre-process wherein, by using the so prepared mask and wafer, circuits are practically formed on the wafer through lithography. Step 5 subsequent to this is an assembling step which is called a post-process wherein the wafer processed by step 4 is formed into semiconductor chips. This step includes assembling (dicing and bonding) and packaging (chip sealing). Step 6 is an inspection step wherein operability check, durability check and so on of the semiconductor devices produced by step 5 are carried out. With these processes, semiconductor devices are finished and they are shipped (step 7).

Figure 76 is a flow chart showing details of the wafer process. Step 11 is an oxidation process for oxidizing the surface of a wafer. Step 12 is a CVD process for forming an insulating film on the wafer surface. Step 13 is an electrode forming process for forming electrodes on the wafer by vapor deposition. Step 14 is an ion implanting process for implanting ions to the wafer. Step 15 is a resist process for applying a resist (photosensitive material) to the wafer. Step 16 is an exposure process for printing, by exposure, the circuit pattern of the mask on the wafer through the exposure apparatus described above. Step 17 is a developing process for developing the exposed wafer. Step 18 is an etching process for removing portions other than the developed resist image. Step 19 is a resist separation process for separating the resist material remaining on the wafer after being subjected to the etching process. By repeating these processes, circuit patterns are superposedly formed on the wafer.

While the invention has been described with reference to the structures disclosed herein, it is not confined to the details set forth and this application is intended to cover such modifications or changes as may come within the purposes of the improvements or the scope of the following claims.

**Claims**

**1.** A positioning stage device comprising:

a base stage (102) and a movable stage (105) supported on said base stage (102) for translational movement with respect to said base stage (102) along a predetermined direction (y);
coarse motion driving means (109,121) directly engaging said movable stage (105) for providing a relatively coarse positioning of said movable stage (105) within a first range along said direction (y), and
fine motion driving means (123,124) for providing a relatively fine positioning of said movable stage (105) along said direction (y) and within said first range, characterised in that
said fine motion driving means (123,124) engages directly with said movable stage (105) and with said base stage (102), such that the moving force exerted by said fine motion driving means (123,124) is directly applied between said movable stage (105) and said base stage (102).

**2.** A device according to claim 1, wherein said fine motion driving means (123,124) comprises a linear motor.

**3.** A device according to claim 1, wherein said coarse motion driving means (109,121) uses a rotary drive force of a rotary motor.

**4.** A device according to claim 1, wherein said coarse motion driving means (109,121) uses a gas pressure.

**5.** A device according to claim 4, wherein said coarse motion driving means (109,121) comprises a gas cylinder and control means for controlling supply of a gas to said gas cylinder.

**6.** A device according to claim 1, wherein said coarse motion driving means (109,121) and the movable stage (105) are coupled with each other through a resilient member which is deformable with respect to the movement direction.

**7.** A device according to claim 6, further comprising means for detecting displacement of said resilient member, and control means for moving the movable stage (105) on the basis of an output of said detecting means.

**8.** A device according to claim 6, further comprising second control means for controlling said coarse motion driving means (109,121) in accordance with an acceleration curve which can be differentiated with respect to time.

**9.** A device according to claim 1, wherein said coarse motion driving means (109,121) and the movable stage (105) are disengageably coupled with each other through a disengageable clutch.

**10.** A device according to claim 1,wherein said coarse motion driving means (109,121) and the movable stage (105) are coupled with each other through a joint having a clearance in the predetermined direction (y).

**11.** A device according to claim 1, wherein the device is arranged such that the movable stage (105) is to be moved in the predetermined direction (y) against or assisted by gravity.

**12.** A pattern transfer system including a stage device, comprising:

the positioning stage device according to any preceding claim; and

means for transferring a pattern onto a substrate (101) placed on the movable stage (105).

13. A system according to claim 12, wherein the substrate (101) comprises a semiconductor wafer, and a circuit pattern is transferred thereto by said system.

14. A method of processing a substrate by means of a system according to claim 12 or claim 13, wherein a pattern is repeated stepwise over the substrate (101) and wherein the major part of the stage (105) and substrate (101) motion between repetitions is effected generally by the coarse motion driving means (109,121), with fine positioning of the pattern being effected by the fine motion drive means (123,124).

15. A method of manufacturing a semiconductor device comprising the method of claim 14 wherein the substrate (101) comprises a semiconductor wafer, and a circuit pattern is transferred thereto stepwise.

## Patentansprüche

1. Eine Positionierbühnenvorrichtung, die umfaßt:

   - eine Bühnenbasis (102) sowie eine an der genannten Bühnenbasis (102) für eine translatorische Bewegung mit Bezug zu der genannten Bühnenbasis (102) längs einer vorbestimmten Richtung (y) gelagerte bewegbare Bühne (105);
   - Grobbewegung-Antriebseinrichtungen (109, 121), die unmittelbar an der besagten bewegbaren Bühne (105) angreifen, um ein relativ grobes Positionieren der besagten bewegbaren Bühne (105) innerhalb eines ersten Bereichs längs der erwähnten Richtung (y) herbeizuführen, und
   - Feinbewegung-Antriebseinrichtungen (123, 124), um ein relativ feines Positionieren der besagten bewegbaren Bühne (105) längs der erwähnten Richtung (y) sowie innerhalb des genannten ersten Bereichs zu bewerkstelligen,

   dadurch gekennzeichnet, daß

   - die erwähnten Feinbewegung-Antriebseinrichtungen (123, 124) unmittelbar mit der besagten bewegbaren Bühne (105) sowie mit der genannten Bühnenbasis (102) derart verbunden sind, daß die von den erwähnten Feinbewegung-Antriebseinrichtungen (123, 124) ausgeübte Bewegungskraft direkt zwischen der besagten bewegbaren Bühne (105) sowie der genannten Bühnenbasis (102) aufgebracht wird.

2. Eine Vorrichtung nach Anspruch 1, in welcher die erwähnten Feinbewegung-Antriebseinrichtungen (123, 124) einen Linearmotor umfassen.

3. Eine Vorrichtung nach Anspruch 1, in welcher die besagten Grobbewegung-Antriebseinrichtungen (109, 121) von einer Drehantriebskraft eines drehenden Motors Gebrauch machen.

4. Eine Vorrichtung nach Anspruch 1, in welcher die besagten Grobbewegung-Antriebseinrichtungen (109, 121) von einem Gasdruck Gebrauch machen.

5. Eine Vorrichtung nach Anspruch 4, in welcher die besagten Grobbewegung-Antriebseinrichtungen (109, 121) einen Gaszylinder sowie Regeleinrichtungen, um eine Zufuhr eines Gases zu dem genannten Gaszylinder zu kontrollieren, umfassen.

6. Eine Vorrichtung nach Anspruch 1, in welcher die besagten Grobbewegung-Antriebseinrichtungen (109, 121) sowie die bewegbare Bühne (105) untereinander durch ein elastisches Bauteil verbunden sind, das mit Bezug auf die Bewegungsrichtung verformbar ist.

7. Eine Vorrichtung nach Anspruch 6, die ferner Mittel, um eine Verlagerung des erwähnten elastischen Bauteils zu erfassen, und Steuereinrichtungen, um die bewegbare Bühne (105) auf der Grundlage eines Ausgangs der besagten Erfassungsmittel zu bewegen, umfaßt.

8. Eine Vorrichtung nach Anspruch 6, die ferner zweite Steuereinrichtungen, um die besagten Grobbewegung-Antriebseinrichtungen (109, 121) in Übereinstimmung mit einer Beschleunigungskurve, welche in bezug auf die Zeit differenziert werden kann, zu steuern, umfaßt.

**9.** Eine Vorrichtung nach Anspruch 1, in welcher die besagten Grobbewegung-Antriebseinrichtungen (109, 121) und die bewegbare Bühne (105) lösbar miteinander durch eine trennbare Kupplung verbunden sind.

**10.** Eine Vorrichtung nach Anspruch 1, in welcher die besagten Grobbewegung-Antriebseinrichtungen (109, 121) und die bewegbare Bühne (105) miteinander durch ein Verbindungselement, das einen Spalt in der vorbestimmten Richtung (y) besitzt, verbunden sind.

**11.** Eine Vorrichtung nach Anspruch 1, in welcher die Vorrichtung so eingerichtet ist, daß die bewegbare Bühne (105) in der vorbestimmten Richtung (y) gegen die oder unterstützt durch die Schwerkraft zu bewegen ist.

**12.** Ein Struktur-Übertragungssystem, das eine Bühnenvorrichtung einschließt, umfaßt:

- die Positionierbühnenvorrichtung nach irgendeinem vorhergehenden Anspruch; und
- Einrichtungen, um eine Struktur auf ein an der bewegbaren Bühne (105) angebrachtes Substrat (101) zu übertragen.

**13.** Ein System nach Anspruch 12, in welchem das Substrat (101) ein Halbleiterwafer umfaßt und eine Schaltungsstruktur durch das genannte System auf dieses übertragen wird.

**14.** Ein Verfahren zur Bearbeitung eines Substrats mittels eines Systems nach Anspruch 12 oder Anspruch 13, in welchem eine Struktur schrittweise über dem Substrat (101) repetiert wird und in welchem der größere Teil der Bewegung der Bühne (105) sowie des Substrats (101) zwischen den Repetiervorgängen allgemein durch die Grobbewegung-Antriebseinrichtungen (109, 121) bewirkt wird, wobei ein Feinpositionieren der Struktur durch die Feinbewegung-Antriebseinrichtungen (123, 124) ausgeführt wird.

**15.** Ein Verfahren zur Herstellung eines Halbleiterbauelements, das das Verfahren des Anspruchs 14 einschließt, in welchem das Substrat (101) ein Halbleiterwafer umfaßt und eine Schaltungsstruktur schrittweise auf dieses übertragen wird.

**Revendications**

**1.** Dispositif à platines de positionnement, comportant :

une platine de base (102) et une platine mobile (105) supportées sur ladite platine de base (102) de façon à effectuer un mouvement de translation par rapport à ladite platine de base (102) suivant une direction prédéterminée (y) ;
des moyens (109, 121) d'entraînement à mouvement grossier en prise directe avec ladite platine mobile (105) pour réaliser un positionnement relativement grossier de ladite platine mobile (105) dans un premier intervalle le long de ladite direction (y) ; et
des moyens (123, 124) d'entraînement à mouvement fin destinés à réaliser un positionnement relativement fin de ladite platine mobile (105) le long de ladite direction (y) et dans ledit premier intervalle, caractérisé en ce que
lesdits moyens (123, 124) d'entraînement à mouvement fin sont en prise directe avec ladite platine mobile (105) et avec ladite platine de base (102), de manière que la force de déplacement exercée par lesdits moyens (123, 124) d'entraînement à mouvement fin soit appliquée directement entre ladite platine mobile (105) et ladite platine de base (102).

**2.** Dispositif selon la revendication 1, dans lequel lesdits moyens (123, 124) d'entraînement à mouvement fin comprennent un moteur linéaire.

**3.** Dispositif selon la revendication 1, dans lequel lesdits moyens (109, 121) d'entraînement à mouvement grossier utilisent une force d'entraînement en rotation d'un moteur rotatif.

**4.** Dispositif selon la revendication 1, dans lequel lesdits moyens (109, 121) d'entraînement à mouvement grossier utilisent une pression gazeuse.

**5.** Dispositif selon la revendication 4, dans lequel lesdits moyens (109, 121) d'entraînement à mouvement grossier comprennent un cylindre à gaz et un moyen de commande pour commander l'alimentation en gaz dudit cylindre à gaz.

**6.** Dispositif selon la revendication 1, dans lequel lesdits moyens (109, 121) d'entraînement à mouvement grossier et la platine mobile (105) sont accouplés entre eux par l'intermédiaire d'un élément élastique qui est déformable par rapport à la direction du mouvement.

**7.** Dispositif selon la revendication 6, comportant en outre des moyens destinés à détecter un déplacement dudit élément élastique, et des moyens de commande destinés à déplacer ladite platine mobile (105) sur la base d'un signal de sortie desdits moyens de détection.

**8.** Dispositif selon la revendication 6, comportant en outre des seconds moyens de commande destinés à commander lesdits moyens (109, 121) d'entraînement à mouvement grossier en fonction d'une courbe d'accélération qui peut être différentiée par rapport au temps.

**9.** Dispositif selon la revendication 1, dans lequel lesdits moyens (109, 121) d'entraînement à mouvement grossier et la platine mobile (105) sont accouplés entre eux de façon débrayable par l'intermédiaire d'un embrayage débrayable.

**10.** Dispositif selon la revendication 1, dans lequel lesdits moyens (109, 121) d'entraînement à mouvement grossier et la platine mobile (105) sont accouplés entre eux par l'intermédiaire d'un joint ayant un jeu dans la direction prédéterminée (y).

**11.** Dispositif selon la revendication 1, dans lequel le dispositif est agencé de façon que la platine mobile (105) doit être déplacée dans la direction prédéterminée (y) contre la pesanteur ou avec l'assistance de la pesanteur.

**12.** Système de transfert de motifs utilisant un dispositif à platines, comportant :

le dispositif à platines de positionnement selon l'une quelconque des revendications précédentes ; et
des moyens destinés à transférer un motif sur un substrat (101) placé sur la platine mobile (105).

**13.** Système selon la revendication 12, dans lequel le substrat (101) comprend une tranche de semiconducteurs, et un motif de circuits est transféré sur celle-ci par ledit système.

**14.** Procédé de traitement d'un substrat au moyen d'un système selon la revendication 12 ou la revendication 13, dans lequel un motif est projeté de façon répétitive sur le substrat (101) et dans lequel la plus grande partie du mouvement de la platine (105) et du substrat (101) entre des répétitions est effectuée globalement par les moyens (109, 121) d'entraînement à mouvement grossier, un positionnement fin du motif étant effectué par les moyens (123, 124) d'entraînement à mouvement fin.

**15.** Procédé de fabrication d'un dispositif à semiconducteurs comprenant le procédé de la revendication 14, dans lequel le substrat (101) comprend une tranche de semiconducteurs, et un motif de circuit est transféré sur cette tranche de façon répétitive.

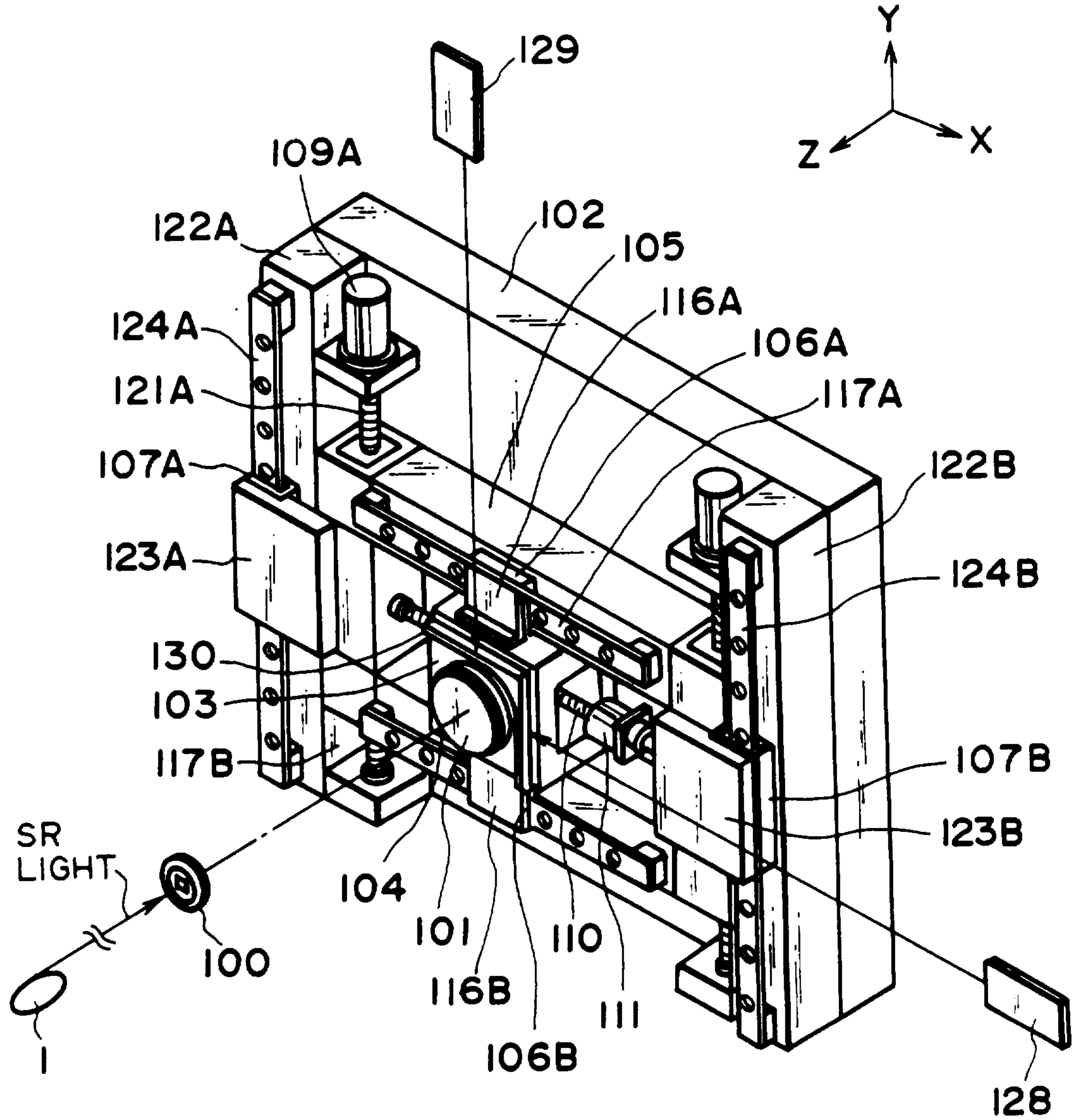
Y
X
Z
129
109A
122A
102
105
116A
124A
106A
121A
117A
107A
122B
123A
124B
130
103
107B
117B
123B
SR
LIGHT
104
100
101
110
116B
I
111
106B
128

FIG. 1

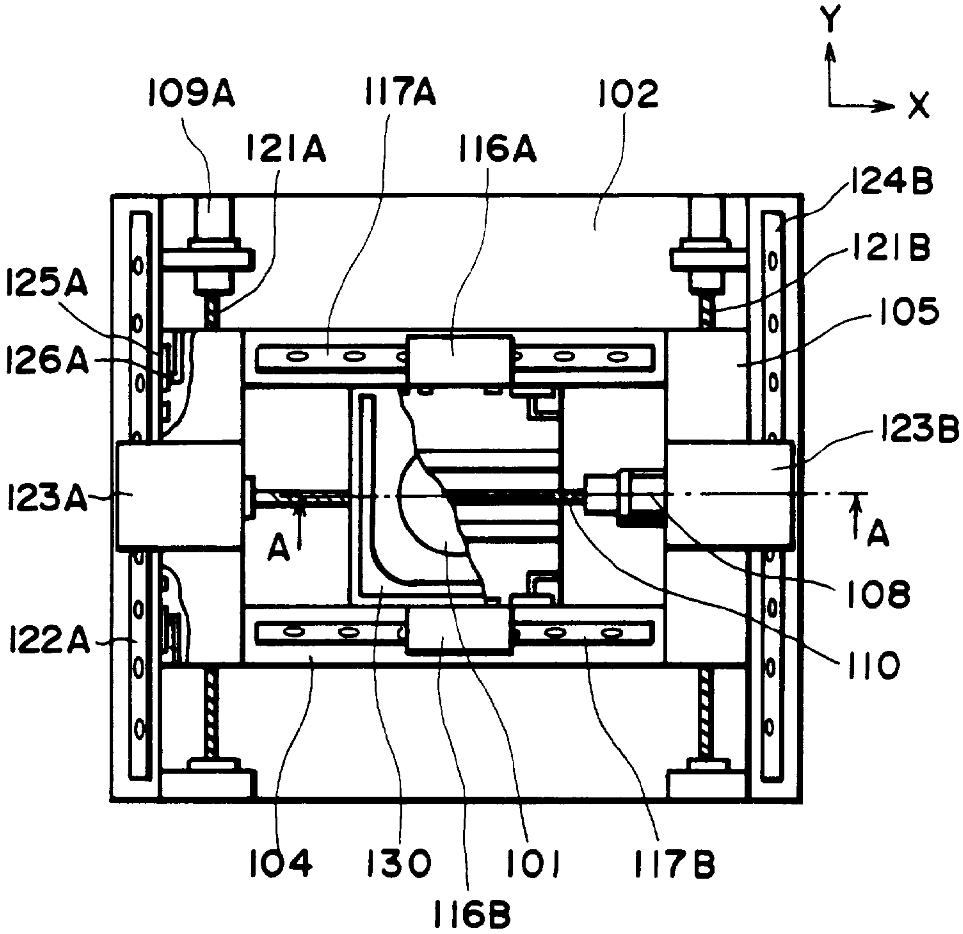
Y
X
109A
117A
102
121A
116A
124B
121B
125A
105
126A
123B
123A
A
A
108
122A
110
104
130
101
117B
116B

FIG. 2A

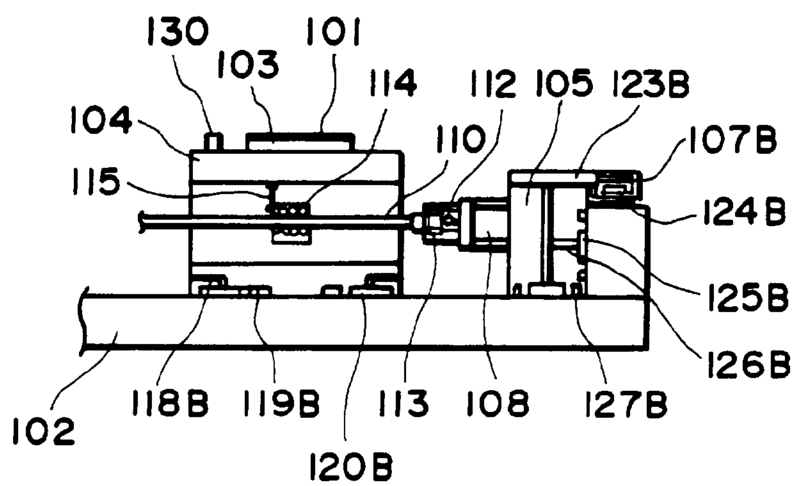
130
101
103
114
112
105
123B
104
110
107B
115
124B
125B
126B
102
118B
119B
113
108
127B
120B

FIG. 2B

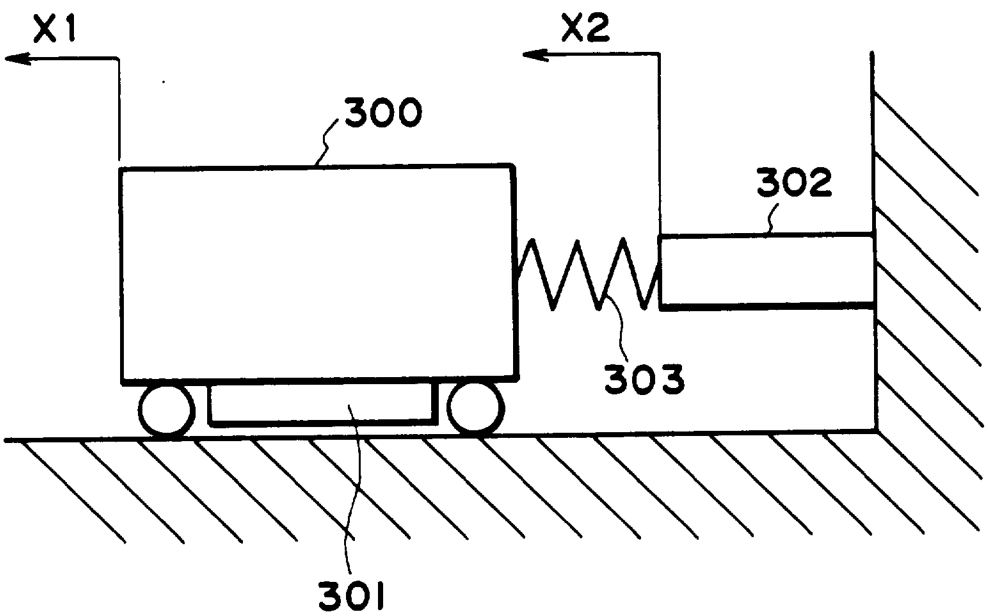


FIG. 3

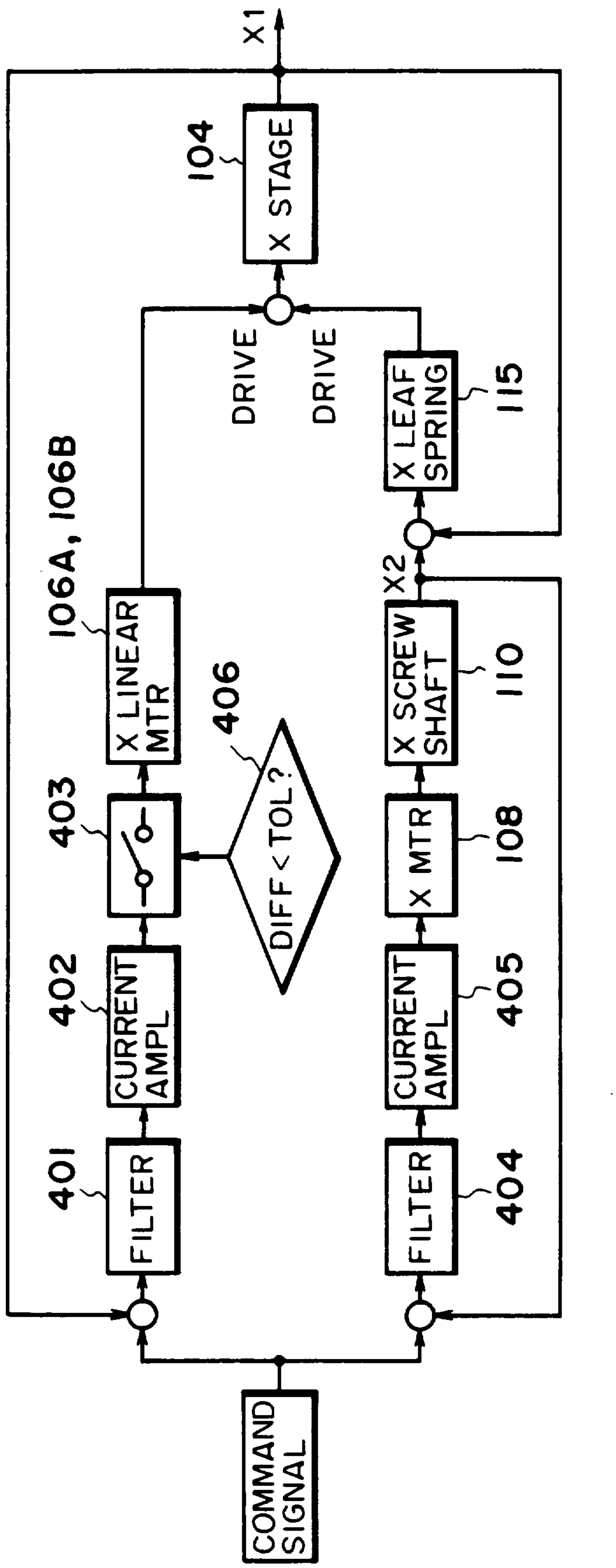
COMMAND SIGNAL
401
FILTER
402
CURRENT AMPL
403
106A, 106B
X LINEAR MTR
406
DIFF<TOL?
DRIVE
DRIVE
104
X STAGE
X1
FILTER
404
CURRENT AMPL
405
X MTR
108
X SCREW SHAFT
110
X2
X LEAF SPRING
115

FIG. 4

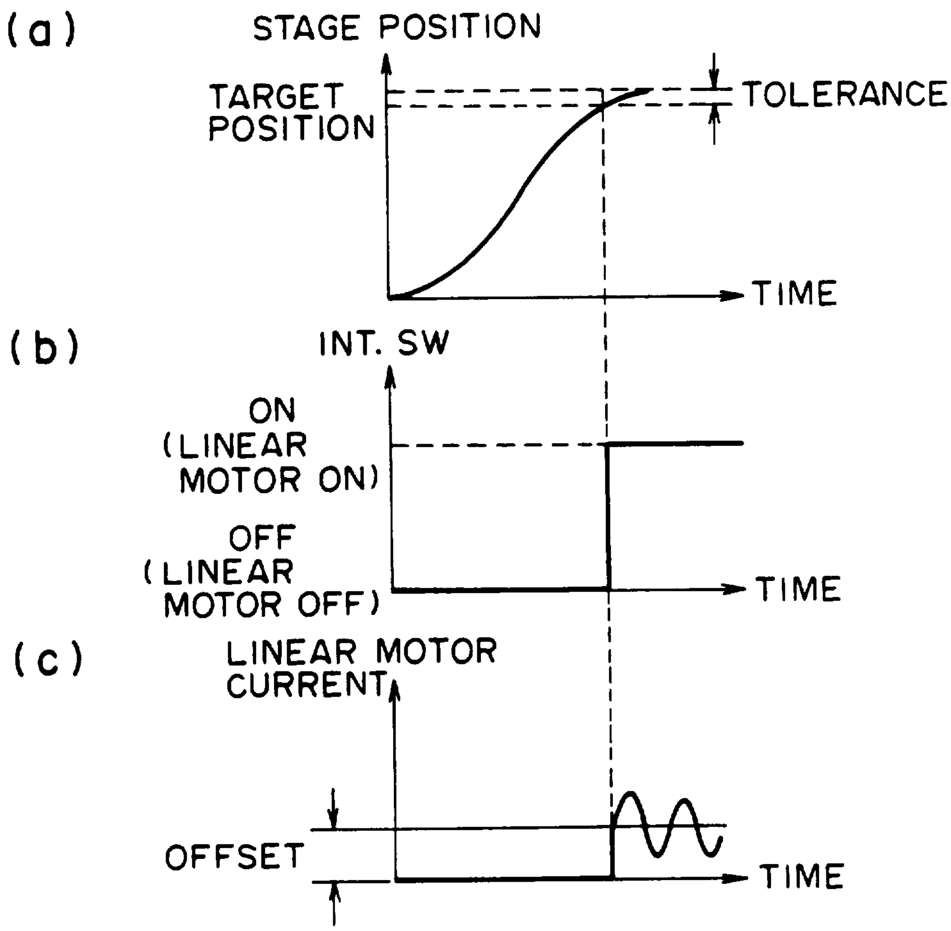
(a)
STAGE POSITION
TARGET POSITION
TOLERANCE
TIME
(b)
INT. SW
ON (LINEAR MOTOR ON)
OFF (LINEAR MOTOR OFF)
TIME
(c)
LINEAR MOTOR CURRENT
OFFSET
TIME

FIG. 5

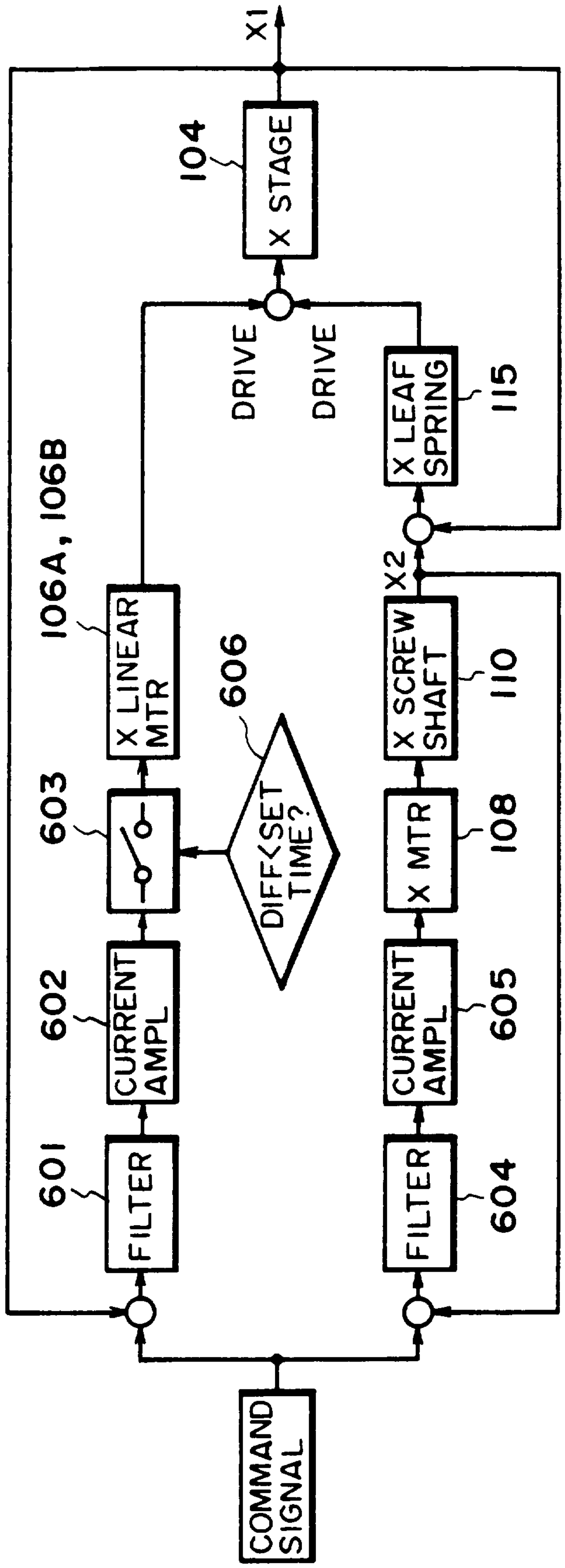
COMMAND SIGNAL
FILTER
601
CURRENT AMPL
602
603
X LINEAR MTR
106A, 106B
DRIVE
DRIVE
X STAGE
104
X1
DIFF<SET TIME?
606
FILTER
604
CURRENT AMPL
605
X MTR
108
X SCREW SHAFT
110
X2
X LEAF SPRING
115

FIG. 6

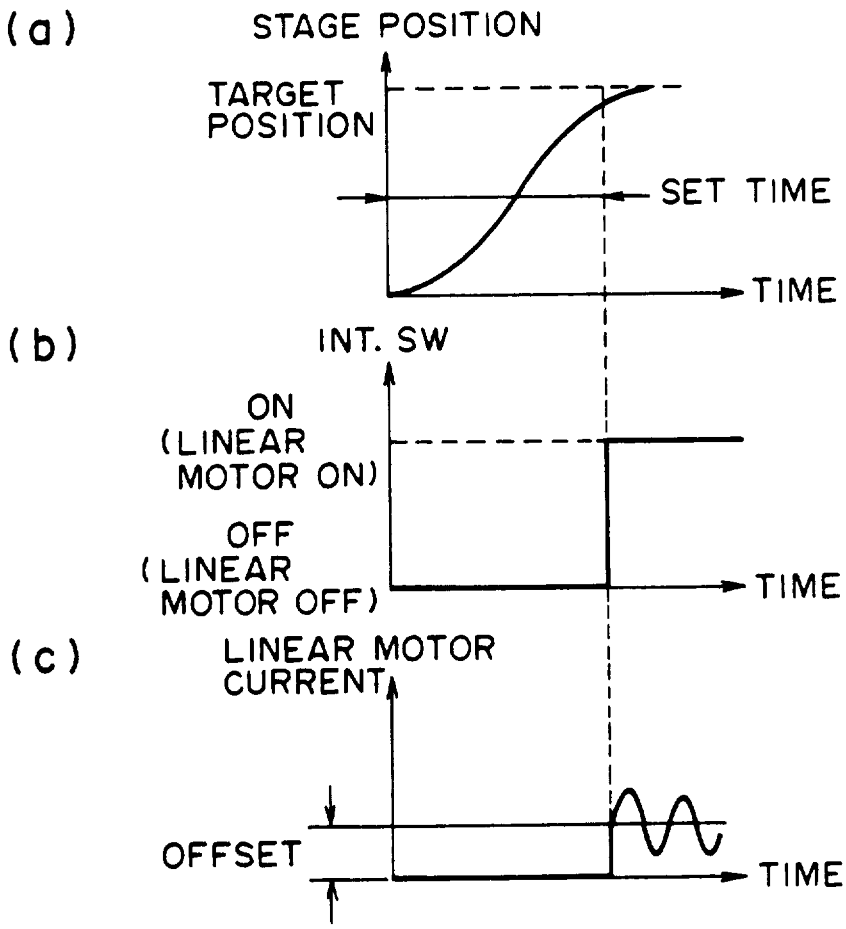
(a)
STAGE POSITION
TARGET POSITION
SET TIME
TIME
(b)
INT. SW
ON (LINEAR MOTOR ON)
OFF (LINEAR MOTOR OFF)
TIME
(c)
LINEAR MOTOR CURRENT
OFFSET
TIME

FIG. 7

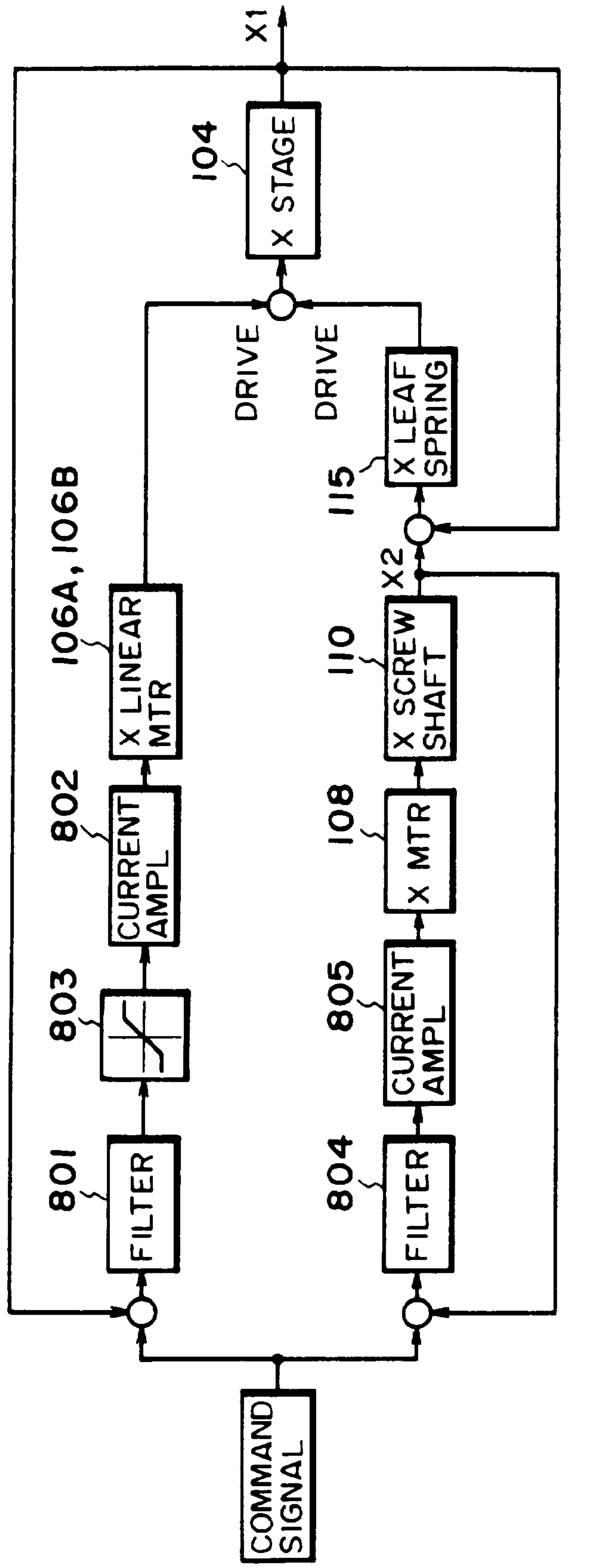
COMMAND SIGNAL
801
FILTER
803
802
CURRENT AMPL
106A, 106B
X LINEAR MTR
DRIVE
104
X STAGE
X1
804
FILTER
805
CURRENT AMPL
108
X MTR
110
X SCREW SHAFT
X2
115
X LEAF SPRING
DRIVE

FIG. 8

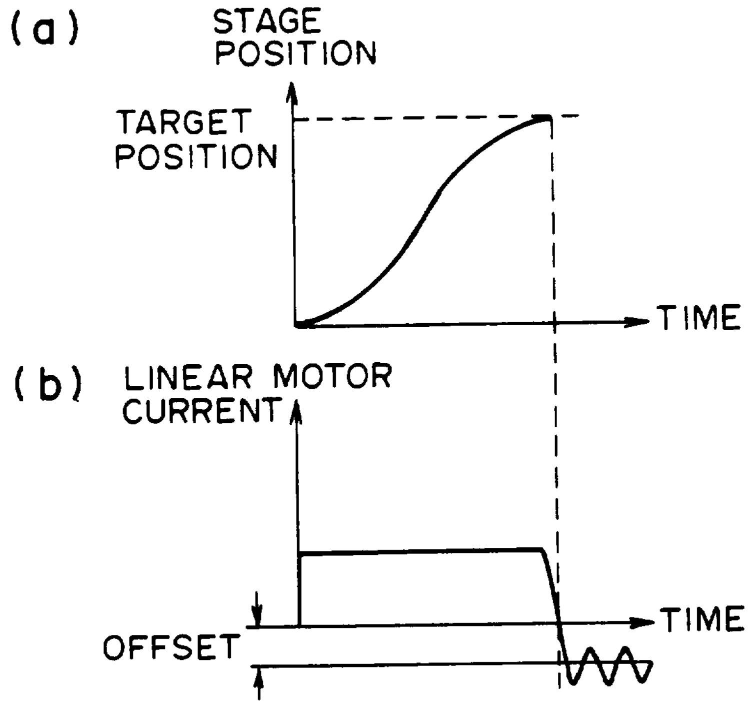
(a)
STAGE POSITION
TARGET POSITION
TIME
(b)
LINEAR MOTOR CURRENT
TIME
OFFSET

FIG. 9

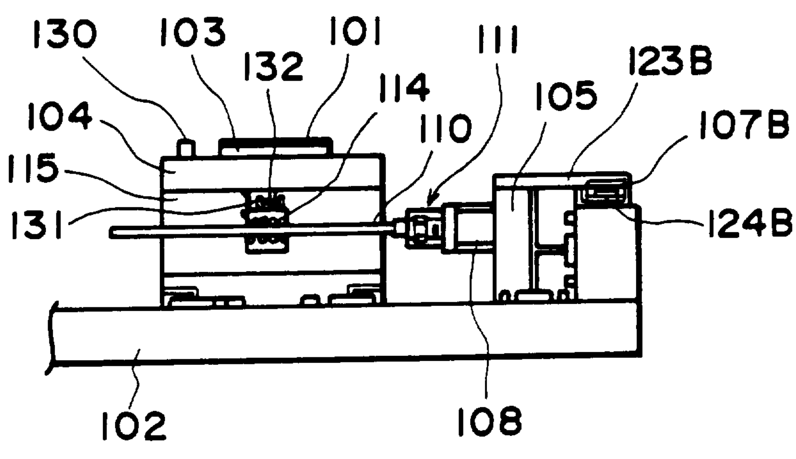
130
103
132
101
111
123B
114
105
104
110
107B
115
131
124B
102
108

FIG. 10

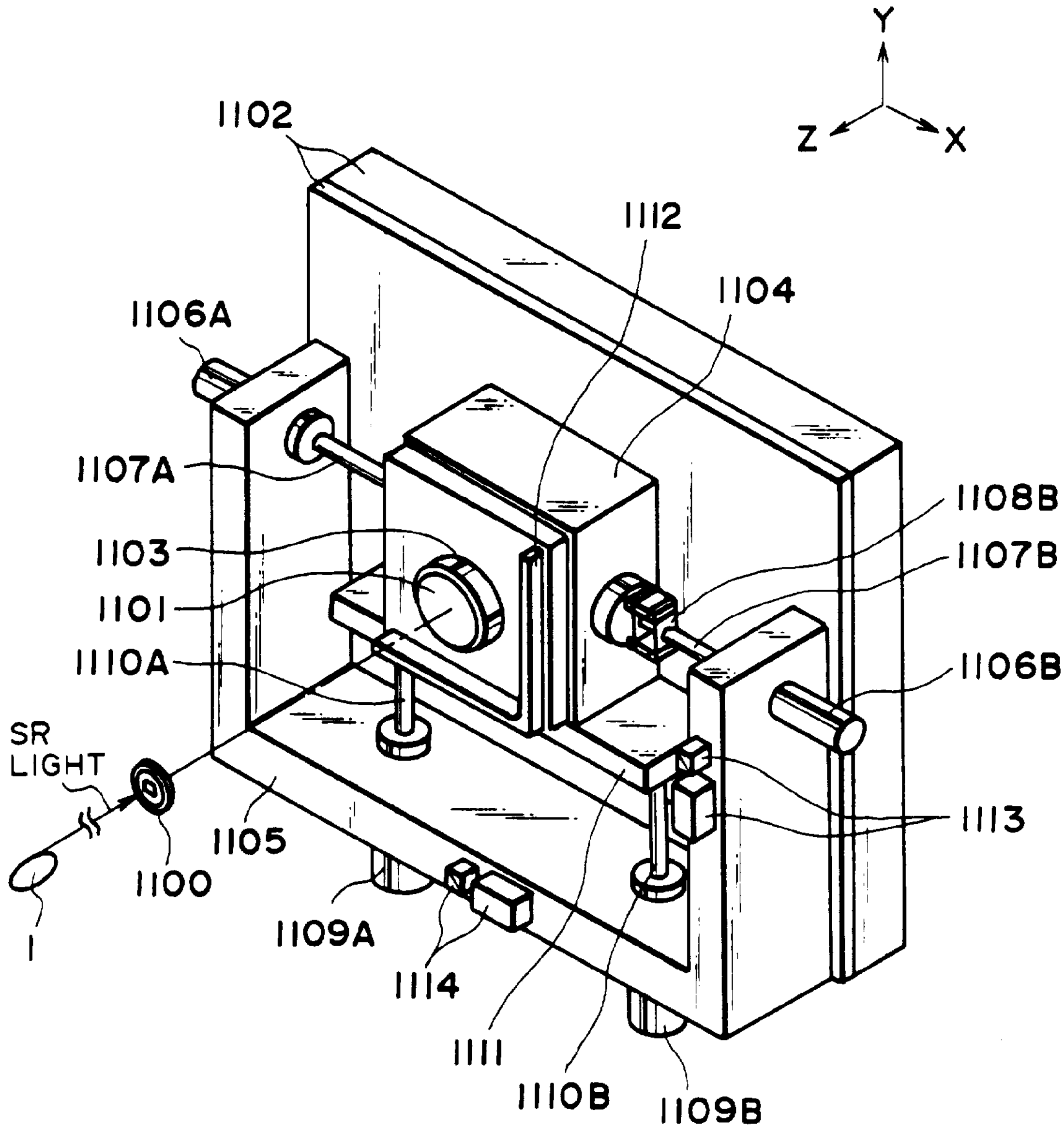
Y
Z
X
1102
1112
1104
1106A
1107A
1108B
1103
1107B
1101
1110A
1106B
SR
LIGHT
1113
1105
1100
I
1109A
1114
1111
1110B
1109B

FIG. 11

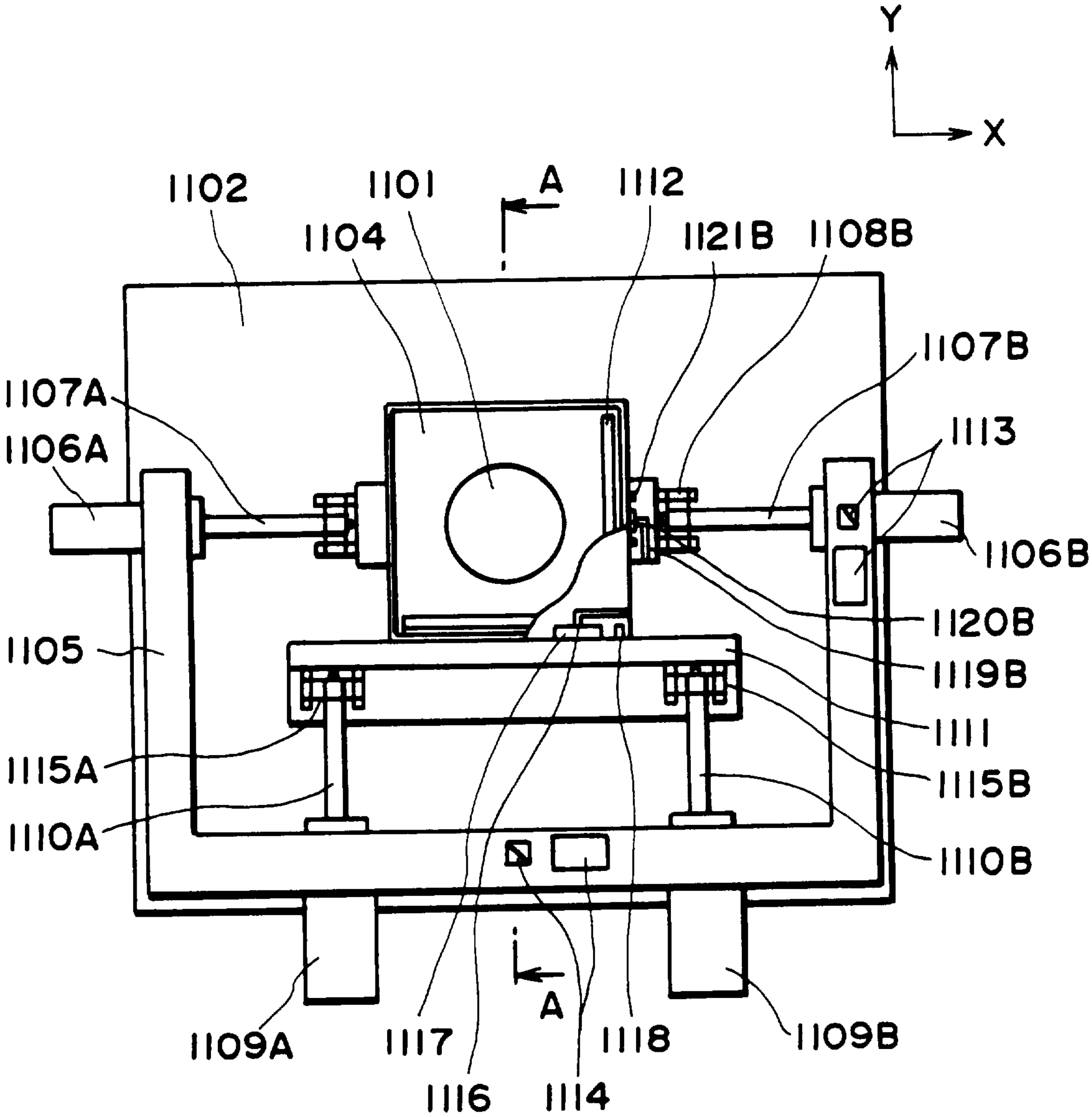
Y
X
1102
1101
A
1112
1104
1121B
1108B
1107B
1107A
1113
1106A
1106B
1105
1120B
1119B
1111
1115A
1115B
1110A
1110B
A
1109A
1117
1118
1109B
1116
1114

F I G. 12

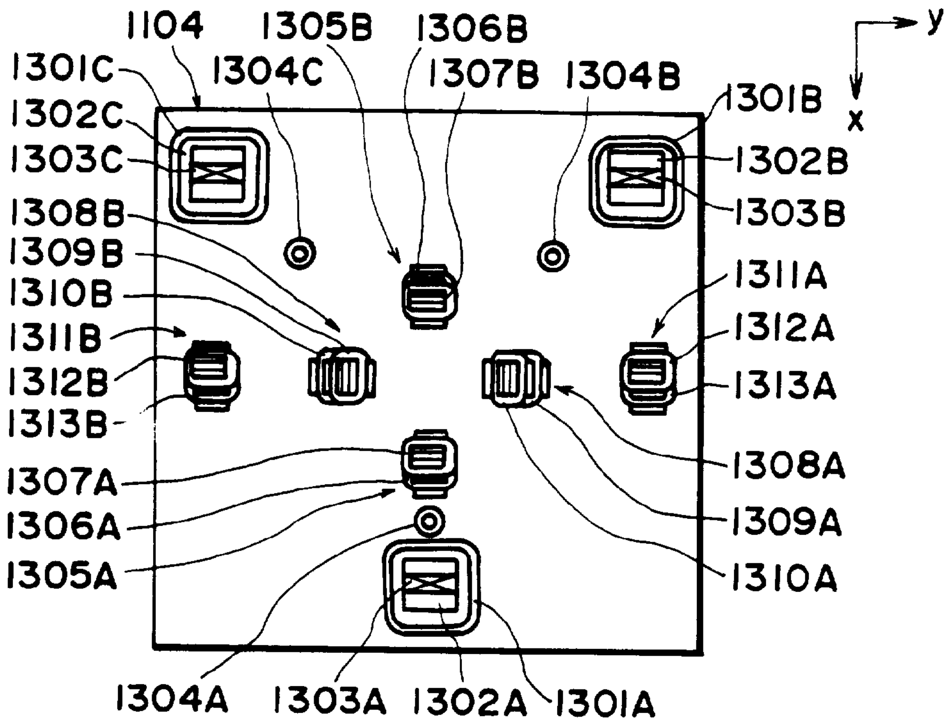


F I G. 13A

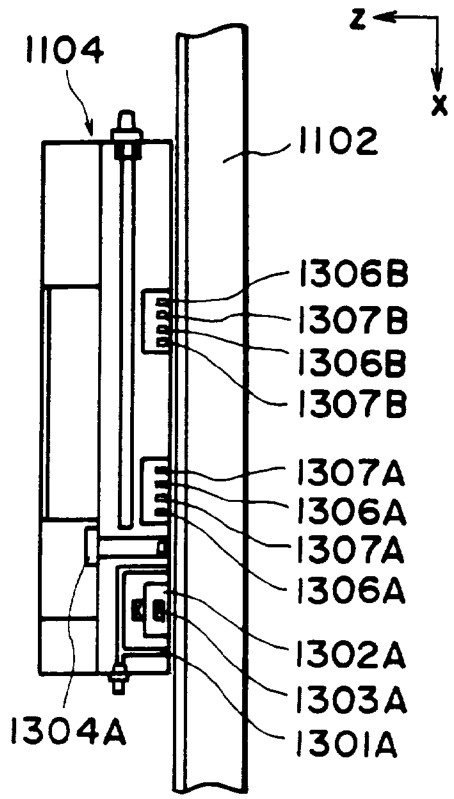


F I G. 13B

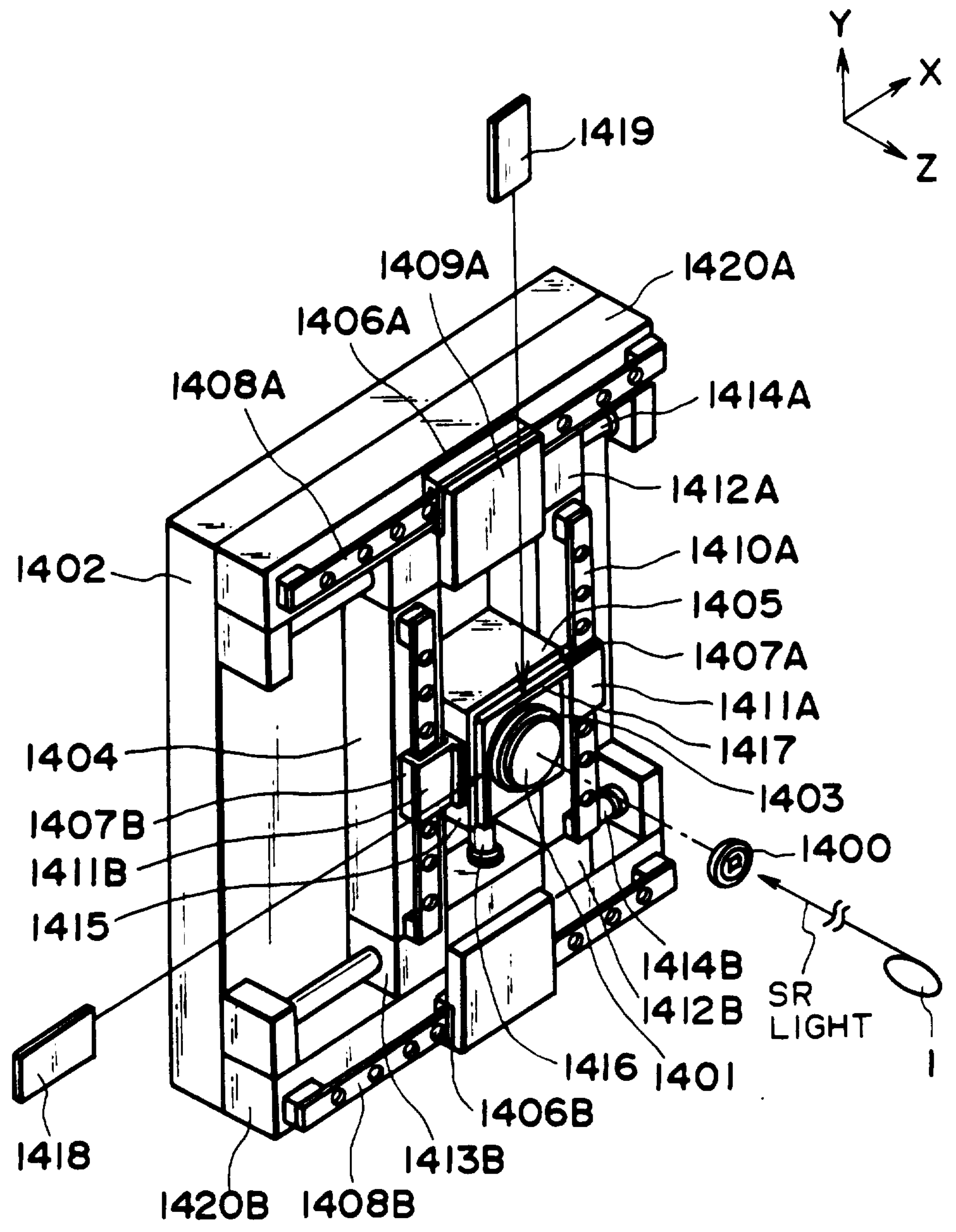
Y
X
Z
1419
1409A
1420A
1406A
1408A
1414A
1412A
1402
1410A
1405
1407A
1411A
1404
1417
1403
1407B
1411B
1400
1415
1414B
SR
LIGHT
1412B
1416
1401
1
1418
1406B
1413B
1420B
1408B

FIG. 14

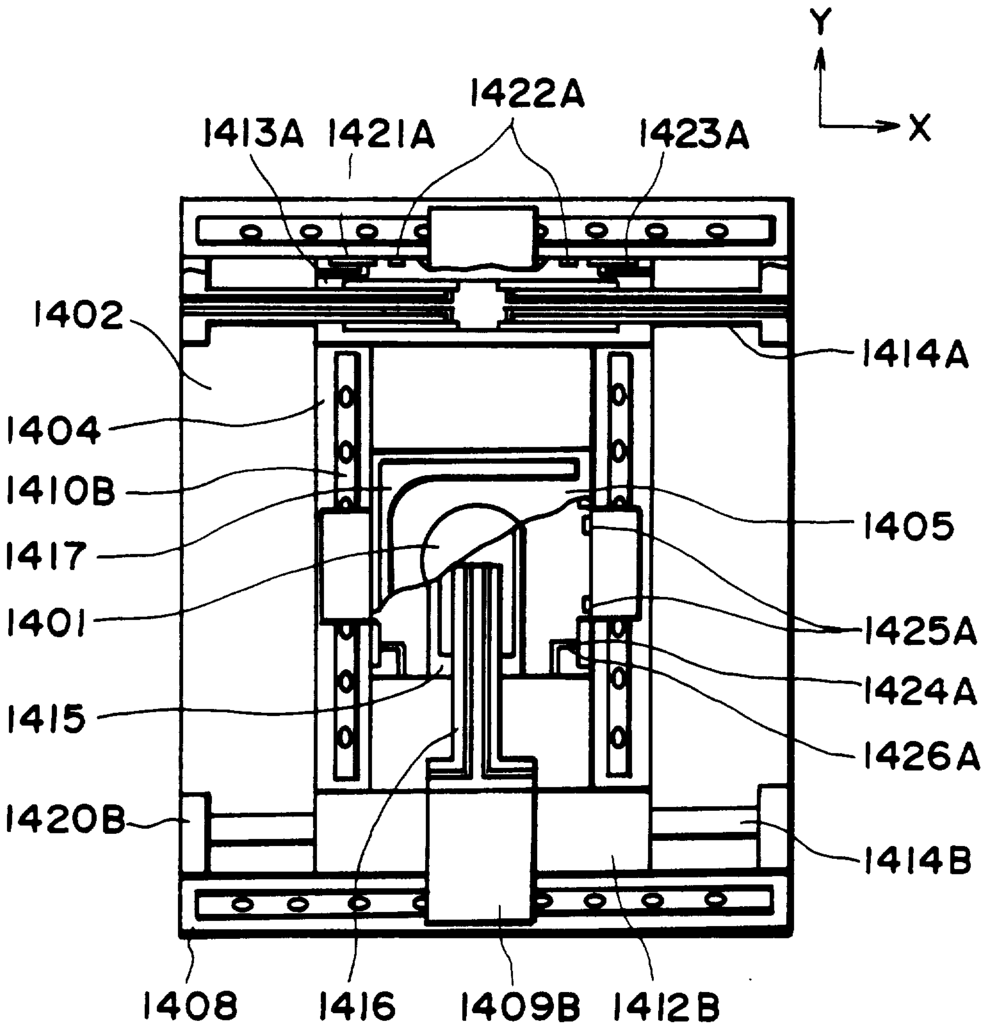
Y
X
1422A
1413A
1421A
1423A
1402
1414A
1404
1410B
1405
1417
1401
1425A
1424A
1415
1426A
1420B
1414B
1408
1416
1409B
1412B

FIG. 15

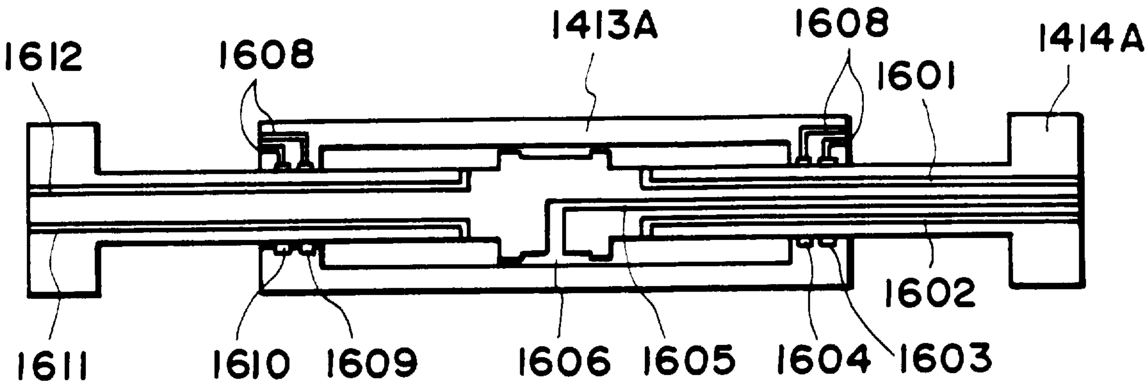
1612
1608
1413A
1608
1414A
1601
1602
1611
1610
1609
1606
1605
1604
1603

FIG. 16

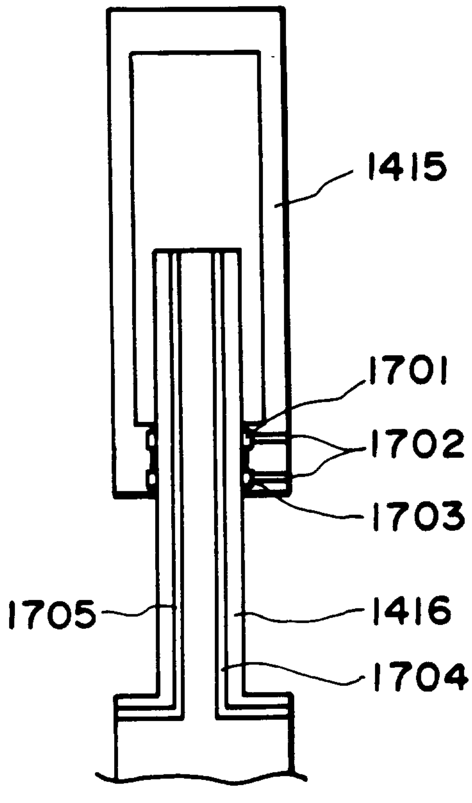
1415
1701
1702
1703
1705
1416
1704

FIG. 17

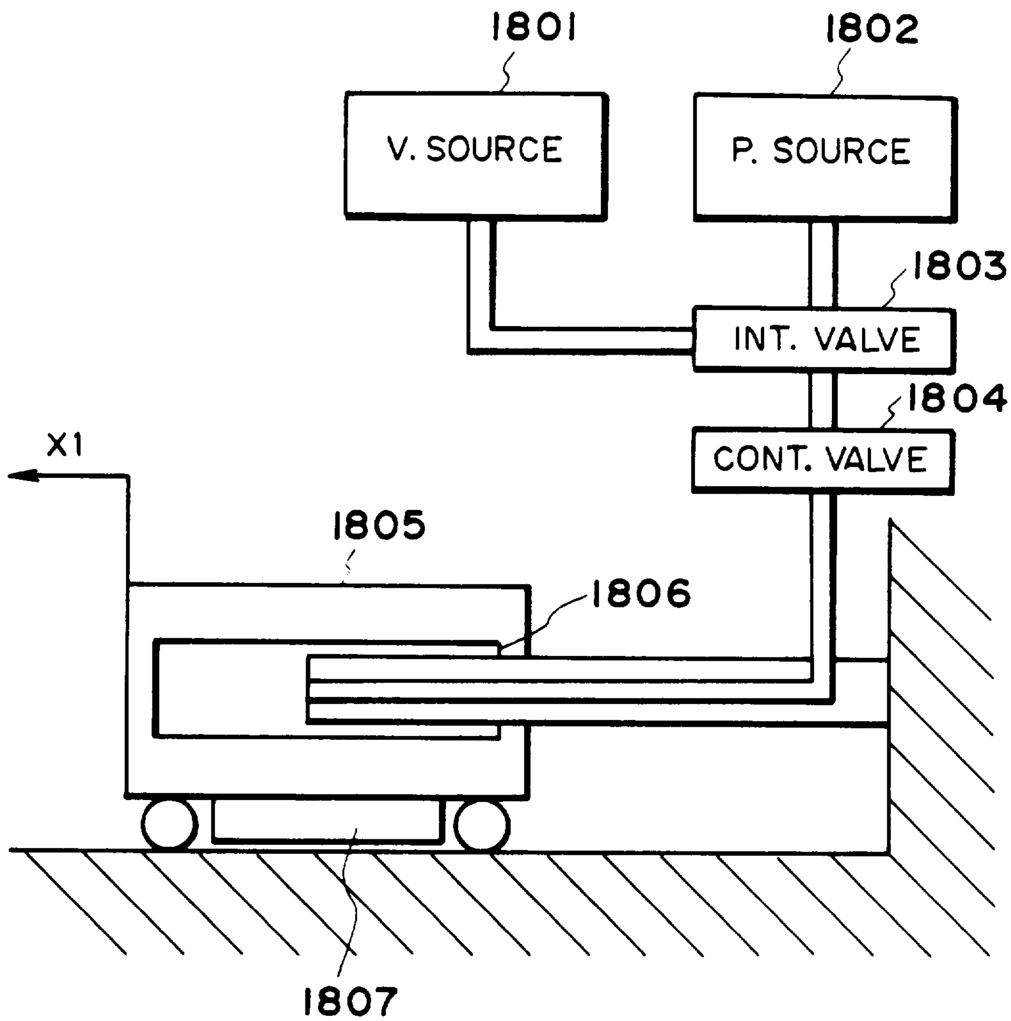
1801
1802
V. SOURCE
P. SOURCE
1803
INT. VALVE
1804
CONT. VALVE
X1
1805
1806
1807

FIG. 18

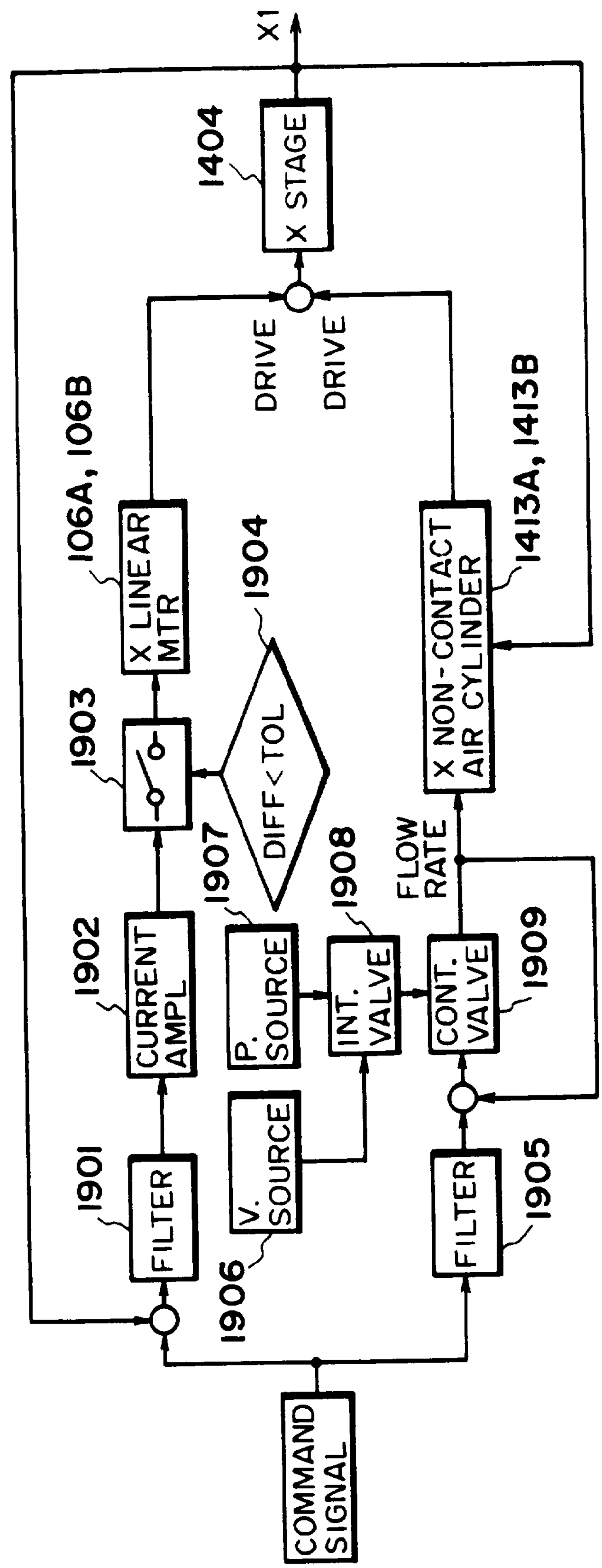
COMMAND SIGNAL
1901
FILTER
1902
CURRENT AMPL
1903
106A, 106B
X LINEAR MTR
1904
DIFF < TOL
1906
V. SOURCE
1907
P. SOURCE
1908
INT. VALVE
1905
FILTER
1909
CONT. VALVE
FLOW RATE
X NON-CONTACT AIR CYLINDER
1413A, 1413B
DRIVE
DRIVE
1404
X STAGE
X1

FIG. 19

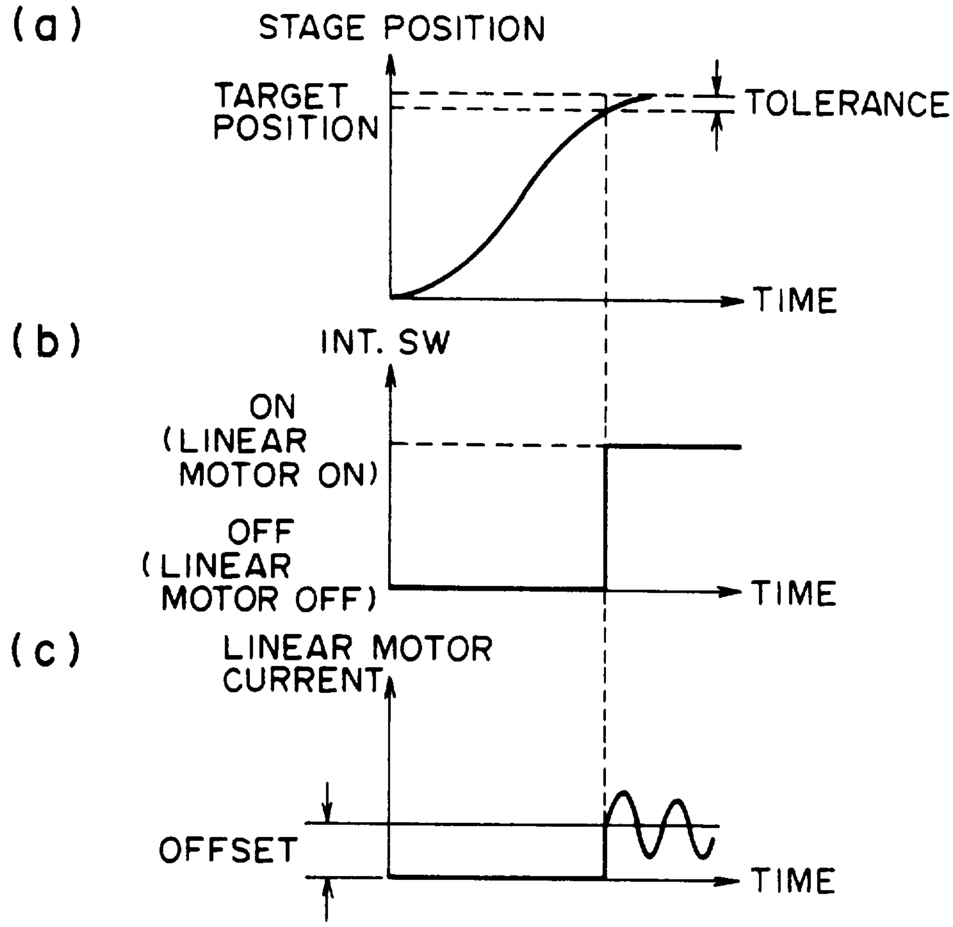
(a)
STAGE POSITION
TARGET POSITION
TOLERANCE
TIME
(b)
INT. SW
ON (LINEAR MOTOR ON)
OFF (LINEAR MOTOR OFF)
TIME
(c)
LINEAR MOTOR CURRENT
OFFSET
TIME

FIG. 20

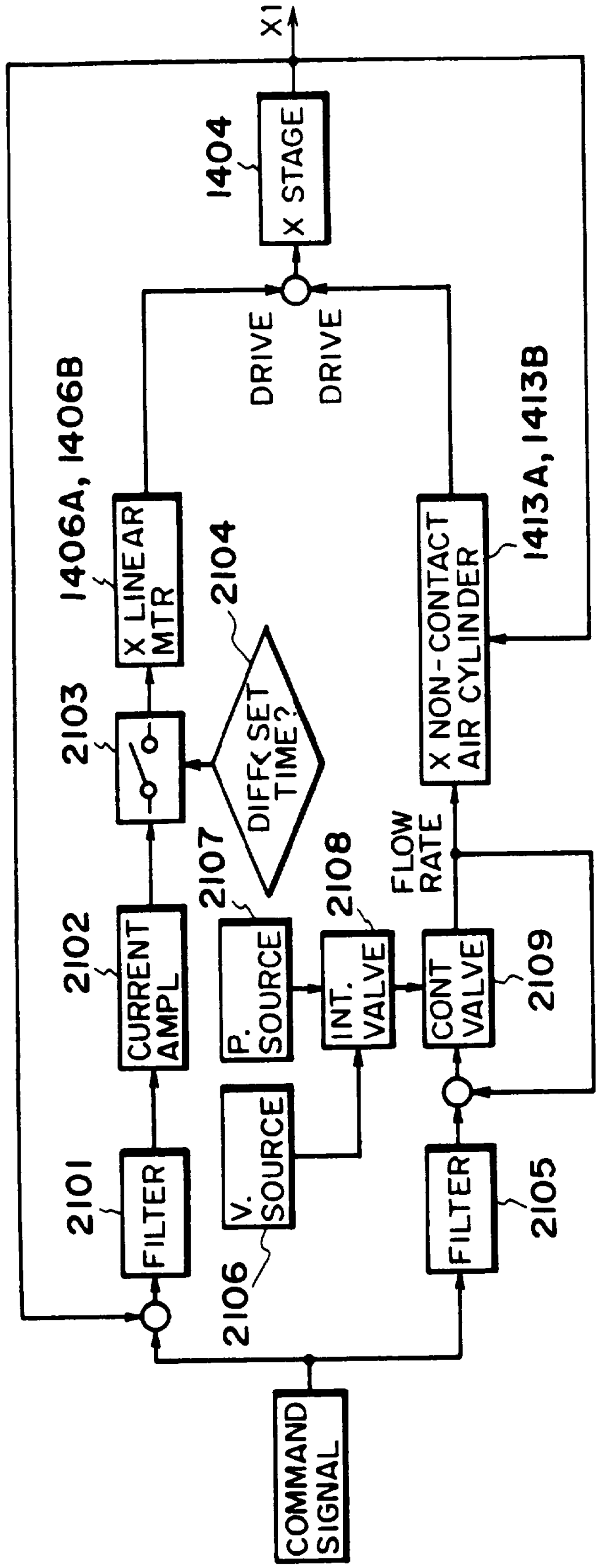
COMMAND SIGNAL
FILTER
2101
CURRENT AMPL
2102
2103
X LINEAR MTR
1406A, 1406B
DIFF< SET TIME?
2104
DRIVE
DRIVE
X STAGE
1404
X1
V. SOURCE
2106
P. SOURCE
2107
INT. VALVE
2108
CONT VALVE
2109
FLOW RATE
X NON-CONTACT AIR CYLINDER
1413A, 1413B
FILTER
2105

FIG. 21

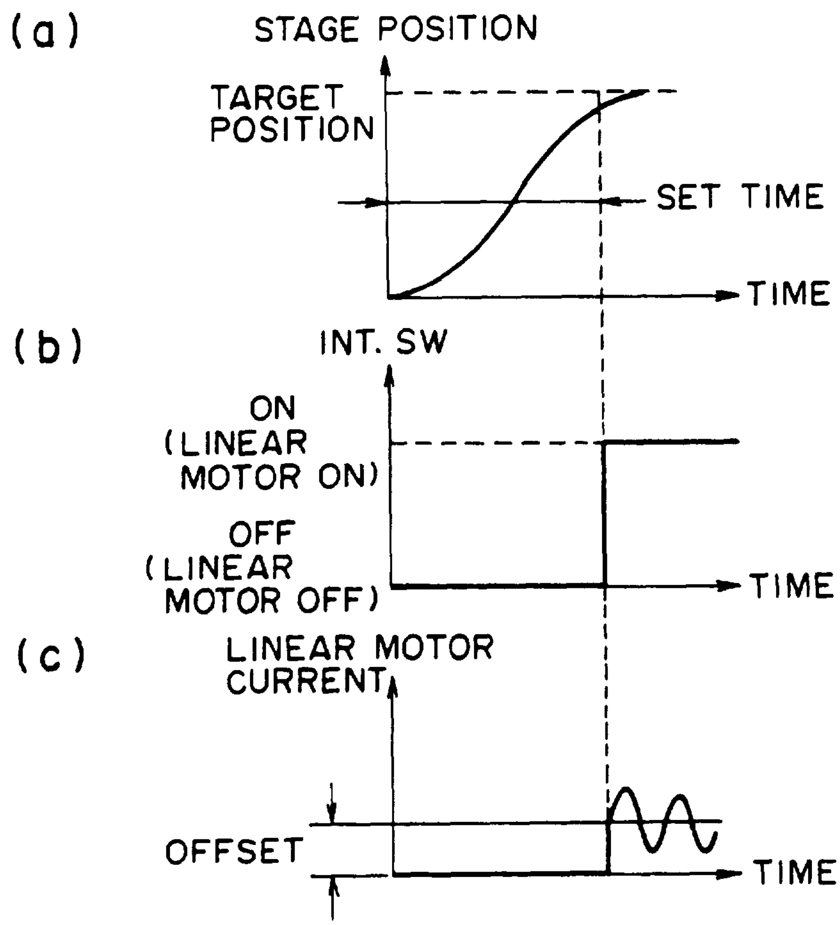
(a)
STAGE POSITION
TARGET POSITION
SET TIME
TIME
(b)
INT. SW
ON (LINEAR MOTOR ON)
OFF (LINEAR MOTOR OFF)
TIME
(c)
LINEAR MOTOR CURRENT
OFFSET
TIME

FIG. 22

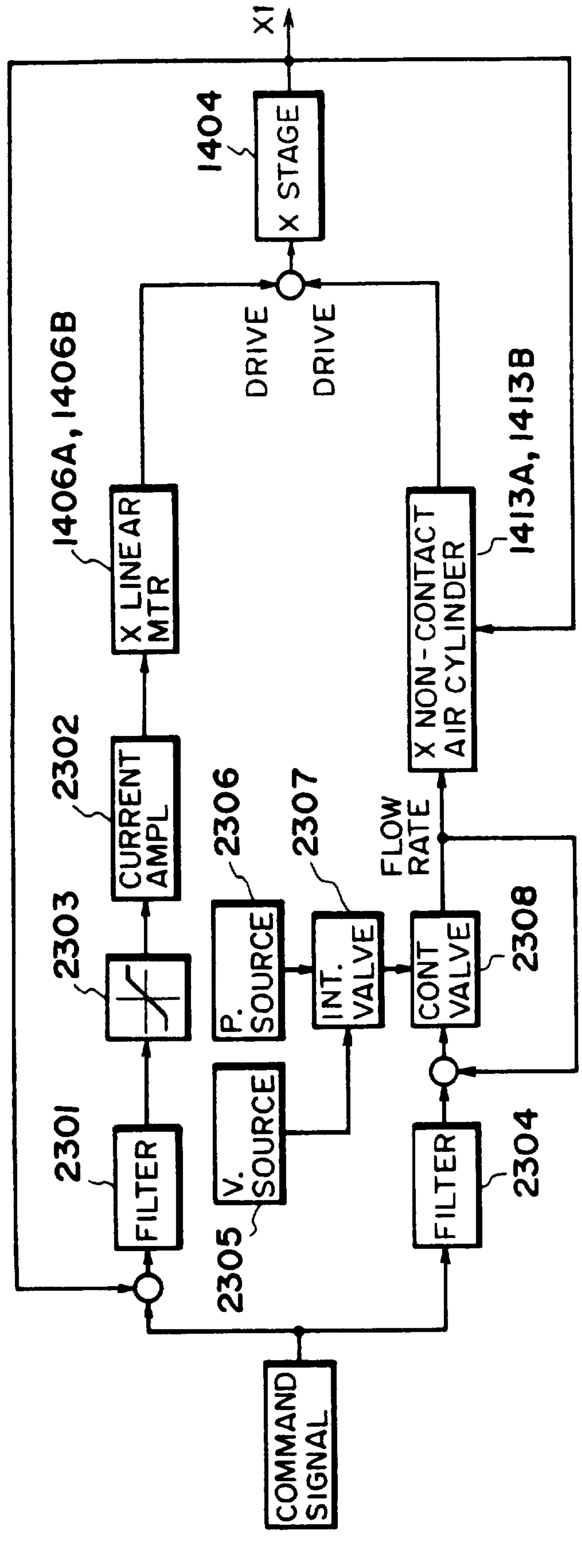
COMMAND SIGNAL
FILTER
2301
2303
CURRENT AMPL
2302
X LINEAR MTR
1406A, 1406B
DRIVE
DRIVE
X STAGE
1404
X1
V. SOURCE
2305
P. SOURCE
2306
INT. VALVE
2307
FILTER
2304
CONT VALVE
2308
FLOW RATE
X NON-CONTACT AIR CYLINDER
1413A, 1413B

FIG. 23

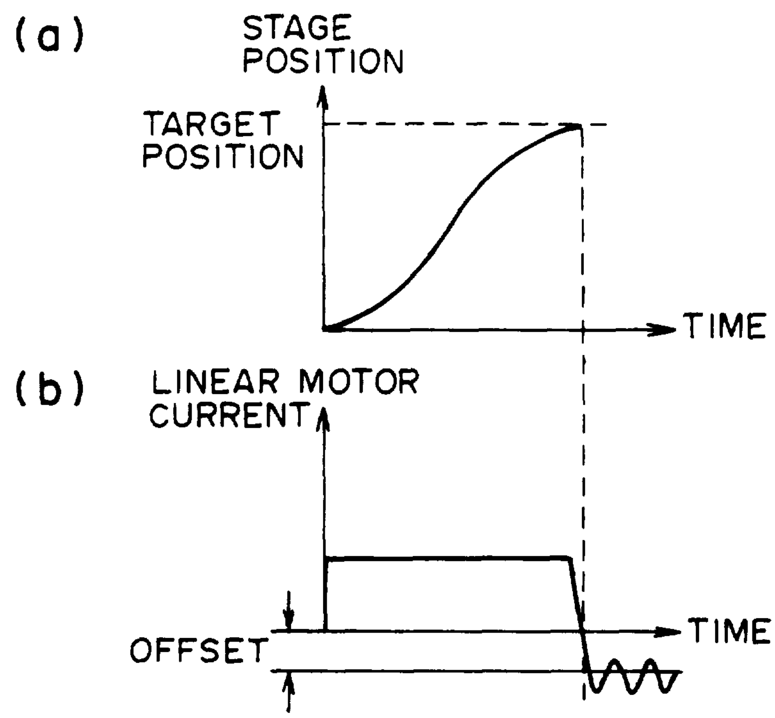
(a)
STAGE POSITION
TARGET POSITION
TIME
(b)
LINEAR MOTOR CURRENT
OFFSET
TIME

FIG. 24

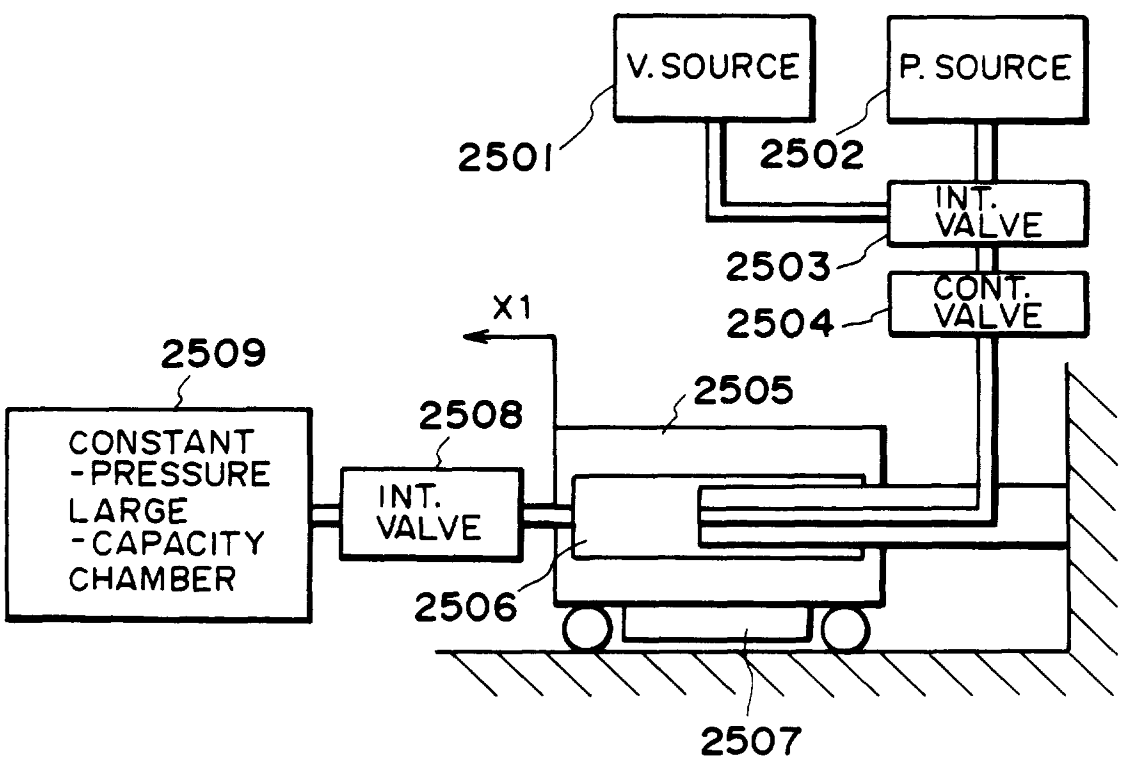
V. SOURCE
P. SOURCE
2501
2502
INT. VALVE
2503
CONT. VALVE
2504
X1
2509
CONSTANT -PRESSURE LARGE -CAPACITY CHAMBER
2508
INT. VALVE
2505
2506
2507

FIG. 25

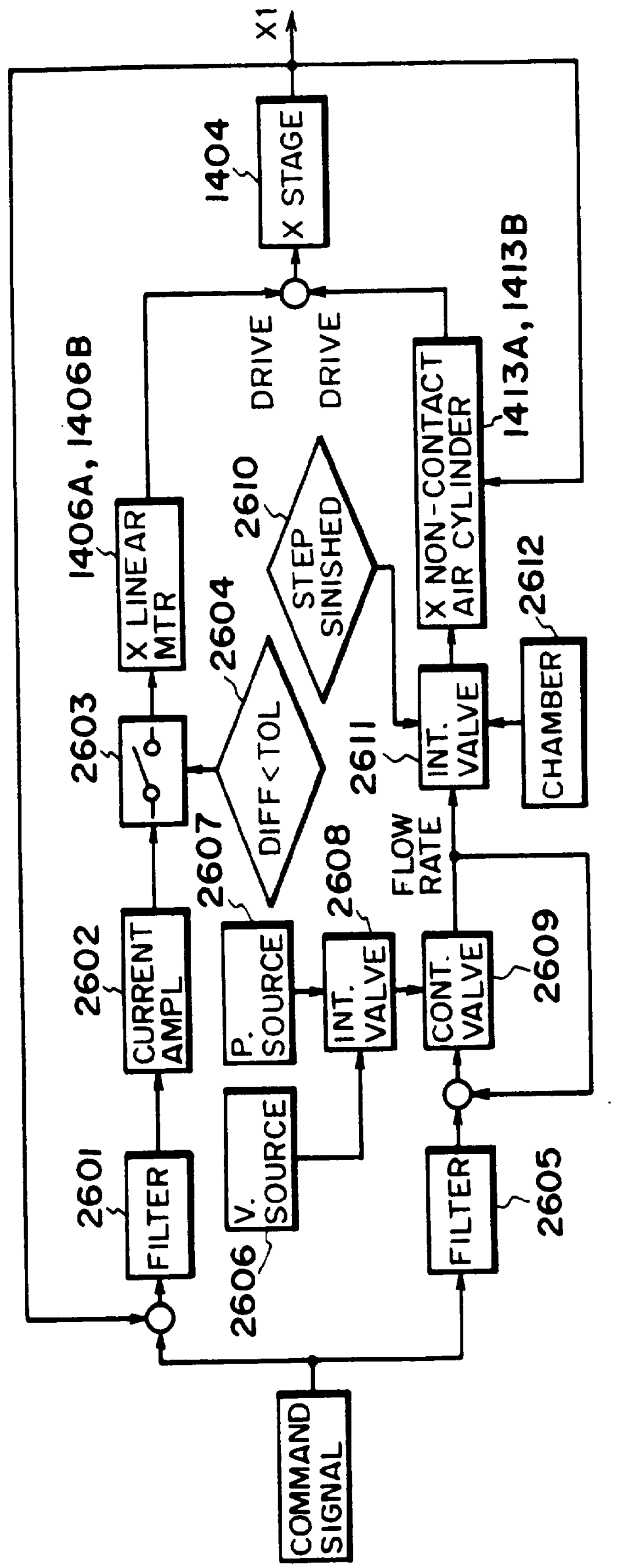
X1
1404
X STAGE
DRIVE
DRIVE
1406A, 1406B
X LINEAR MTR
1413A, 1413B
X NON-CONTACT AIR CYLINDER
2610
STEP SINISHED
2612
CHAMBER
2604
DIFF<TOL
2603
2611
INT. VALVE
FLOW RATE
2607
2608
2602
CURRENT AMPL
P. SOURCE
INT. VALVE
CONT. VALVE
2609
2601
FILTER
V. SOURCE
2606
FILTER
2605
COMMAND SIGNAL

FIG. 26

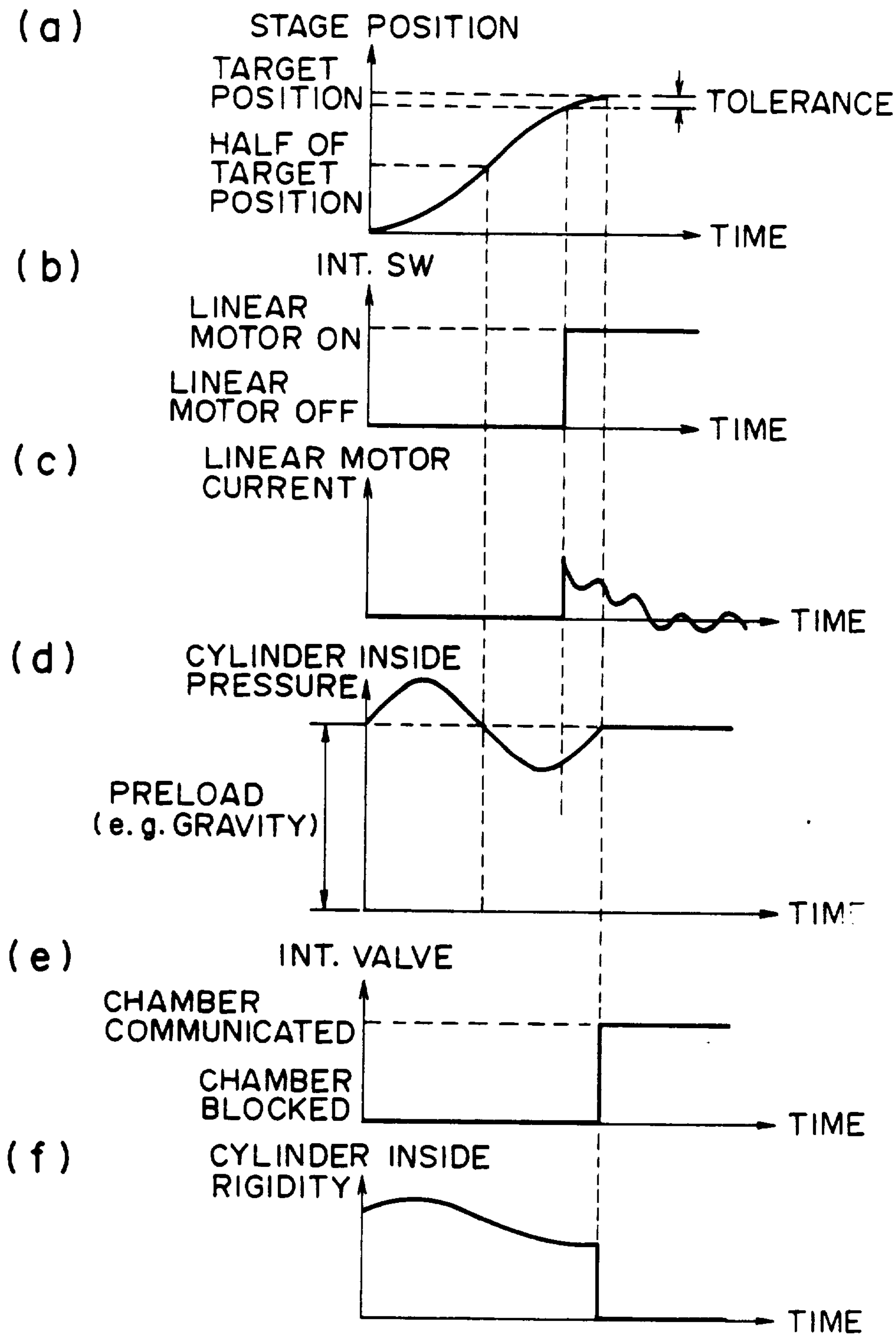
(a)
STAGE POSITION
TARGET POSITION
TOLERANCE
HALF OF TARGET POSITION
TIME
(b)
INT. SW
LINEAR MOTOR ON
LINEAR MOTOR OFF
TIME
(c)
LINEAR MOTOR CURRENT
TIME
(d)
CYLINDER INSIDE PRESSURE
PRELOAD
(e.g. GRAVITY)
(e)
INT. VALVE
CHAMBER COMMUNICATED
CHAMBER BLOCKED
TIME
(f)
CYLINDER INSIDE RIGIDITY
TIME

FIG. 27

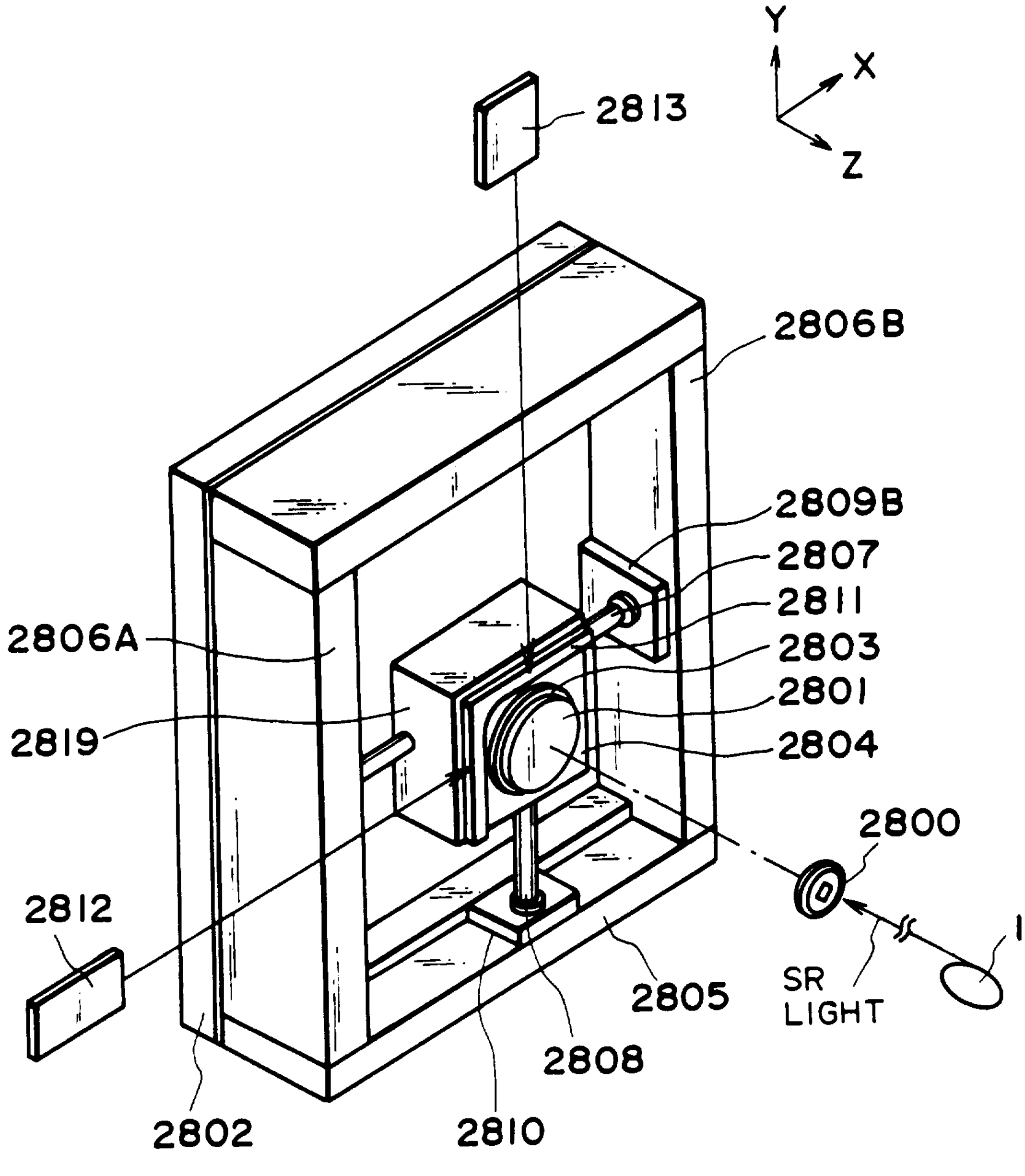
Y
X
Z
2813
2806B
2809B
2807
2811
2803
2801
2804
2806A
2819
2800
2812
SR
LIGHT
I
2805
2808
2802
2810

FIG. 28

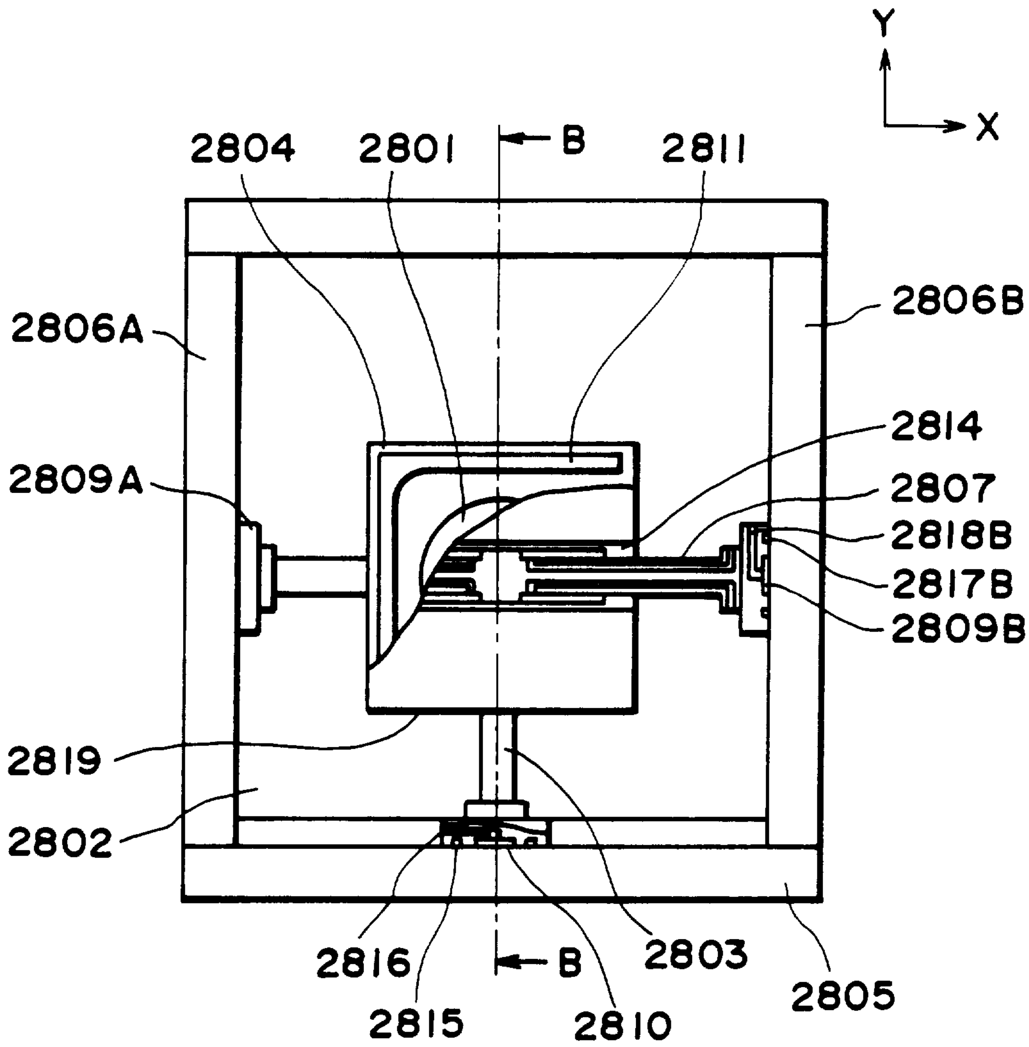
Y
X
2804
2801
B
2811
2806A
2806B
2814
2809A
2807
2818B
2817B
2809B
2819
2802
2816
2815
B
2810
2803
2805

FIG. 29

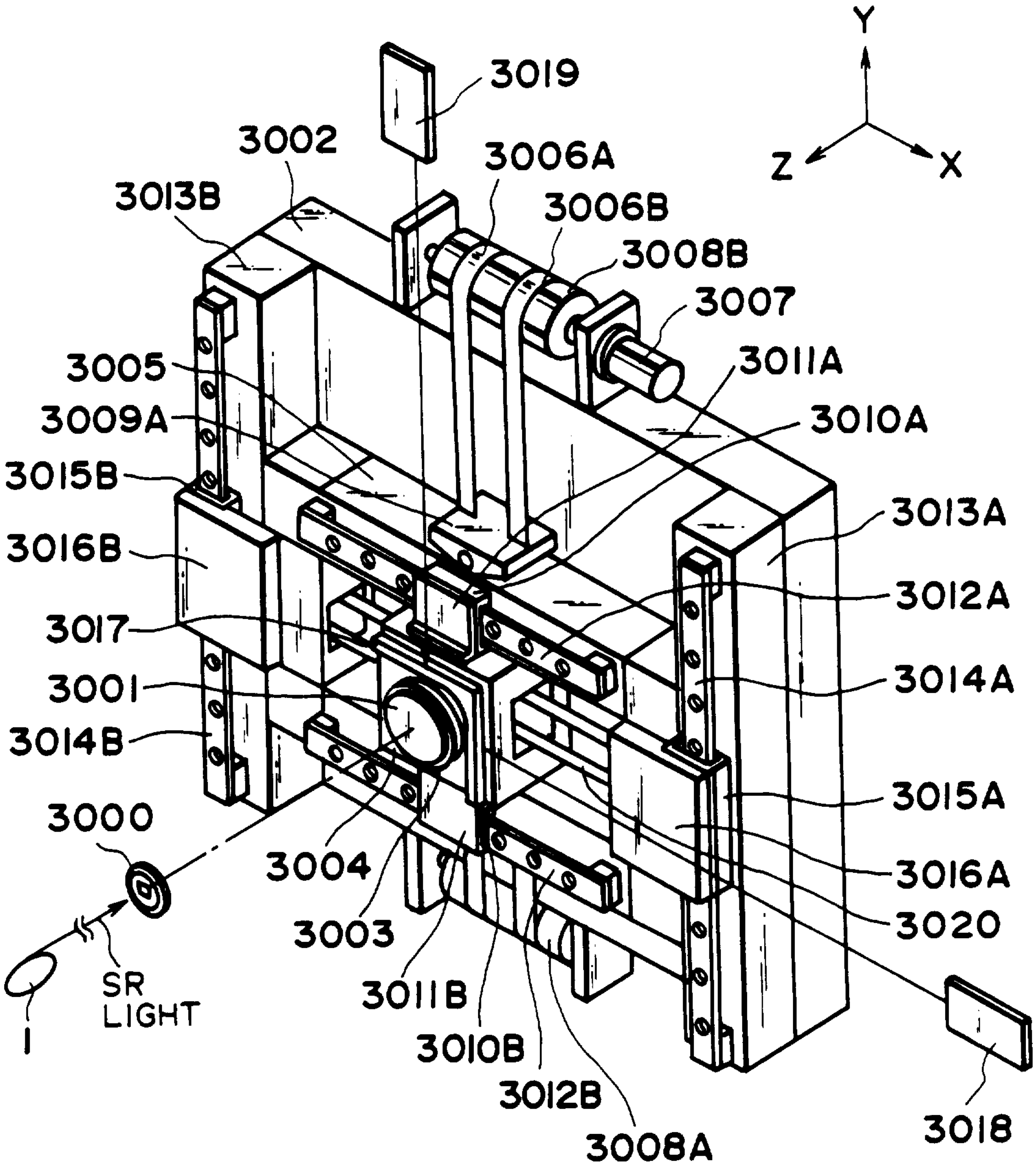
Y
Z
X
3019
3002
3006A
3013B
3006B
3008B
3007
3005
3011A
3009A
3010A
3015B
3013A
3016B
3012A
3017
3001
3014A
3014B
3015A
3000
3004
3016A
3020
3003
SR
LIGHT
3011B
I
3010B
3012B
3018
3008A

F I G. 30

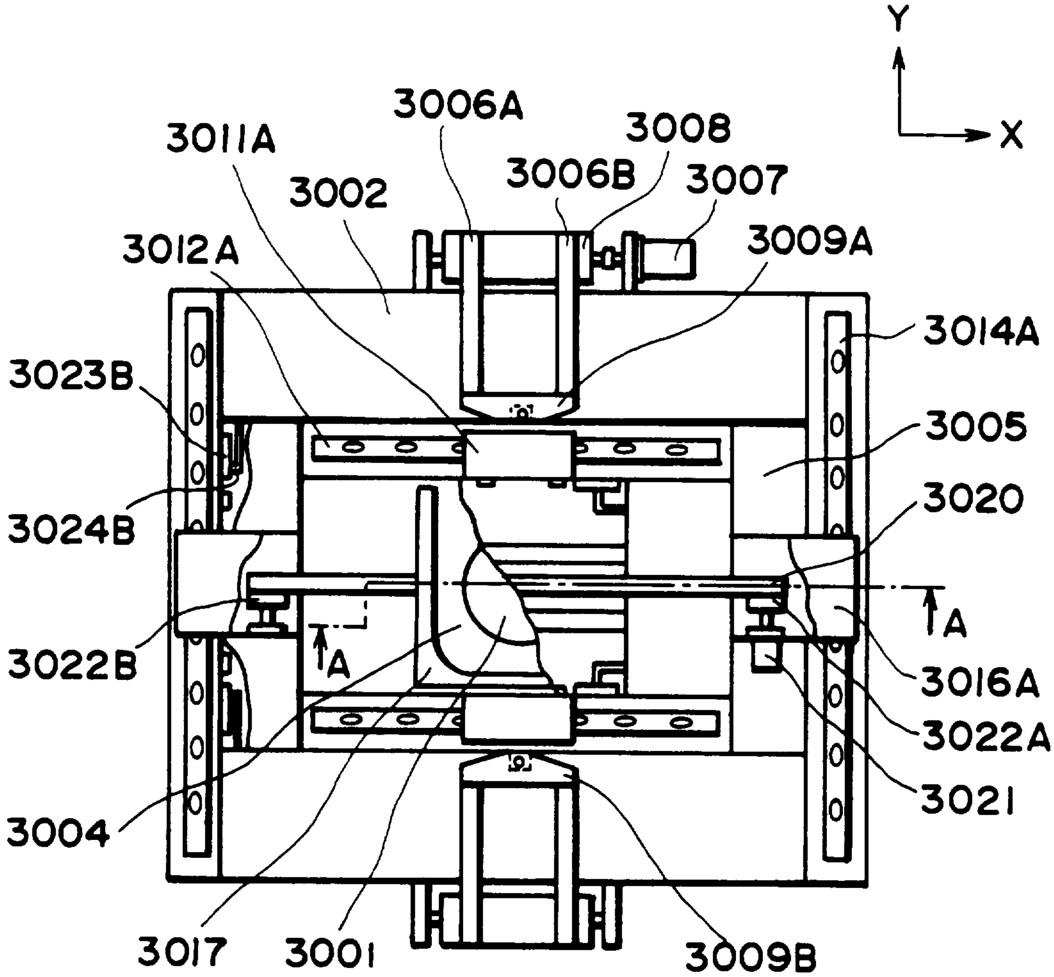
Y
X
3006A
3011A
3008
3006B
3007
3002
3012A
3009A
3014A
3023B
3005
3020
3024B
A
A
3016A
3022B
3022A
3021
3004
3017
3001
3009B

FIG. 31A

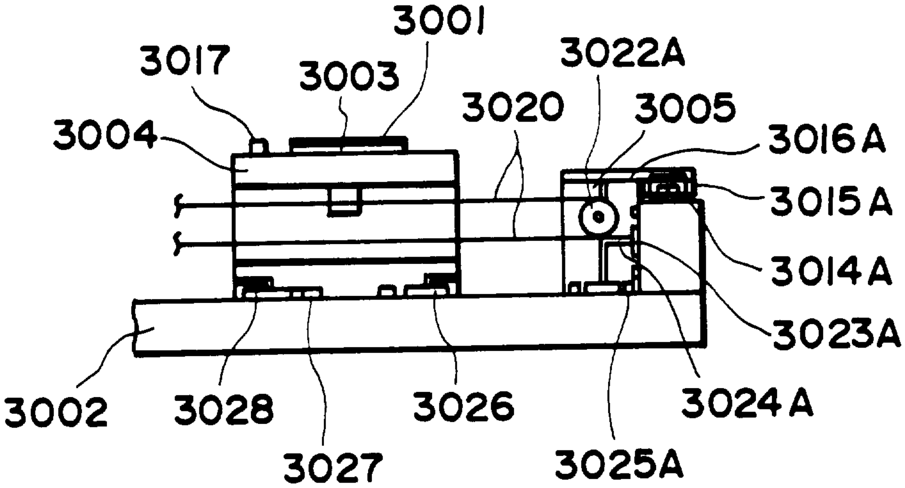


FIG. 31B

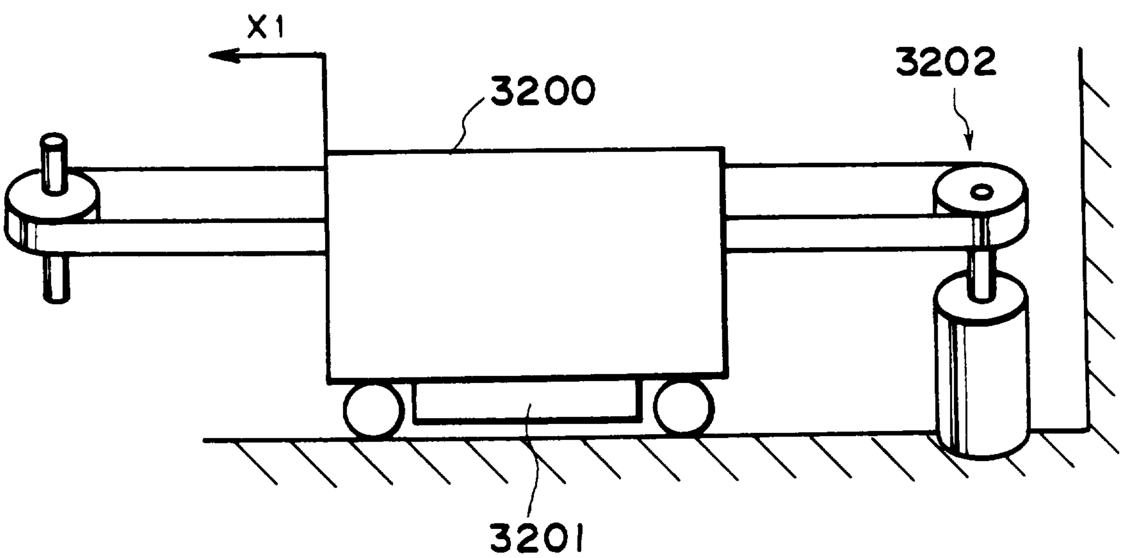


FIG. 32

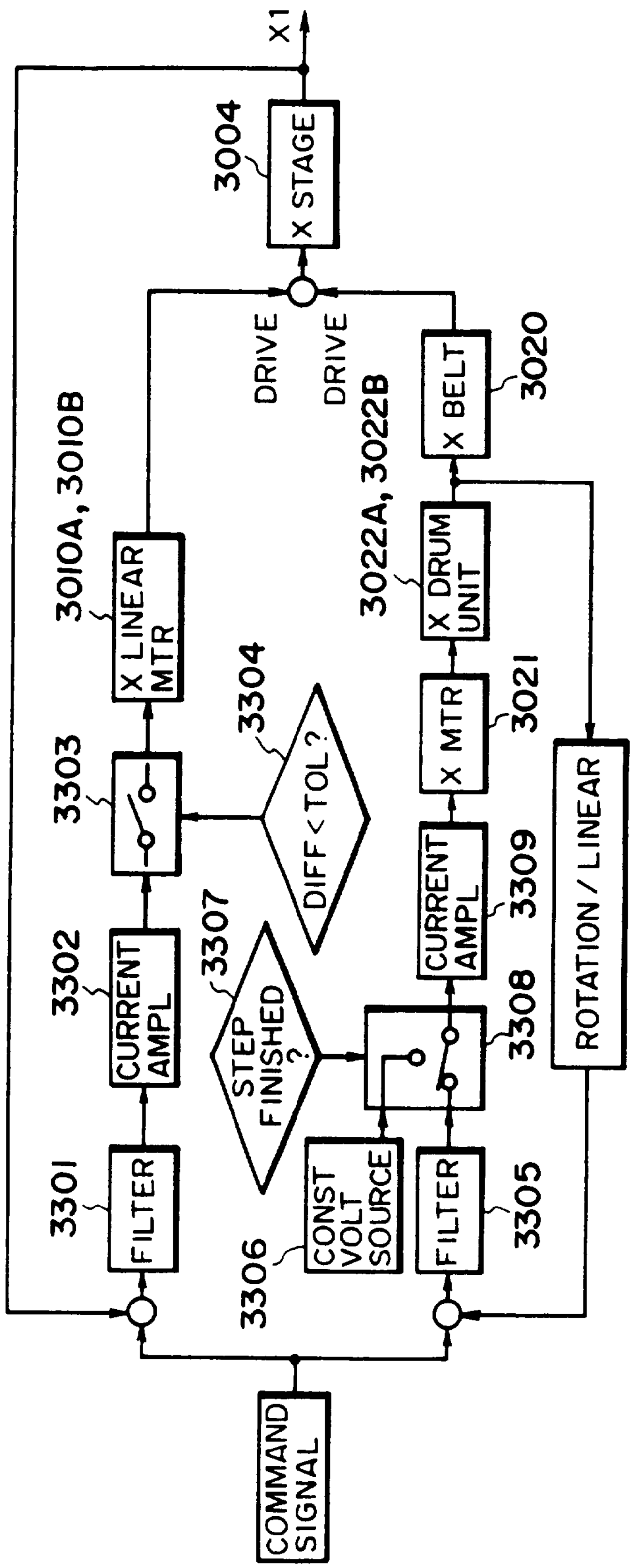
COMMAND SIGNAL
FILTER
3301
CURRENT AMPL
3302
3303
X LINEAR MTR
3010A, 3010B
DIFF < TOL ?
3304
STEP FINISHED ?
3307
CONST VOLT SOURCE
3306
FILTER
3305
3308
CURRENT AMPL
3309
X MTR
3021
X DRUM UNIT
3022A, 3022B
X BELT
3020
DRIVE
DRIVE
X STAGE
3004
X1
ROTATION / LINEAR

FIG. 33

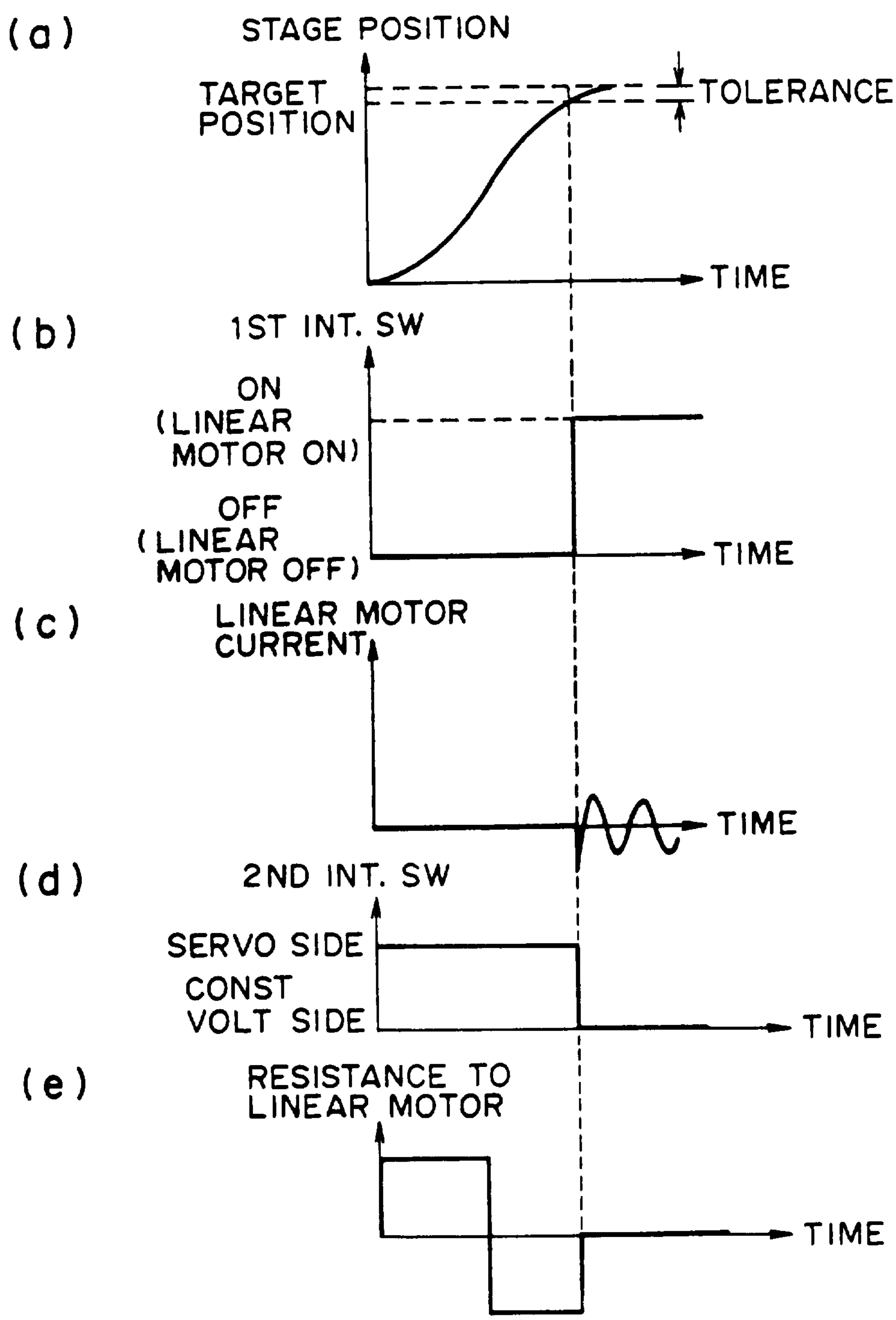
(a)
STAGE POSITION
TARGET POSITION
TOLERANCE
TIME
(b)
1ST INT. SW
ON (LINEAR MOTOR ON)
OFF (LINEAR MOTOR OFF)
TIME
(c)
LINEAR MOTOR CURRENT
TIME
(d)
2ND INT. SW
SERVO SIDE
CONST VOLT SIDE
TIME
(e)
RESISTANCE TO LINEAR MOTOR
TIME

FIG. 34

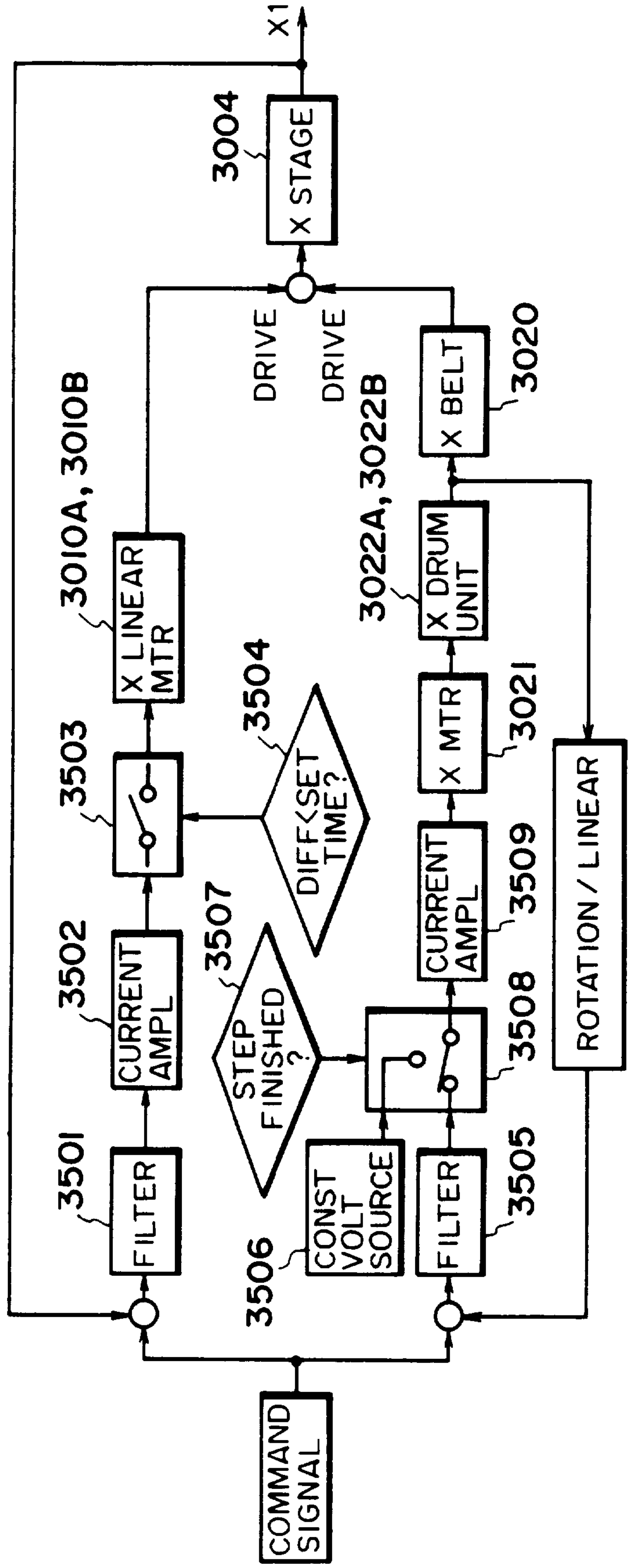

X1
3004
X STAGE
DRIVE
DRIVE
3020
X BELT
3010A, 3010B
X LINEAR MTR
3022A, 3022B
X DRUM UNIT
3504
DIFF<SET TIME?
3503
3021
X MTR
3509
CURRENT AMPL
3502
CURRENT AMPL
3507
STEP FINISHED ?
3508
ROTATION / LINEAR
3501
FILTER
3505
FILTER
3506
CONST VOLT SOURCE
COMMAND SIGNAL


FIG. 35

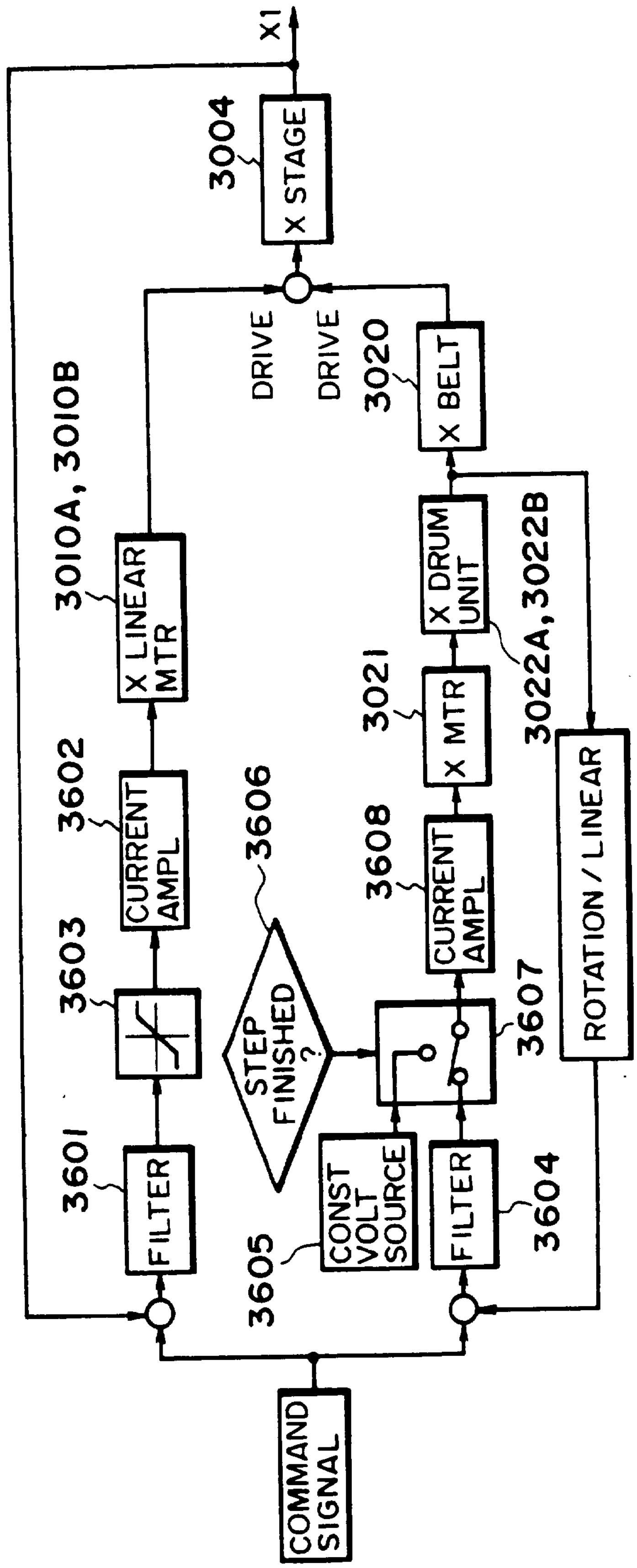
X1
3004
X STAGE
DRIVE
DRIVE
3020
X BELT
3010A, 3010B
X LINEAR MTR
3022A, 3022B
X DRUM UNIT
3021
X MTR
3602
CURRENT AMPL
3606
3608
CURRENT AMPL
ROTATION / LINEAR
3603
STEP FINISHED ?
3607
3601
FILTER
3605
CONST VOLT SOURCE
FILTER
3604
COMMAND SIGNAL

FIG. 36

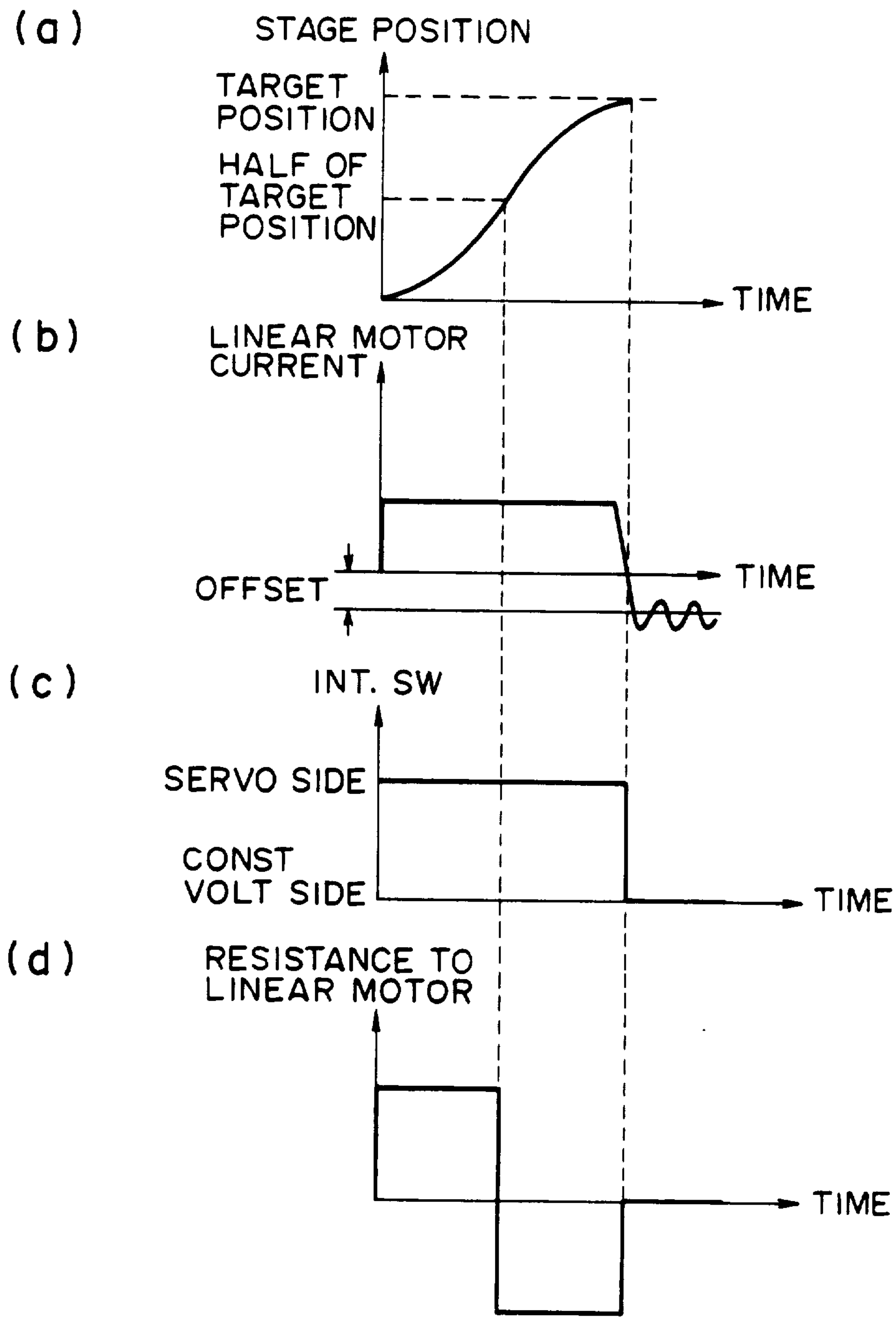
(a)
STAGE POSITION
TARGET POSITION
HALF OF TARGET POSITION
TIME
(b)
LINEAR MOTOR CURRENT
OFFSET
TIME
(c)
INT. SW
SERVO SIDE
CONST VOLT SIDE
TIME
(d)
RESISTANCE TO LINEAR MOTOR
TIME

FIG. 37

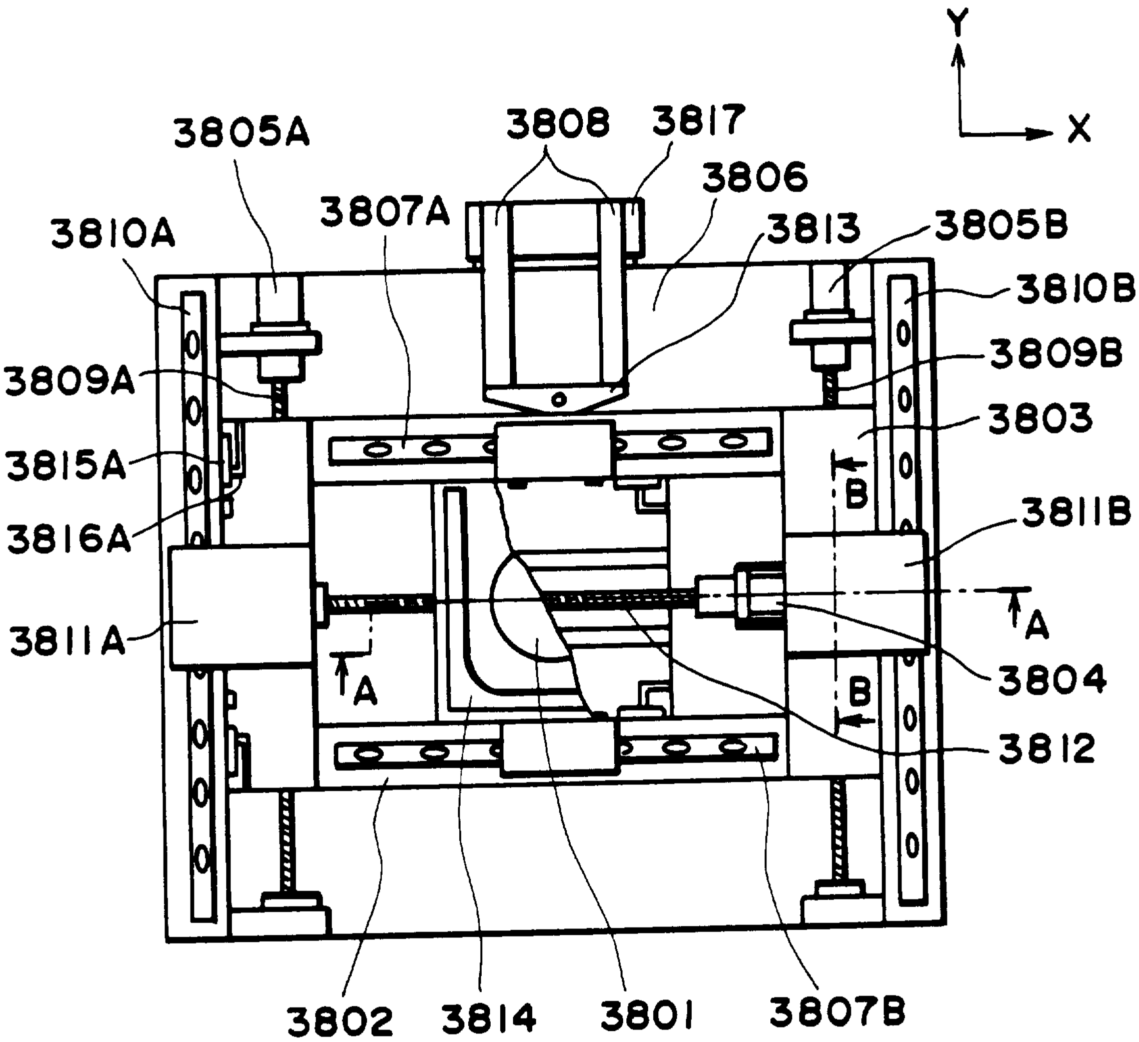
Y
X
3805A
3808
3817
3806
3807A
3813
3805B
3810A
3810B
3809A
3809B
3803
3815A
B
3811B
3816A
3811A
A
A
3804
B
3812
3802
3814
3801
3807B

FIG. 38

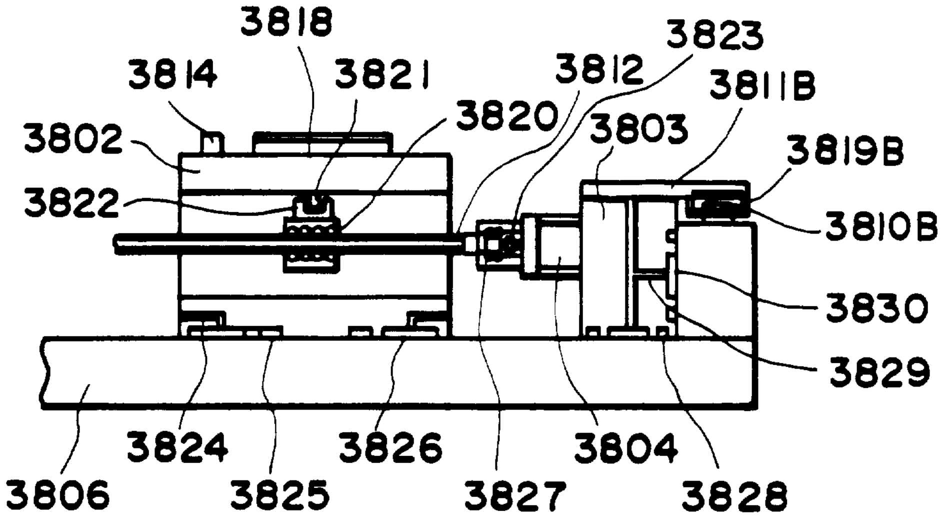


FIG. 39

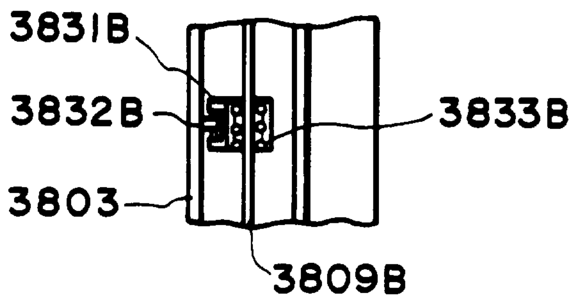


FIG. 40

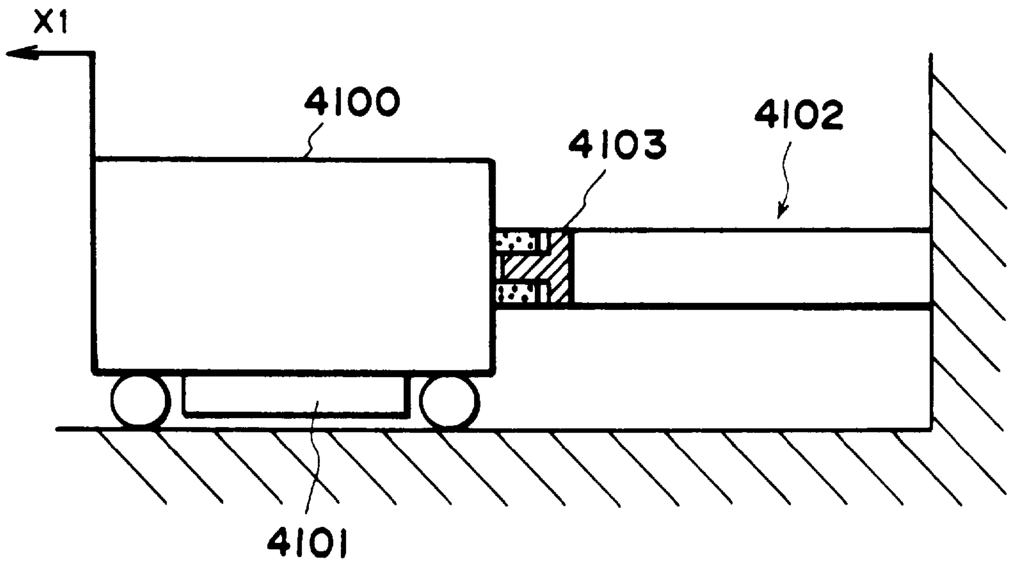


FIG. 41

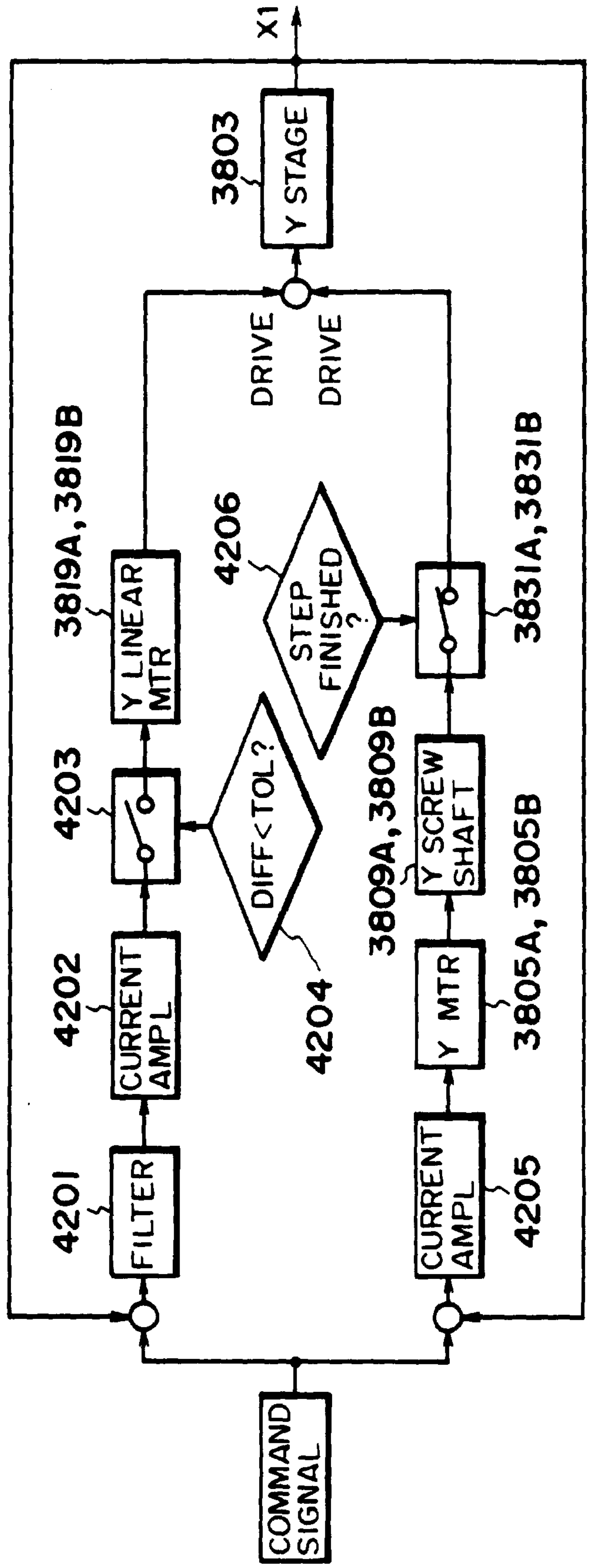
COMMAND SIGNAL
FILTER
4201
CURRENT AMPL
4202
4203
Y LINEAR MTR
3819A, 3819B
DIFF<TOL?
4204
CURRENT AMPL
4205
Y MTR
3805A, 3805B
Y SCREW SHAFT
3809A, 3809B
STEP FINISHED ?
4206
3831A, 3831B
DRIVE
DRIVE
Y STAGE
3803
X1

FIG. 42

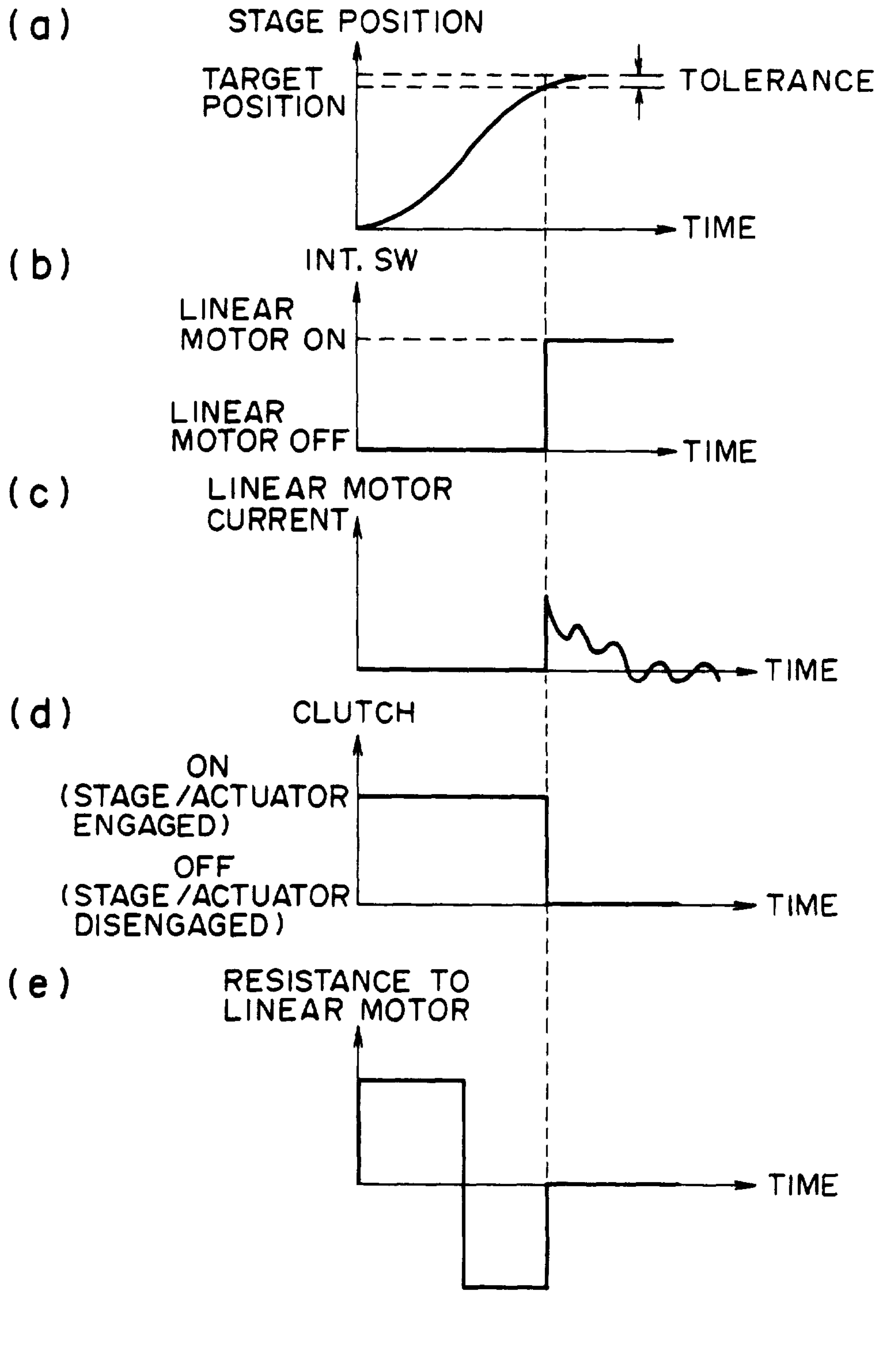
(a)
STAGE POSITION
TARGET POSITION
TOLERANCE
TIME
(b)
INT. SW
LINEAR MOTOR ON
LINEAR MOTOR OFF
TIME
(c)
LINEAR MOTOR CURRENT
TIME
(d)
CLUTCH
ON (STAGE/ACTUATOR ENGAGED)
OFF (STAGE/ACTUATOR DISENGAGED)
TIME
(e)
RESISTANCE TO LINEAR MOTOR
TIME

FIG. 43

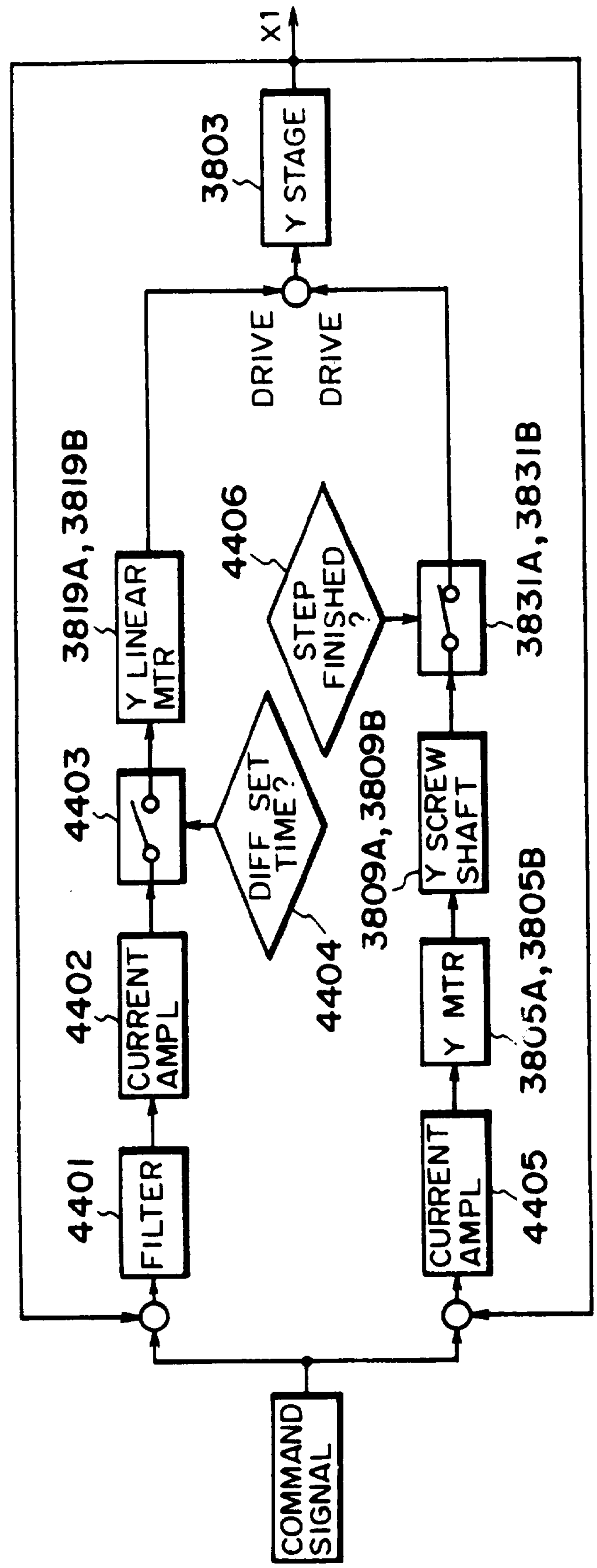
COMMAND SIGNAL
4401
FILTER
4402
CURRENT AMPL
4403
4404
DIFF SET TIME?
3819A, 3819B
Y LINEAR MTR
4405
CURRENT AMPL
3805A, 3805B
Y MTR
3809A, 3809B
Y SCREW SHAFT
4406
STEP FINISHED ?
3831A, 3831B
DRIVE
DRIVE
3803
Y STAGE
X1

FIG. 44

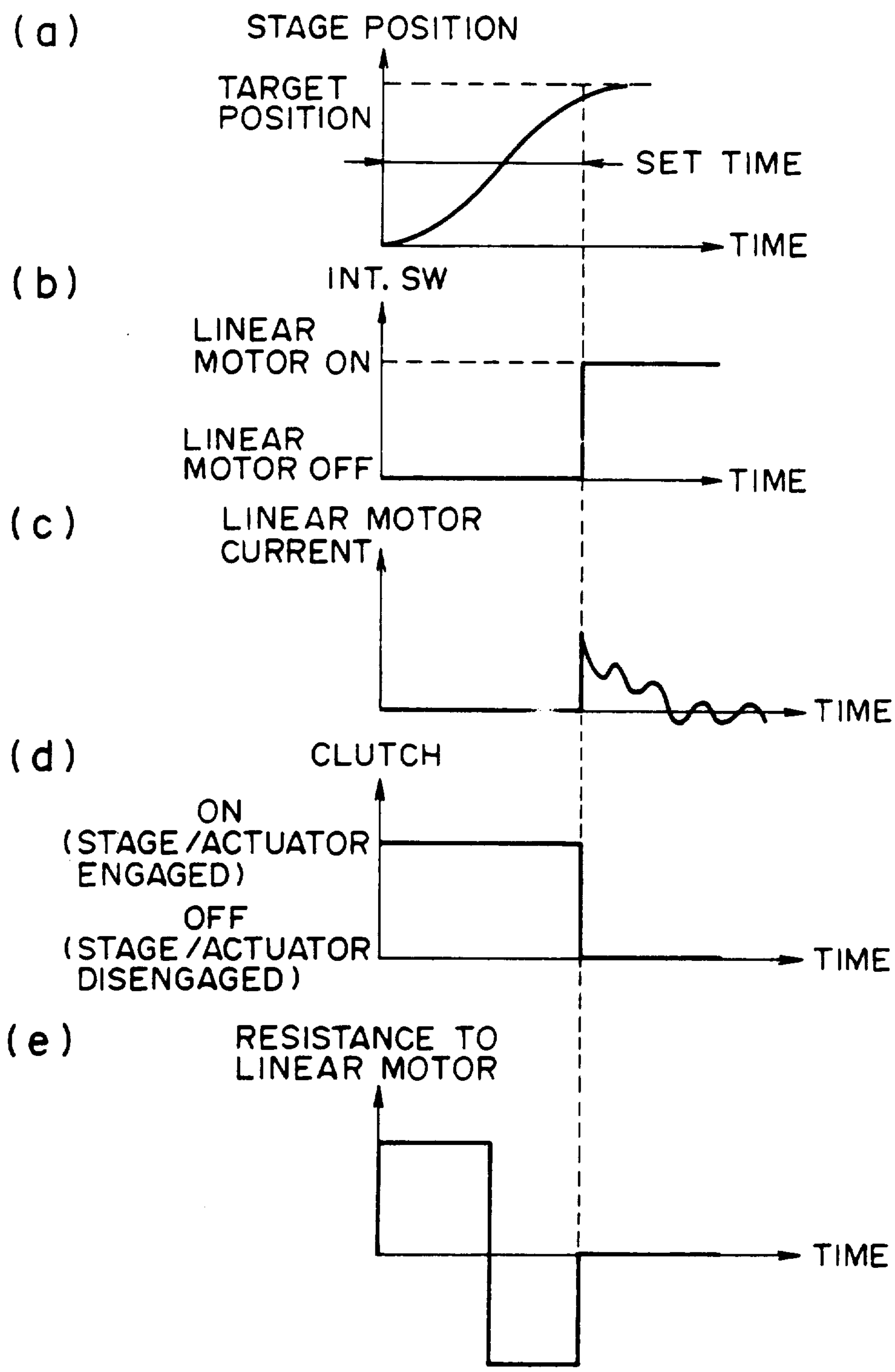
(a)
STAGE POSITION
TARGET POSITION
SET TIME
TIME
(b)
INT. SW
LINEAR MOTOR ON
LINEAR MOTOR OFF
TIME
(c)
LINEAR MOTOR CURRENT
TIME
(d)
CLUTCH
ON (STAGE/ACTUATOR ENGAGED)
OFF (STAGE/ACTUATOR DISENGAGED)
TIME
(e)
RESISTANCE TO LINEAR MOTOR
TIME

FIG. 45

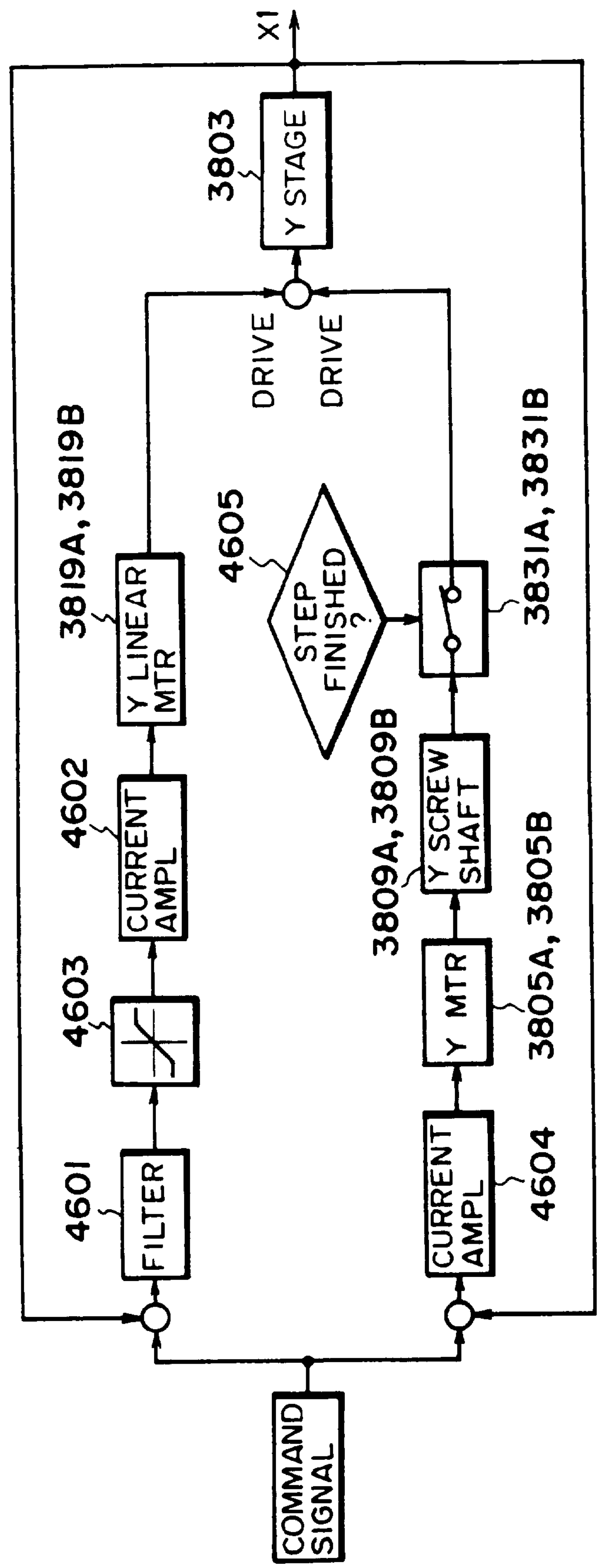
COMMAND SIGNAL
4601
FILTER
4603
4602
CURRENT AMPL
3819A, 3819B
Y LINEAR MTR
DRIVE
4605
STEP FINISHED ?
4604
CURRENT AMPL
3805A, 3805B
Y MTR
3809A, 3809B
Y SCREW SHAFT
3831A, 3831B
DRIVE
3803
Y STAGE
X1

FIG. 46

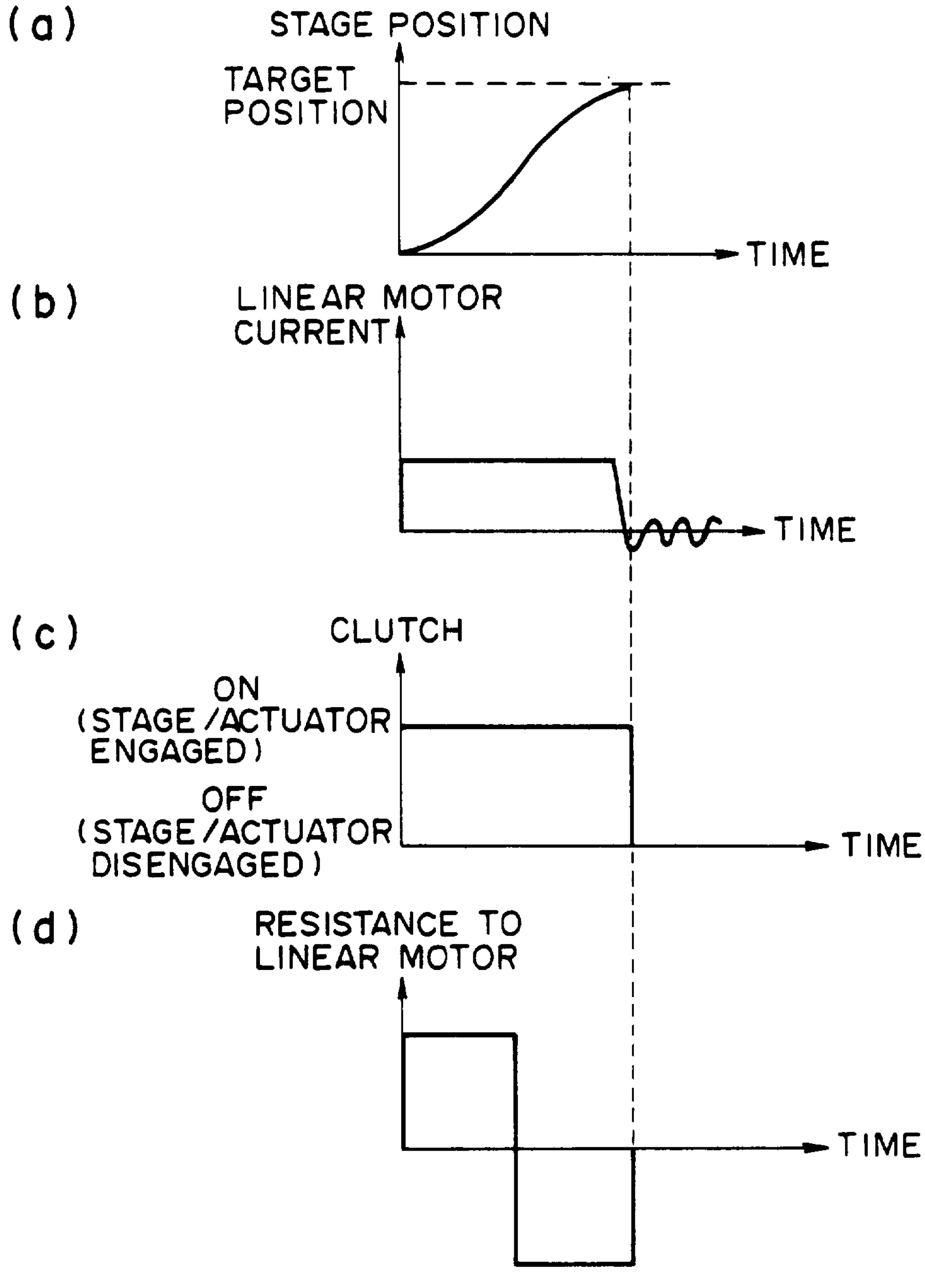
(a)
STAGE POSITION
TARGET POSITION
TIME
(b)
LINEAR MOTOR CURRENT
TIME
(c)
CLUTCH
ON (STAGE /ACTUATOR ENGAGED)
OFF (STAGE /ACTUATOR DISENGAGED)
TIME
(d)
RESISTANCE TO LINEAR MOTOR
TIME

FIG. 47

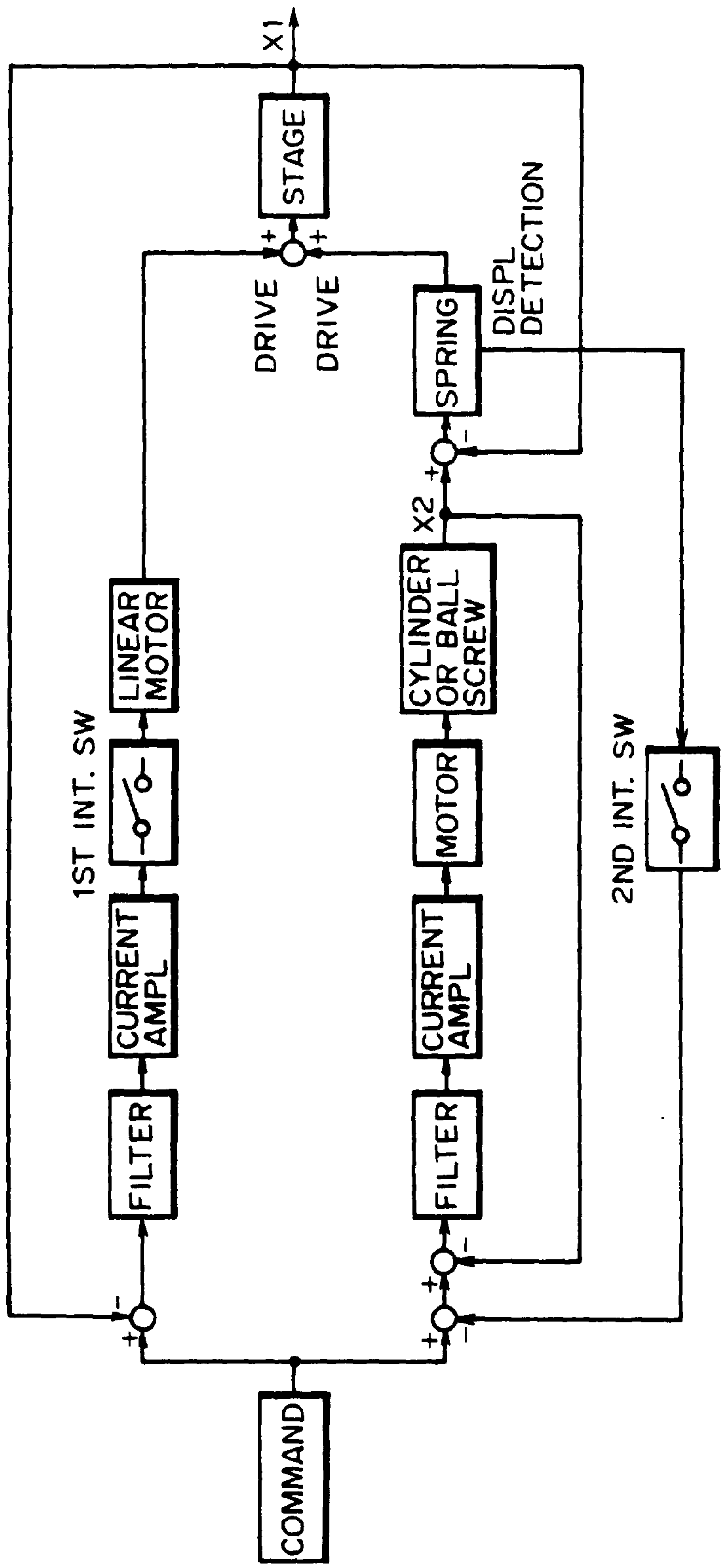
COMMAND
FILTER
CURRENT AMPL
1ST INT. SW
LINEAR MOTOR
DRIVE
STAGE
X1
FILTER
CURRENT AMPL
MOTOR
CYLINDER OR BALL SCREW
X2
SPRING
DRIVE
DISPL DETECTION
2ND INT. SW

FIG. 48

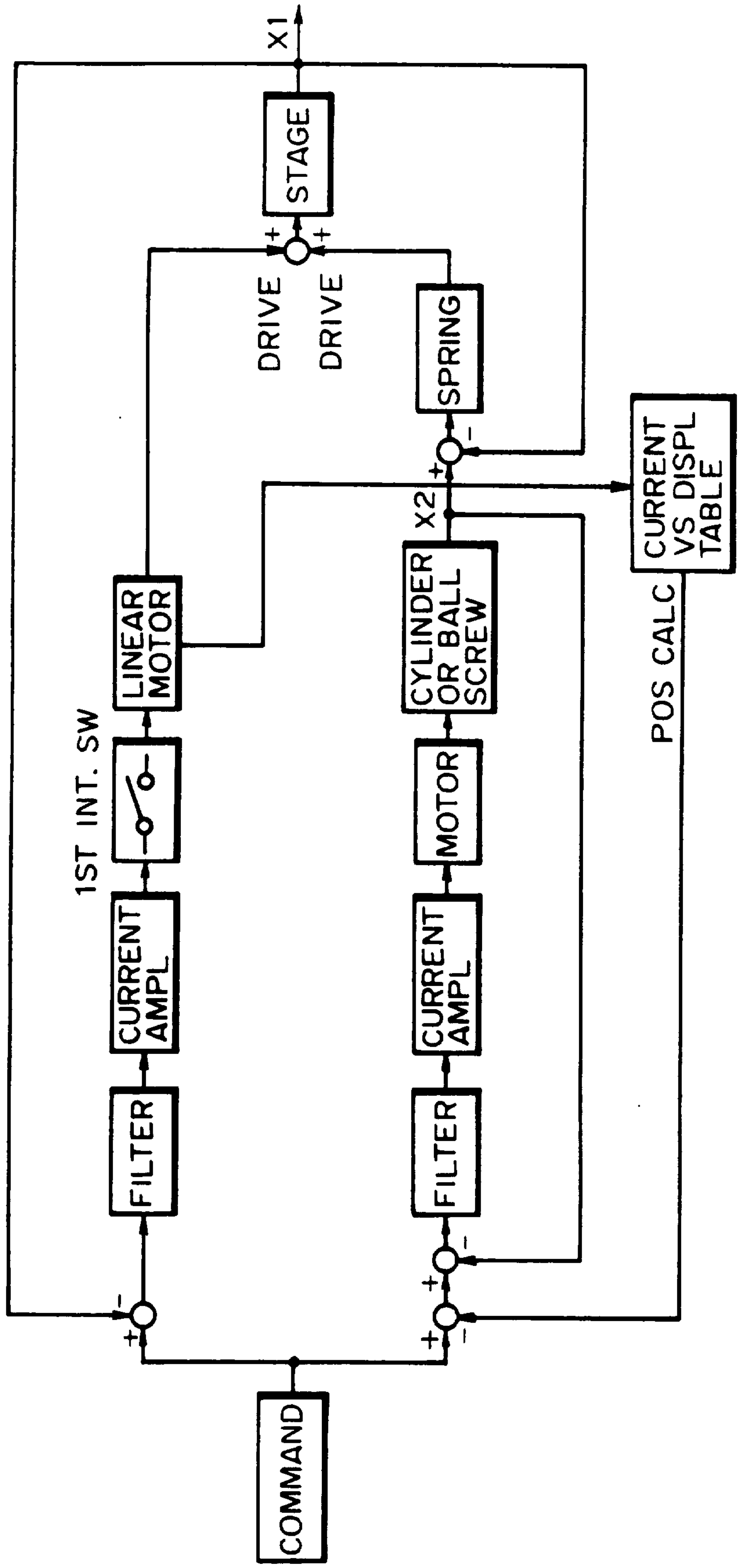
COMMAND
FILTER
CURRENT AMPL
1ST INT. SW
LINEAR MOTOR
DRIVE
DRIVE
STAGE
X1
FILTER
CURRENT AMPL
MOTOR
CYLINDER OR BALL SCREW
X2
SPRING
CURRENT VS DISPL TABLE
POS CALC

F I G. 49

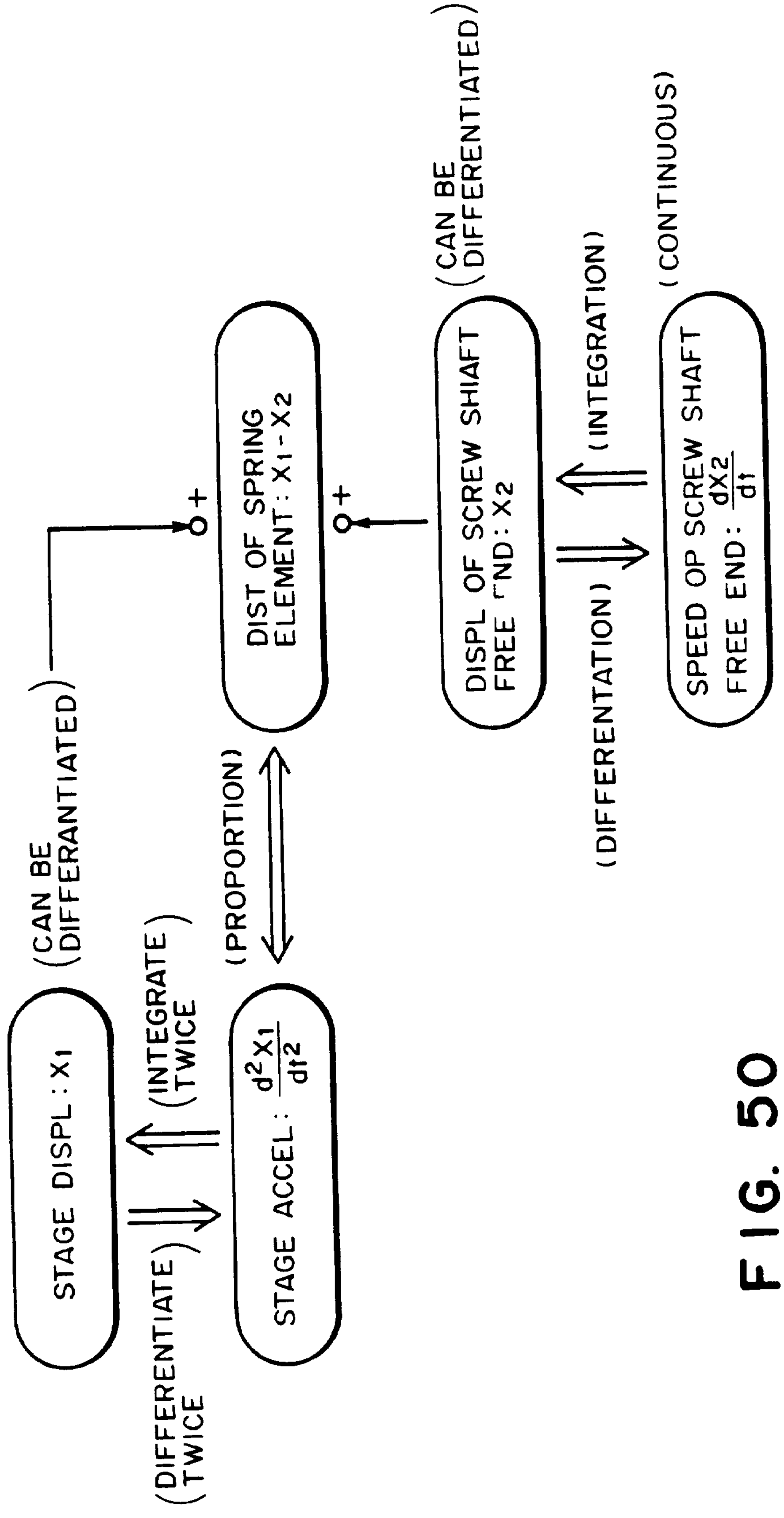
STAGE DISPL : $X_1$
STAGE ACCEL : $\frac{d^2X_1}{dt^2}$
(DIFFERENTIATE TWICE)
(INTEGRATE TWICE)
(CAN BE DIFFERANTIATED)
(PROPORTION)
DIST OF SPRING ELEMENT : $X_1 - X_2$
+
+
DISPL OF SCREW SHIAFT FREE ΓND : $X_2$
(CAN BE DIFFERENTIATED)
(DIFFERENTATION)
(INTEGRATION)
SPEED OP SCREW SHAFT FREE END : $\frac{dX_2}{dt}$
(CONTINUOUS)

FIG. 50

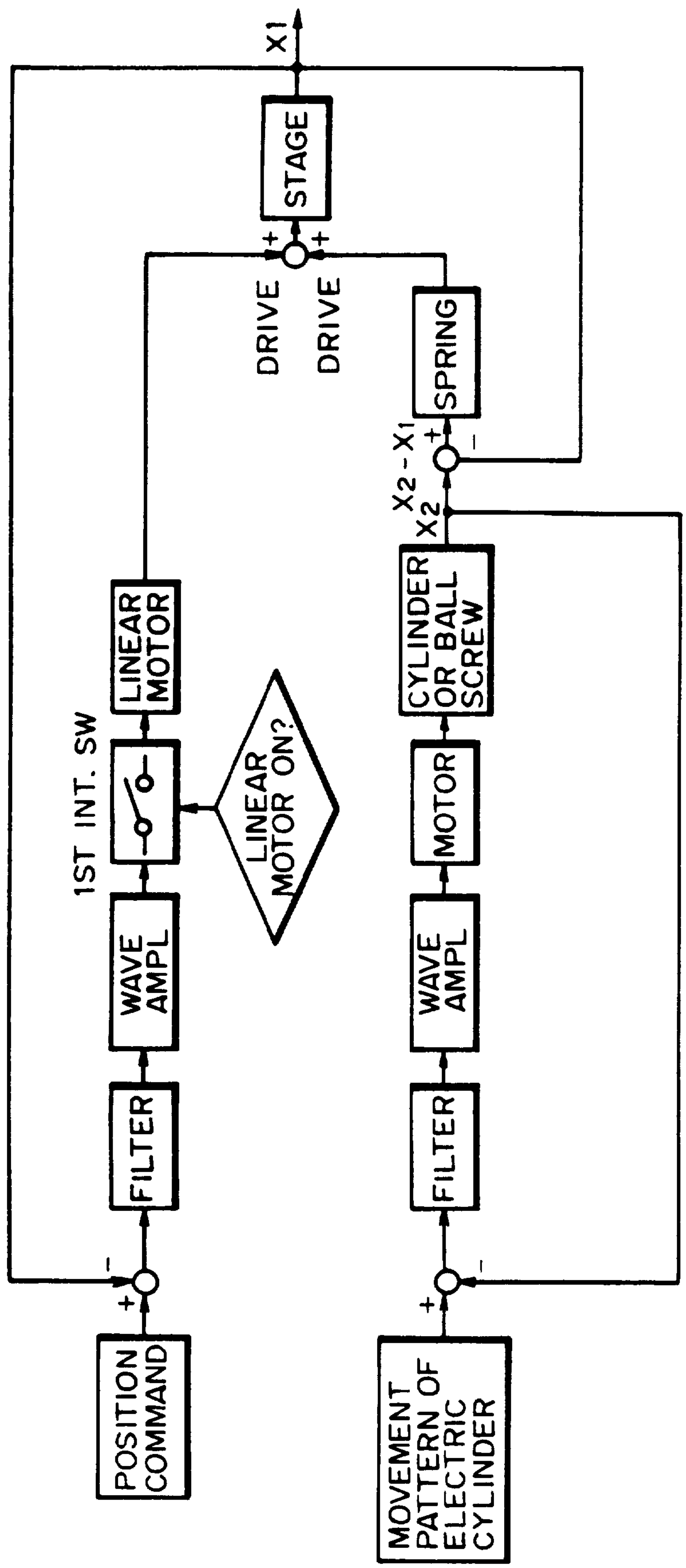
POSITION COMMAND
FILTER
WAVE AMPL
1ST INT. SW
LINEAR MOTOR ON?
LINEAR MOTOR
DRIVE
DRIVE
STAGE
X1
MOVEMENT PATTERN OF ELECTRIC CYLINDER
FILTER
WAVE AMPL
MOTOR
CYLINDER OR BALL SCREW
X2
X2 - X1
SPRING

FIG. 51

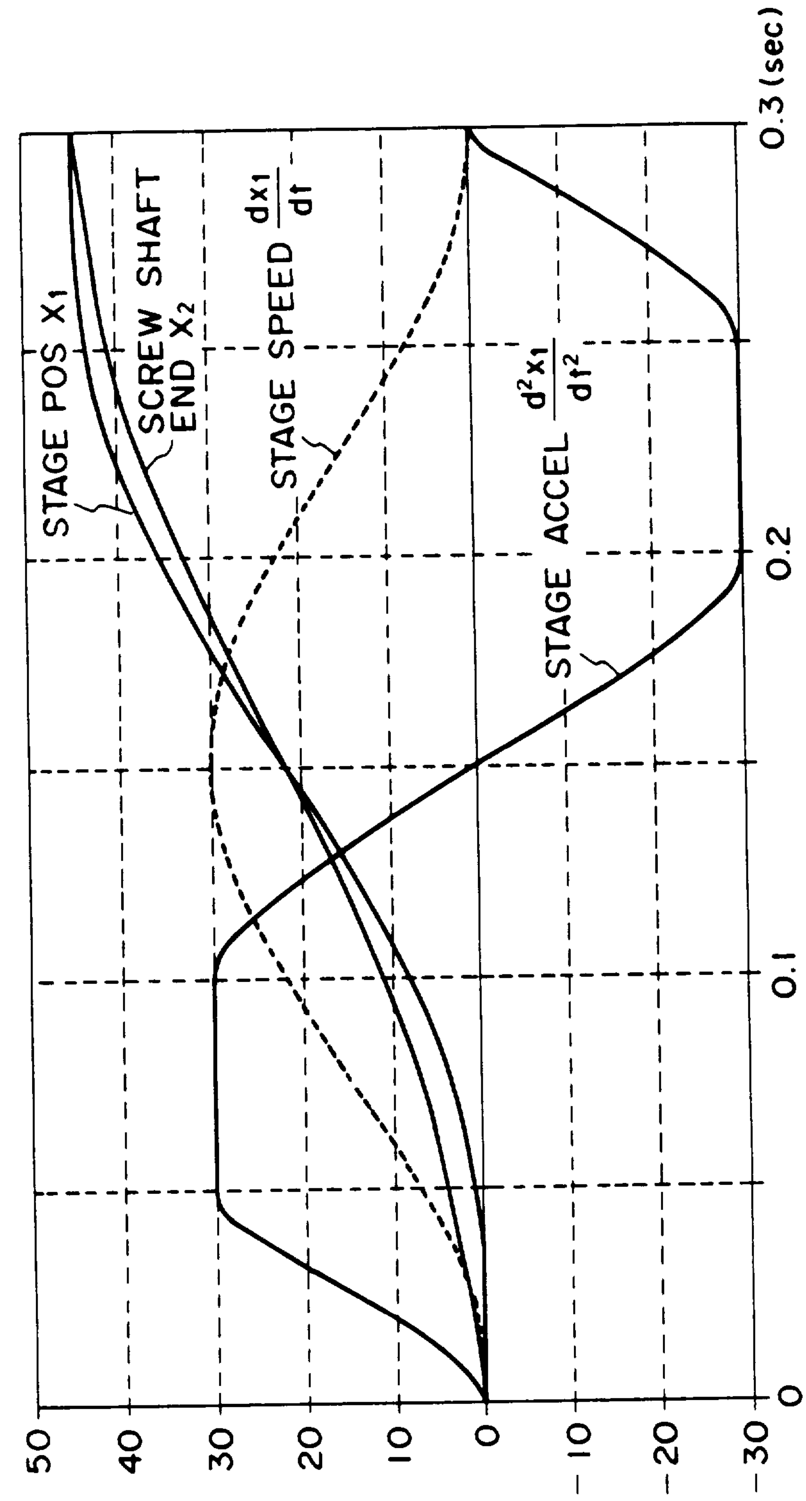
STAGE POS $X_1$
SCREW SHAFT END $X_2$
STAGE SPEED $\frac{dx_1}{dt}$
STAGE ACCEL $\frac{d^2x_1}{dt^2}$
50
40
30
20
10
0
-10
-20
-30
0
0.1
0.2
0.3 (sec)

FIG. 52

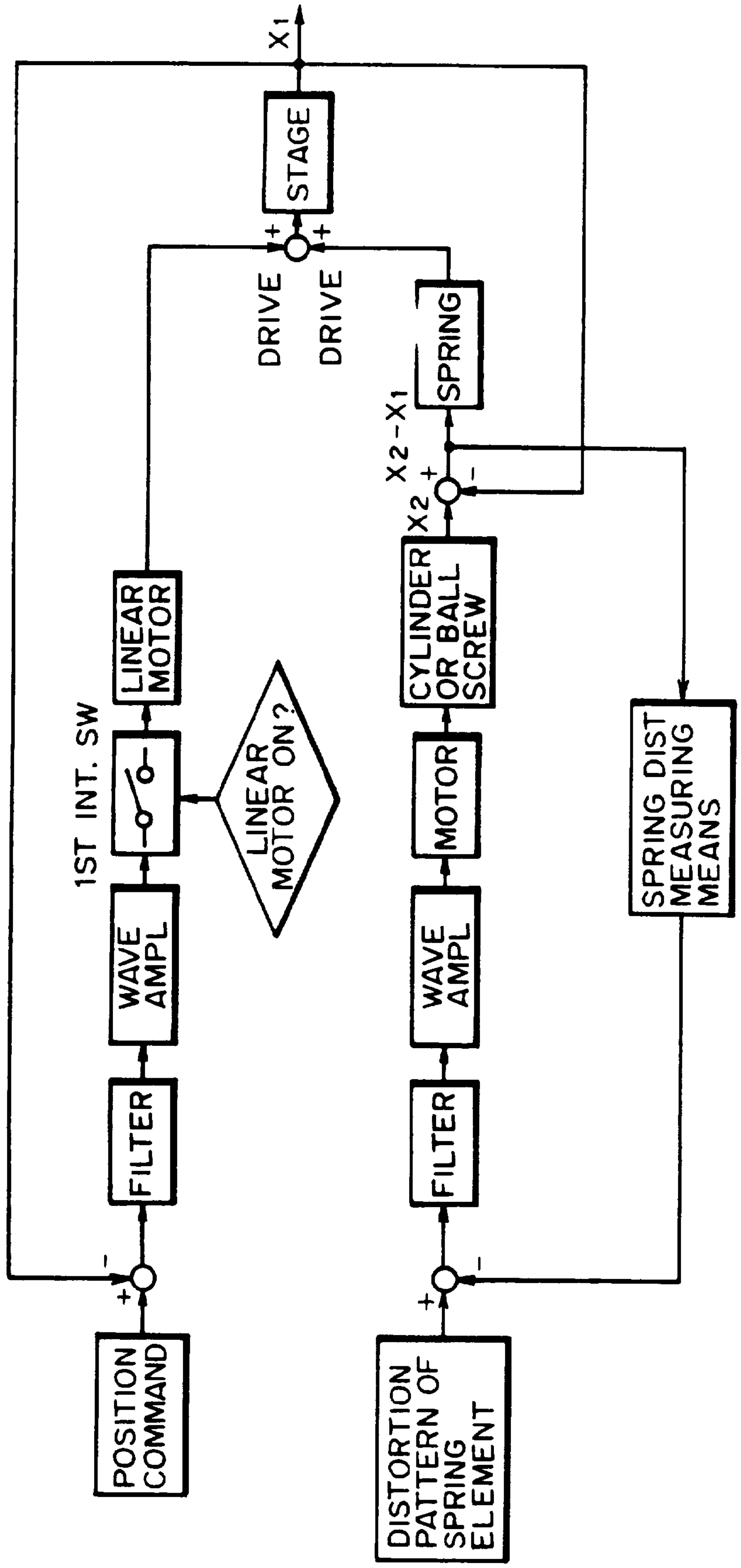
X1
STAGE
DRIVE
DRIVE
SPRING
X2 - X1
X2
POSITION COMMAND
FILTER
WAVE AMPL
1ST INT. SW
LINEAR MOTOR
LINEAR MOTOR ON?
DISTORTION PATTERN OF SPRING ELEMENT
FILTER
WAVE AMPL
MOTOR
CYLINDER OR BALL SCREW
SPRING DIST MEASURING MEANS

FIG. 53

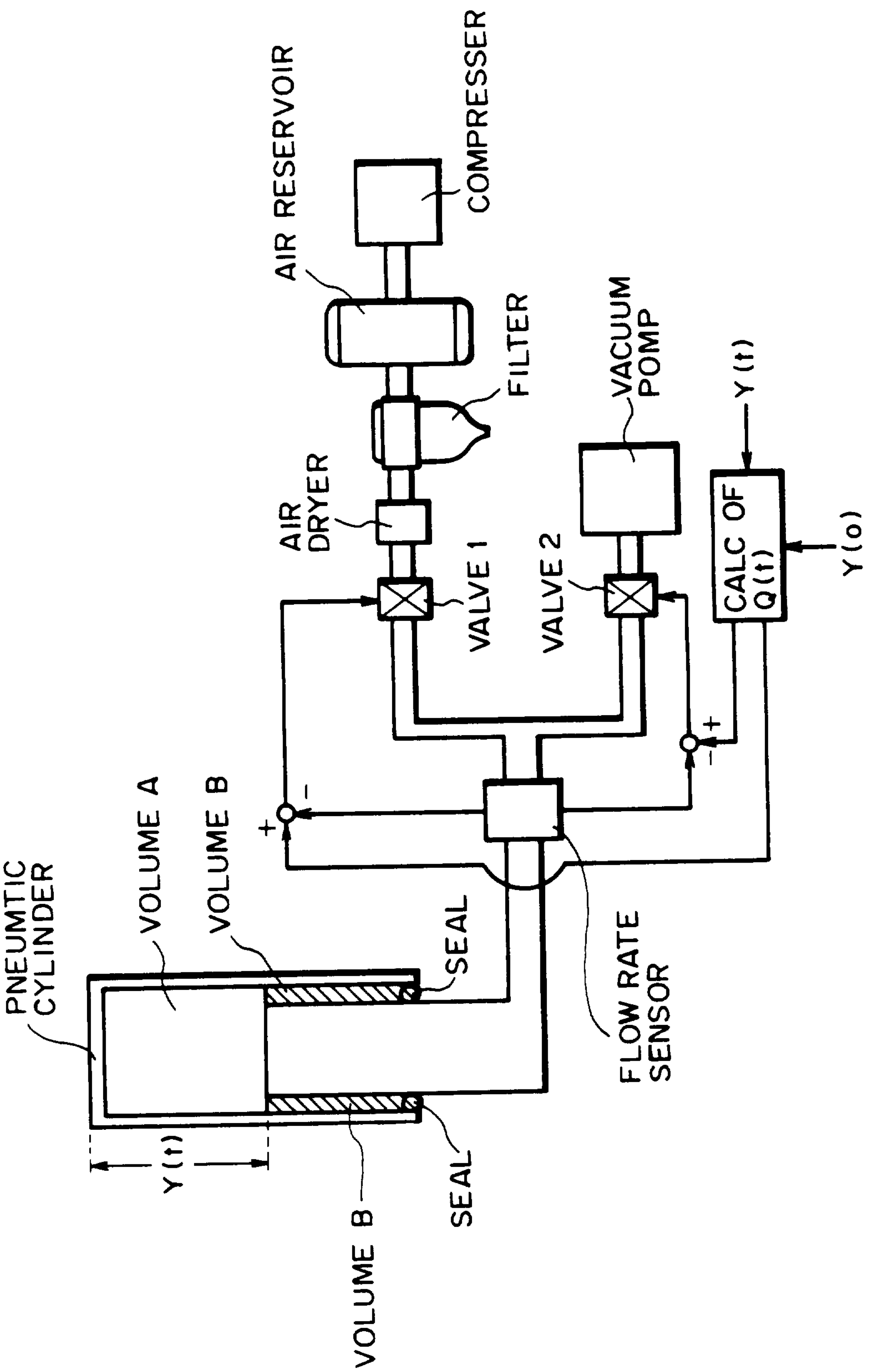
AIR RESERVOIR
COMPRESSER
FILTER
VACUUM
POMP
AIR
DRYER
VALVE 1
VALVE 2
Y (t)
CALC OF
Q (t)
Y (o)
+
-
PNEUMTIC
CYLINDER
VOLUME A
VOLUME B
SEAL
FLOW RATE
SENSOR
Y (t)
VOLUME B
SEAL

FIG. 54

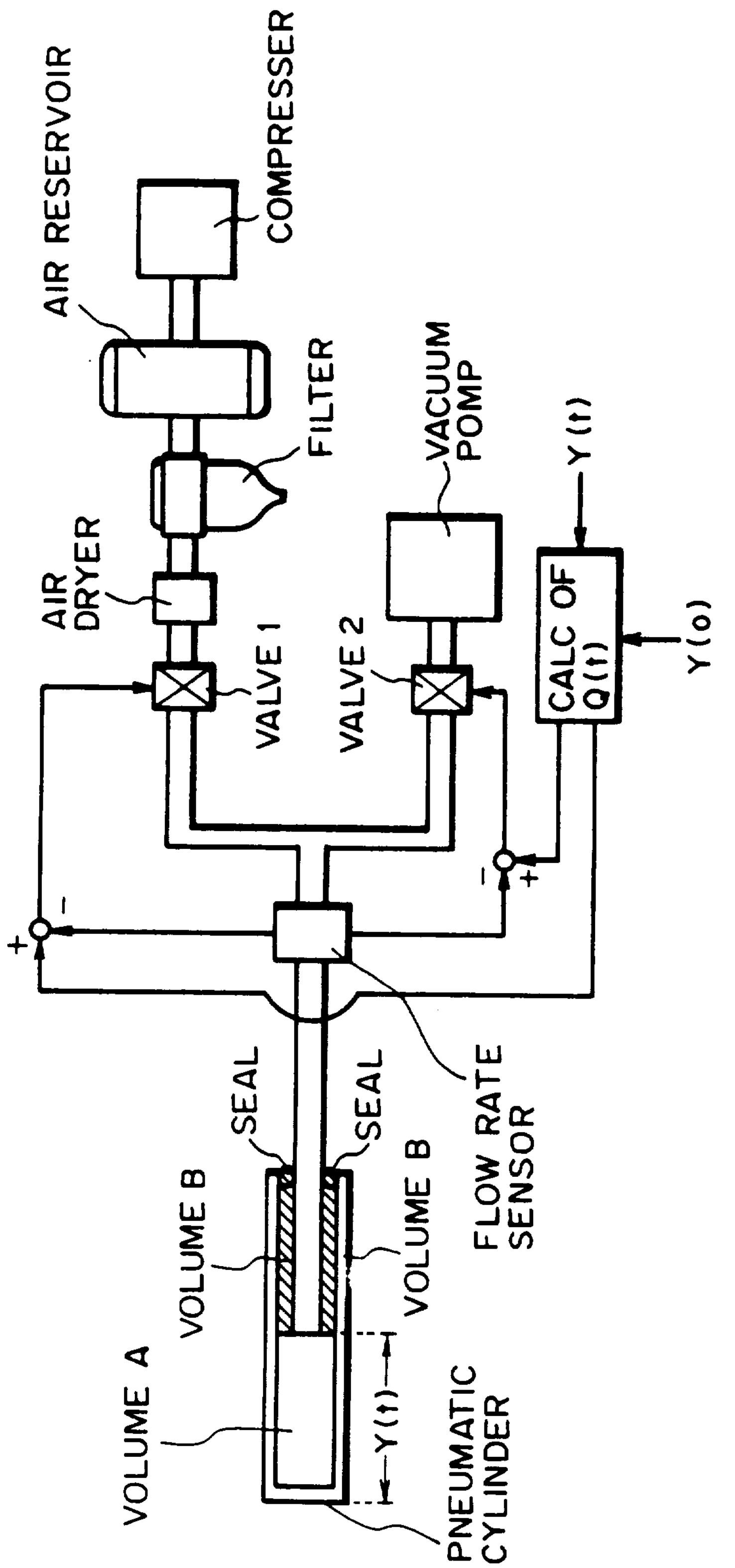
AIR RESERVOIR
COMPRESSER
FILTER
VACUUM POMP
AIR DRYER
VALVE 1
VALVE 2
CALC OF Q(t)
Y(t)
Y(o)
SEAL
SEAL
VOLUME A
VOLUME B
VOLUME B
FLOW RATE SENSOR
Y(t)
PNEUMATIC CYLINDER

FIG. 55

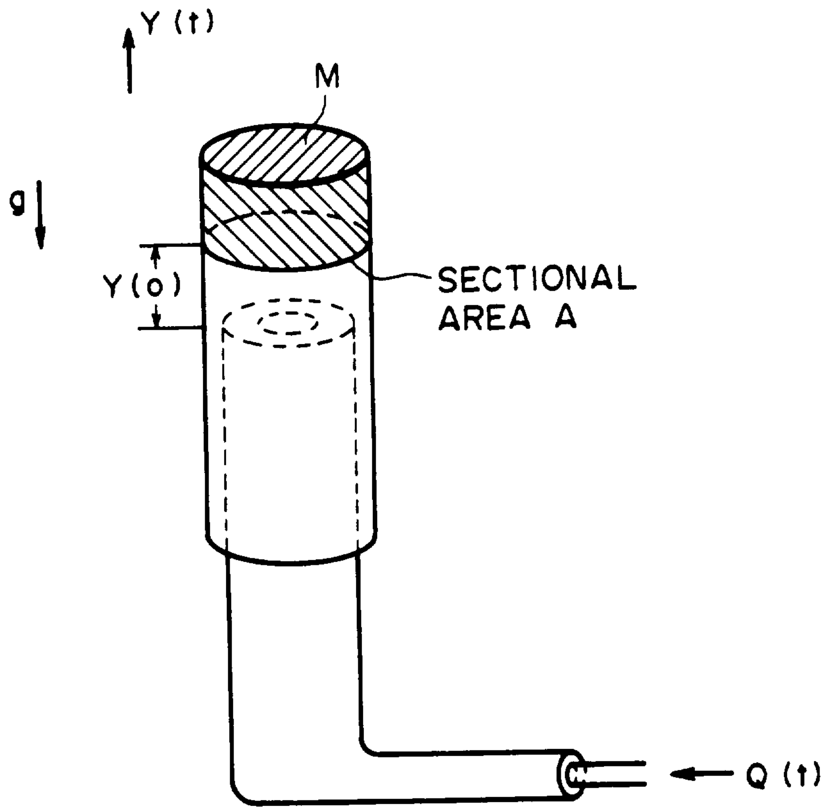
Y (t)
M
g
Y (o)
SECTIONAL
AREA A
Q (t)

FIG. 56

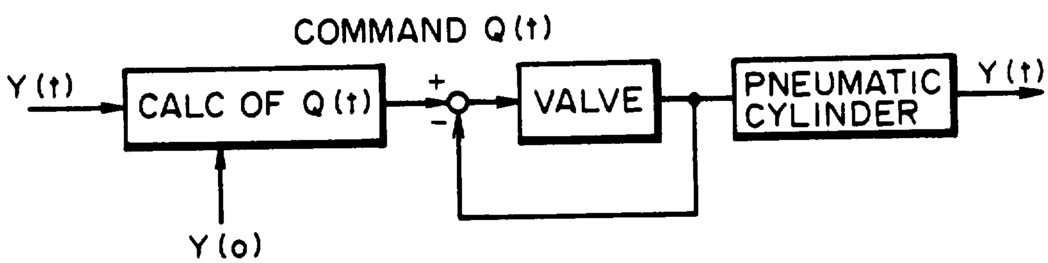
COMMAND Q (t)
Y (t)
CALC OF Q (t)
+
-
VALVE
PNEUMATIC
CYLINDER
Y (t)
Y (o)

FIG. 57

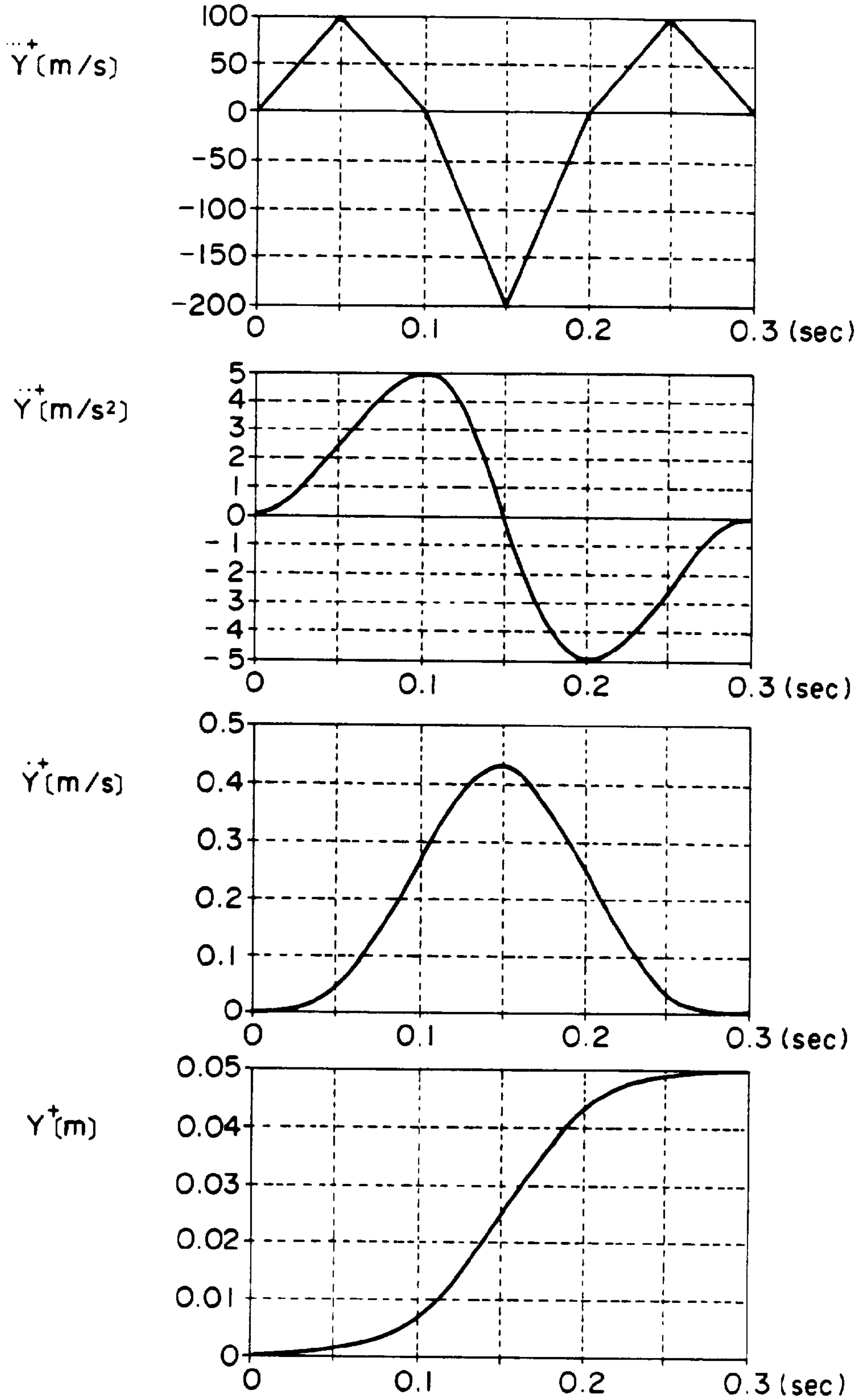

Y⃛+(m/s)
100
50
0
-50
-100
-150
-200
0
0.1
0.2
0.3 (sec)
Ÿ+(m/s²)
5
4
3
2
1
0
-1
-2
-3
-4
-5
0
0.1
0.2
0.3 (sec)
Ẏ+(m/s)
0.5
0.4
0.3
0.2
0.1
0
0
0.1
0.2
0.3 (sec)
Y+(m)
0.05
0.04
0.03
0.02
0.01
0
0
0.1
0.2
0.3 (sec)


FIG. 58

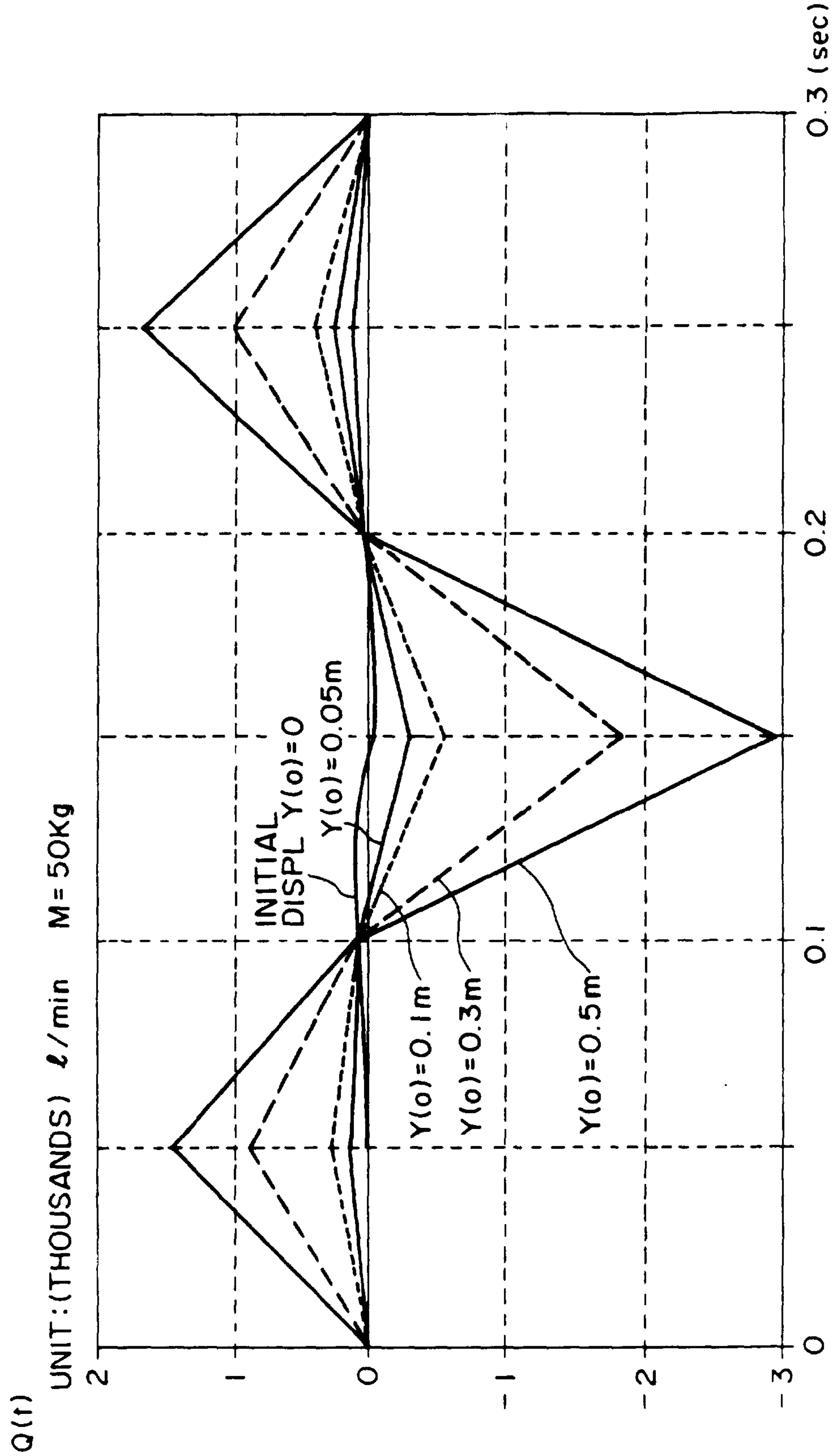
Q(t)
UNIT: (THOUSANDS) ℓ/min M = 50Kg
INITIAL DISPL Y(o) = 0
Y(o) = 0.05m
Y(o) = 0.1m
Y(o) = 0.3m
Y(o) = 0.5m
2
1
0
-1
-2
-3
0
0.1
0.2
0.3 (sec)

FIG. 59

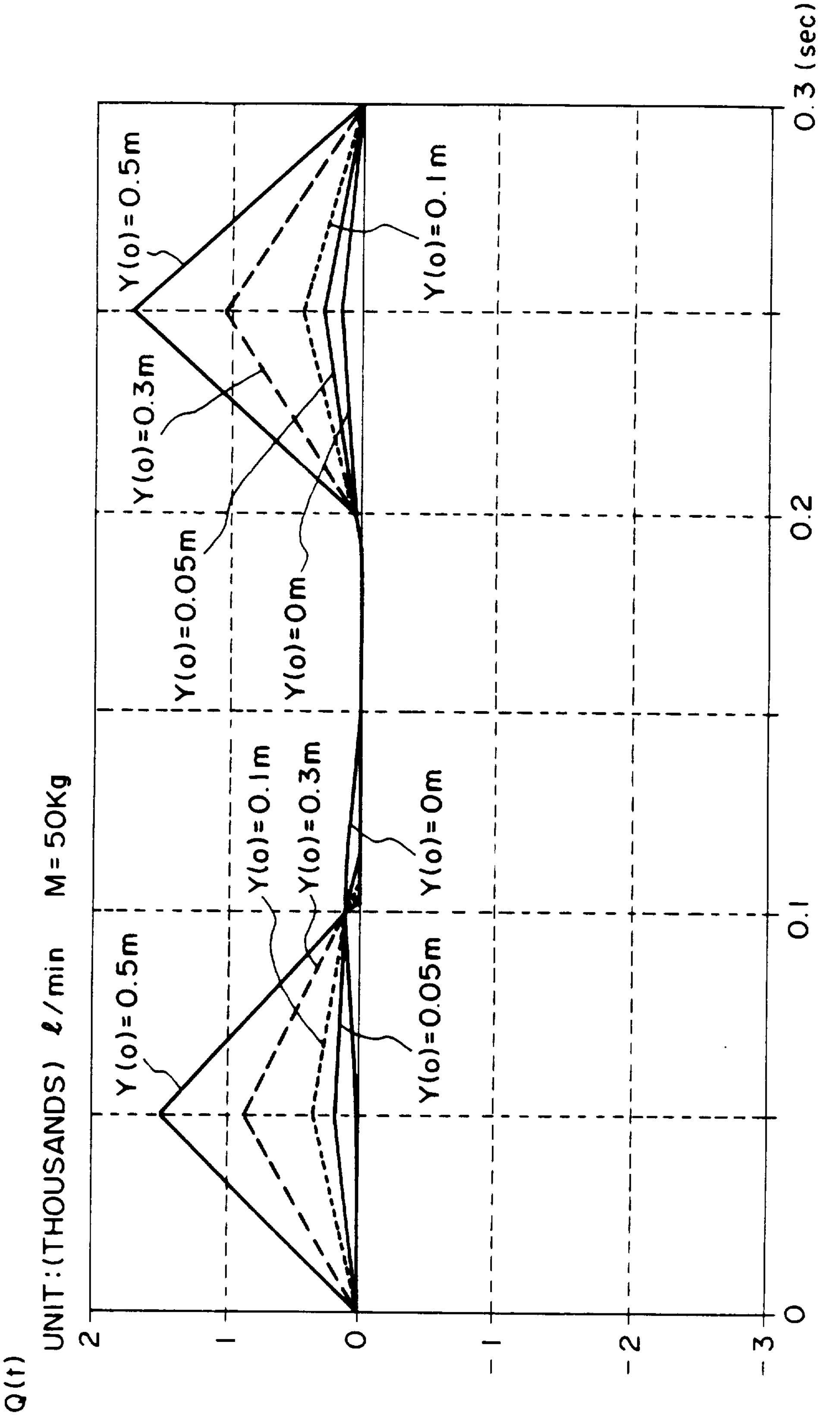
Q(t)
UNIT:(THOUSANDS) ℓ/min M=50Kg
2
1
0
-1
-2
-3
0
0.1
0.2
0.3 (sec)
Y(o)=0.5m
Y(o)=0.1m
Y(o)=0.3m
Y(o)=0.05m
Y(o)=0m
Y(o)=0.5m
Y(o)=0.3m
Y(o)=0.05m
Y(o)=0m
Y(o)=0.1m

FIG. 60

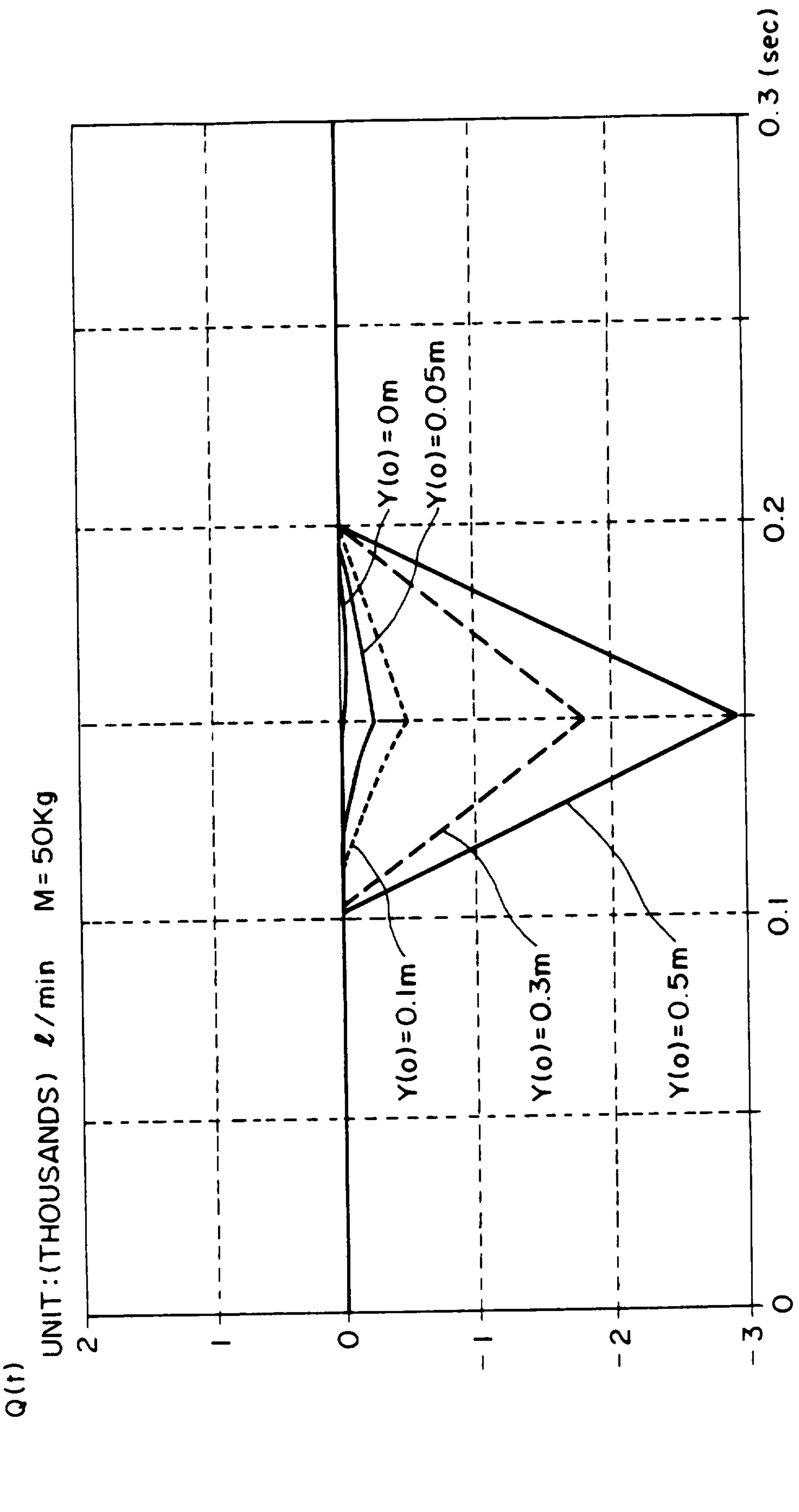
Q(t)
UNIT : (THOUSANDS) ℓ/min M= 50Kg
2
1
0
-1
-2
-3
0
0.1
0.2
0.3 (sec)
Y(o)=0m
Y(o)=0.05m
Y(o)=0.1m
Y(o)=0.3m
Y(o)=0.5m

FIG. 61

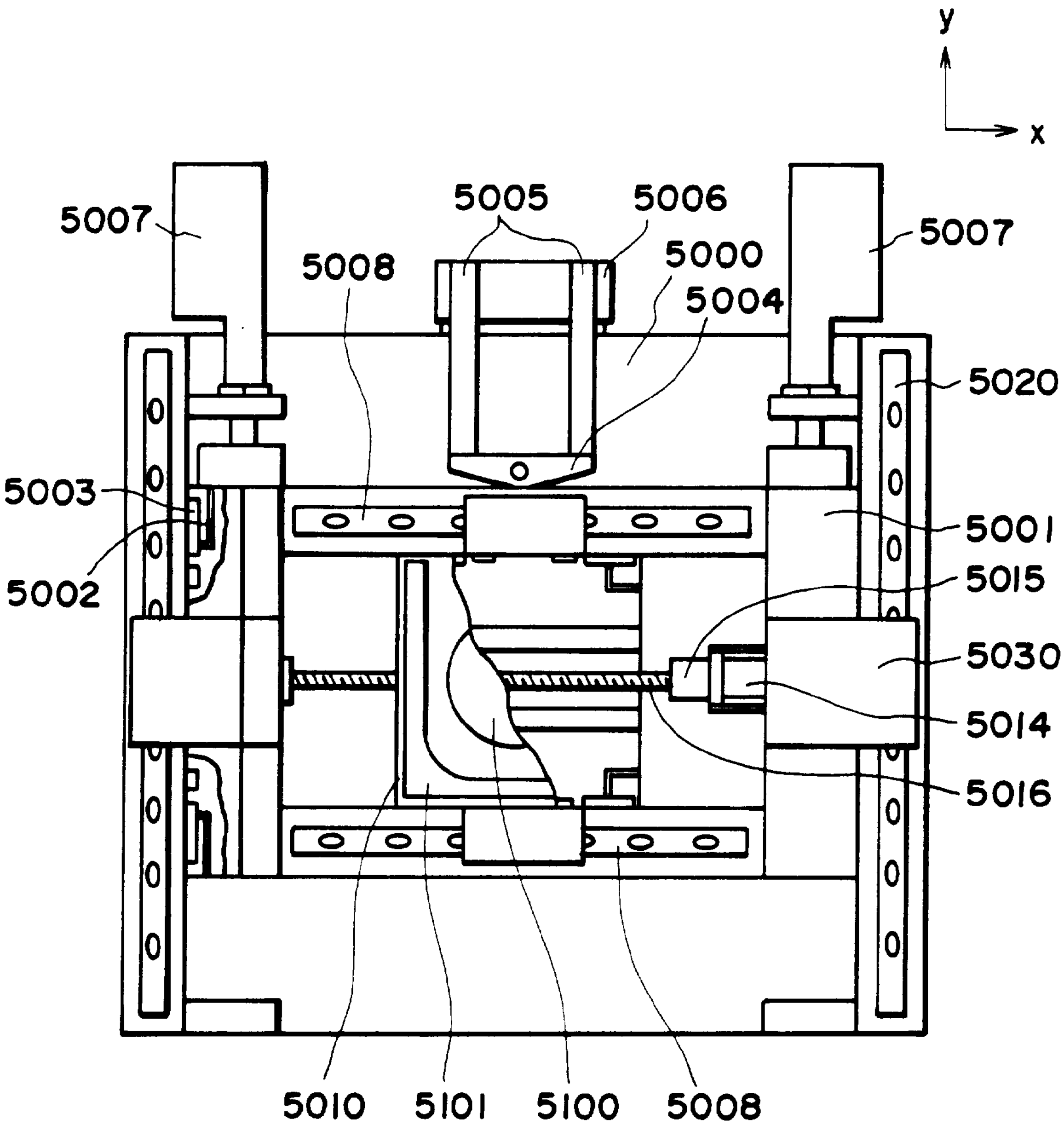
y
x
5007
5005
5006
5007
5008
5000
5004
5020
5003
5001
5002
5015
5030
5014
5016
5010
5101
5100
5008

FIG. 62

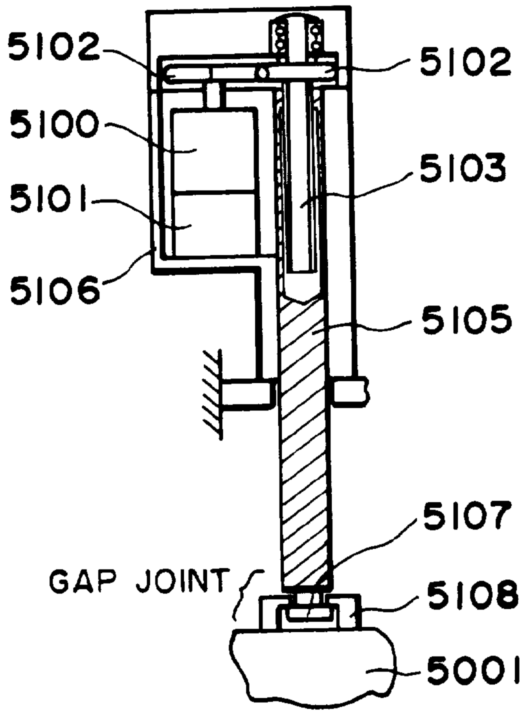
5102
5102
5100
5103
5101
5106
5105
5107
GAP JOINT
5108
5001

FIG. 63

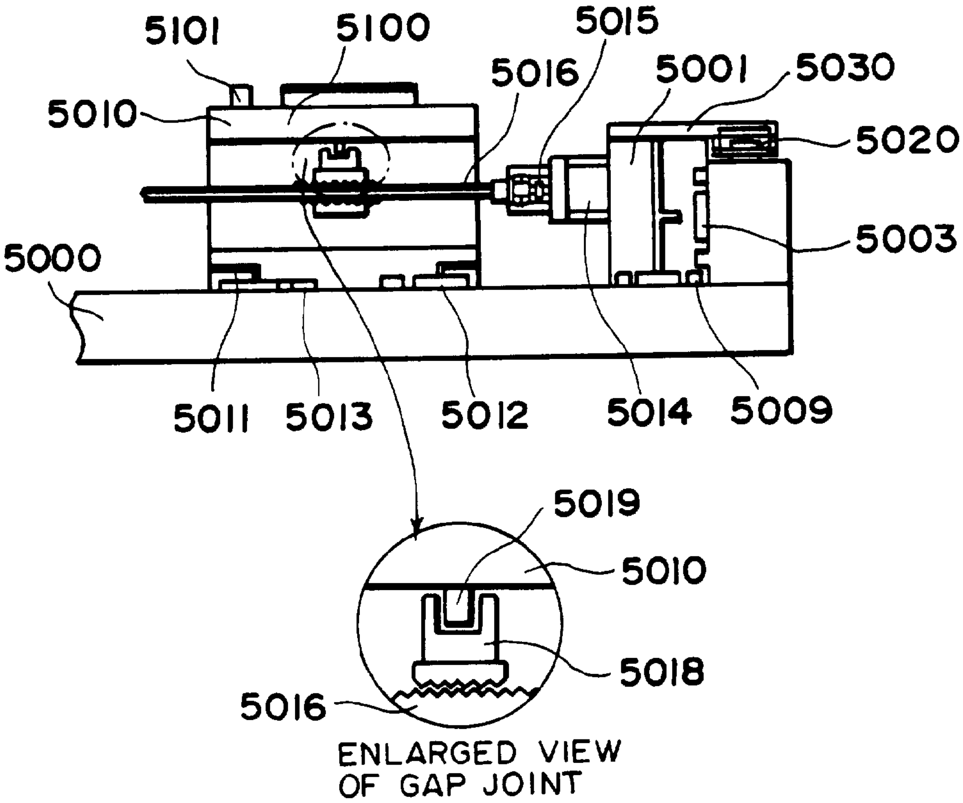
5101
5100
5015
5016
5001
5030
5010
5020
5003
5000
5011
5013
5012
5014
5009
5019
5010
5018
5016
ENLARGED VIEW
OF GAP JOINT

FIG. 64

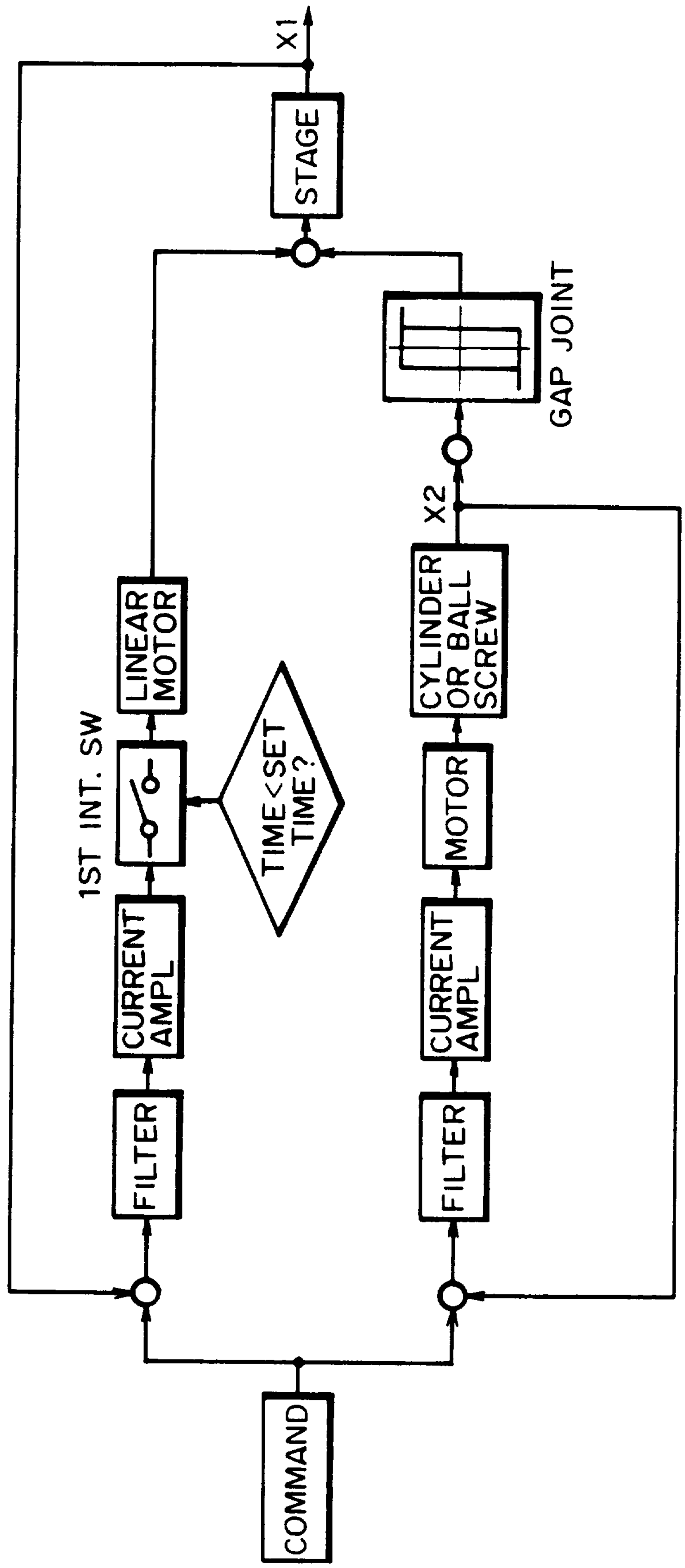
COMMAND
FILTER
CURRENT AMPL
1ST INT. SW
TIME<SET TIME?
LINEAR MOTOR
STAGE
X1
FILTER
CURRENT AMPL
MOTOR
CYLINDER OR BALL SCREW
X2
GAP JOINT

FIG. 65

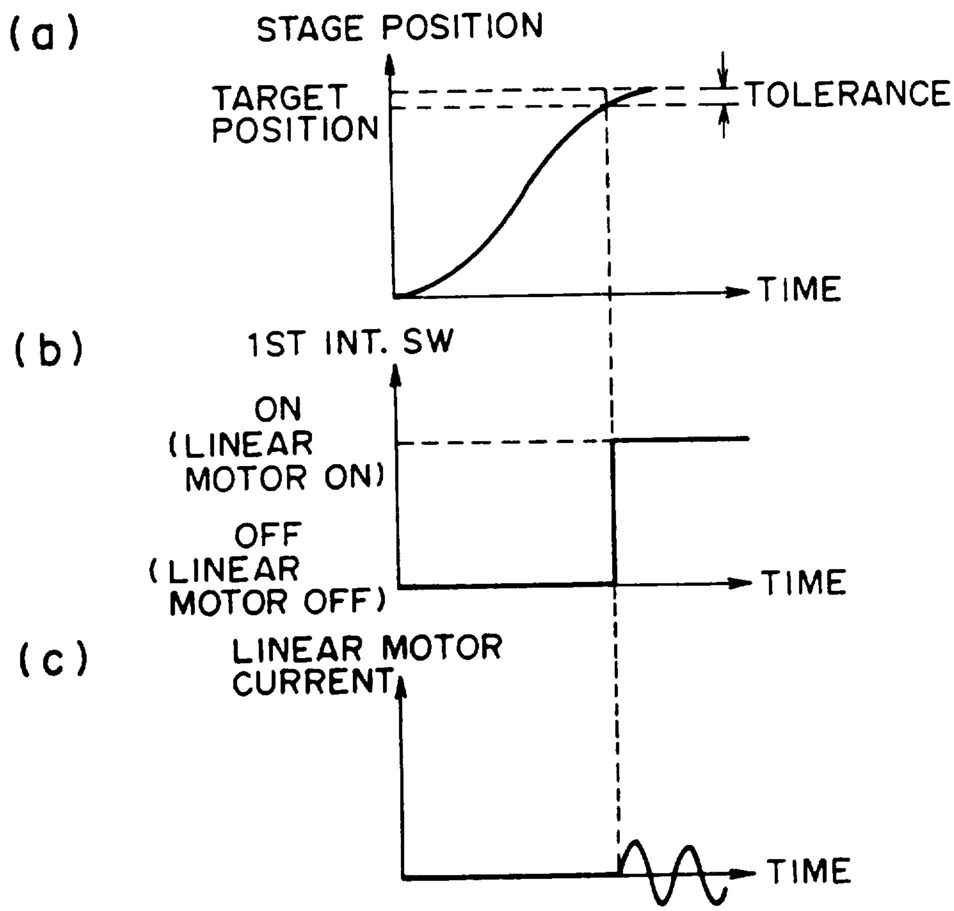
(a)
STAGE POSITION
TARGET POSITION
TOLERANCE
TIME
(b)
1ST INT. SW
ON (LINEAR MOTOR ON)
OFF (LINEAR MOTOR OFF)
TIME
(c)
LINEAR MOTOR CURRENT
TIME

FIG. 66

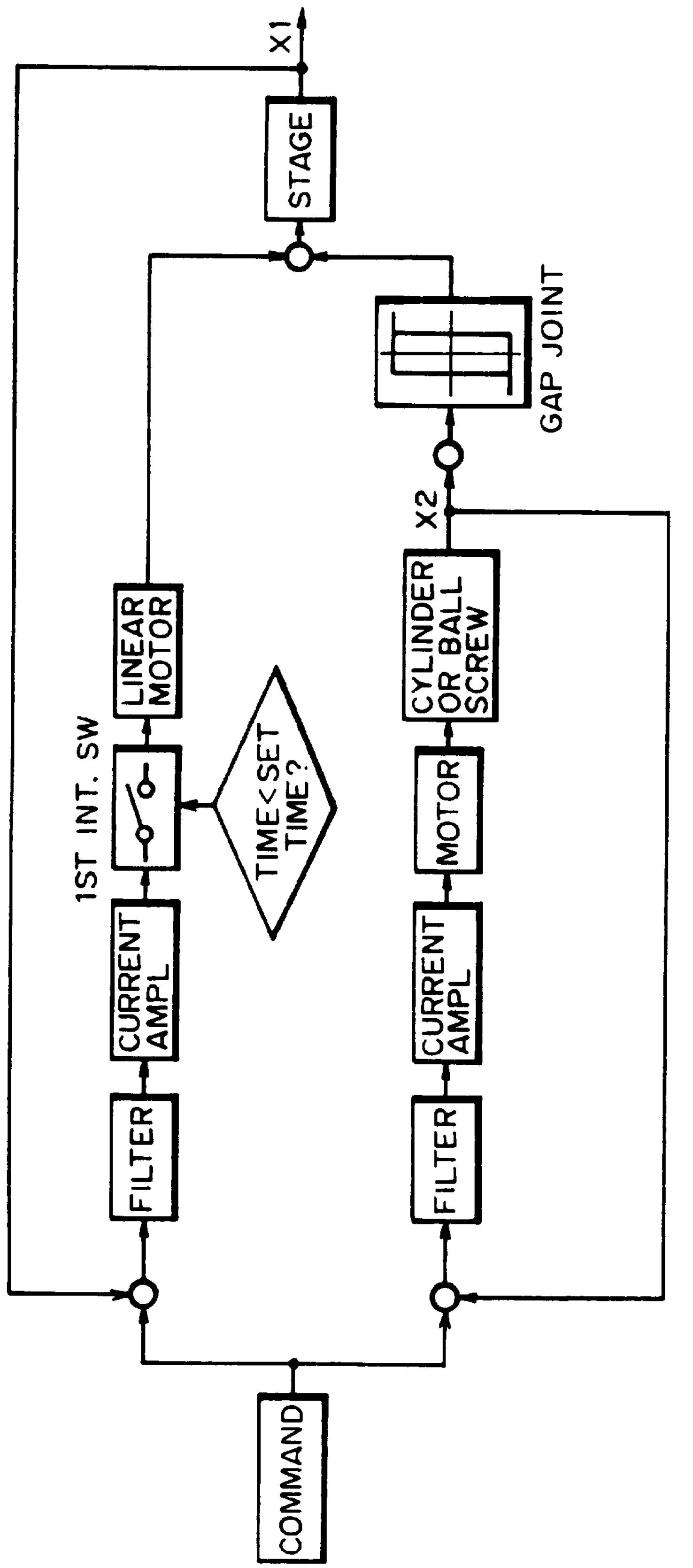
COMMAND
FILTER
CURRENT AMPL
1ST INT. SW
TIME<SET TIME?
LINEAR MOTOR
STAGE
X1
FILTER
CURRENT AMPL
MOTOR
CYLINDER OR BALL SCREW
X2
GAP JOINT

FIG. 67

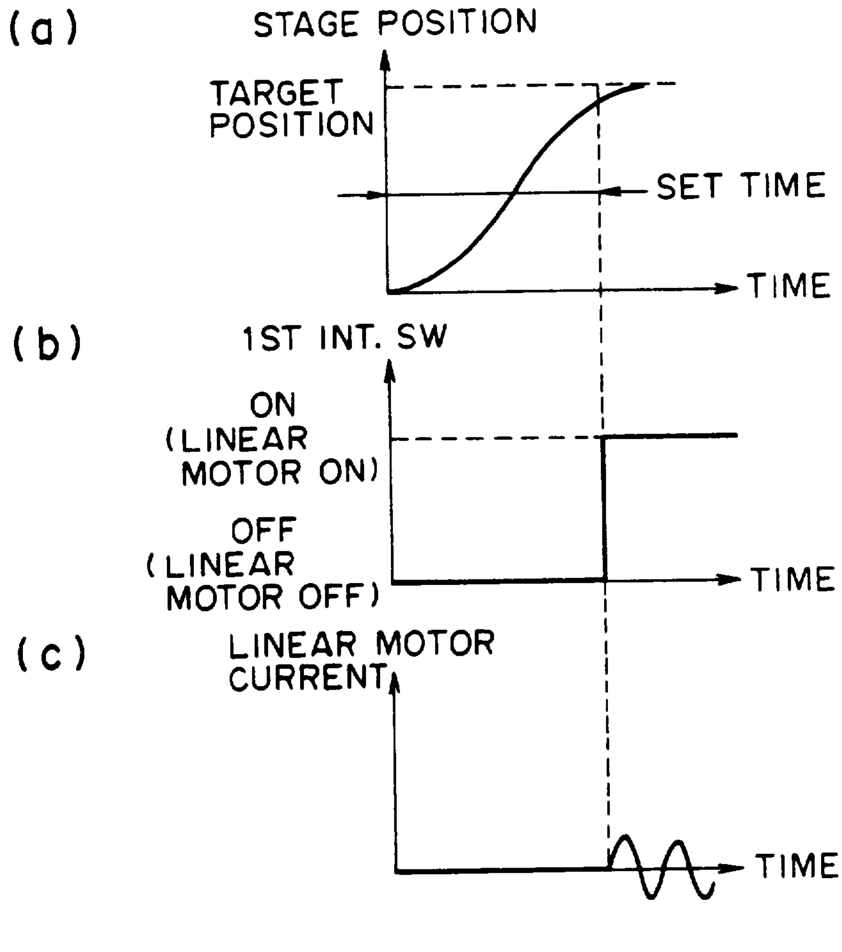
(a)
STAGE POSITION
TARGET POSITION
SET TIME
TIME
(b)
1ST INT. SW
ON (LINEAR MOTOR ON)
OFF (LINEAR MOTOR OFF)
TIME
(c)
LINEAR MOTOR CURRENT
TIME

FIG. 68

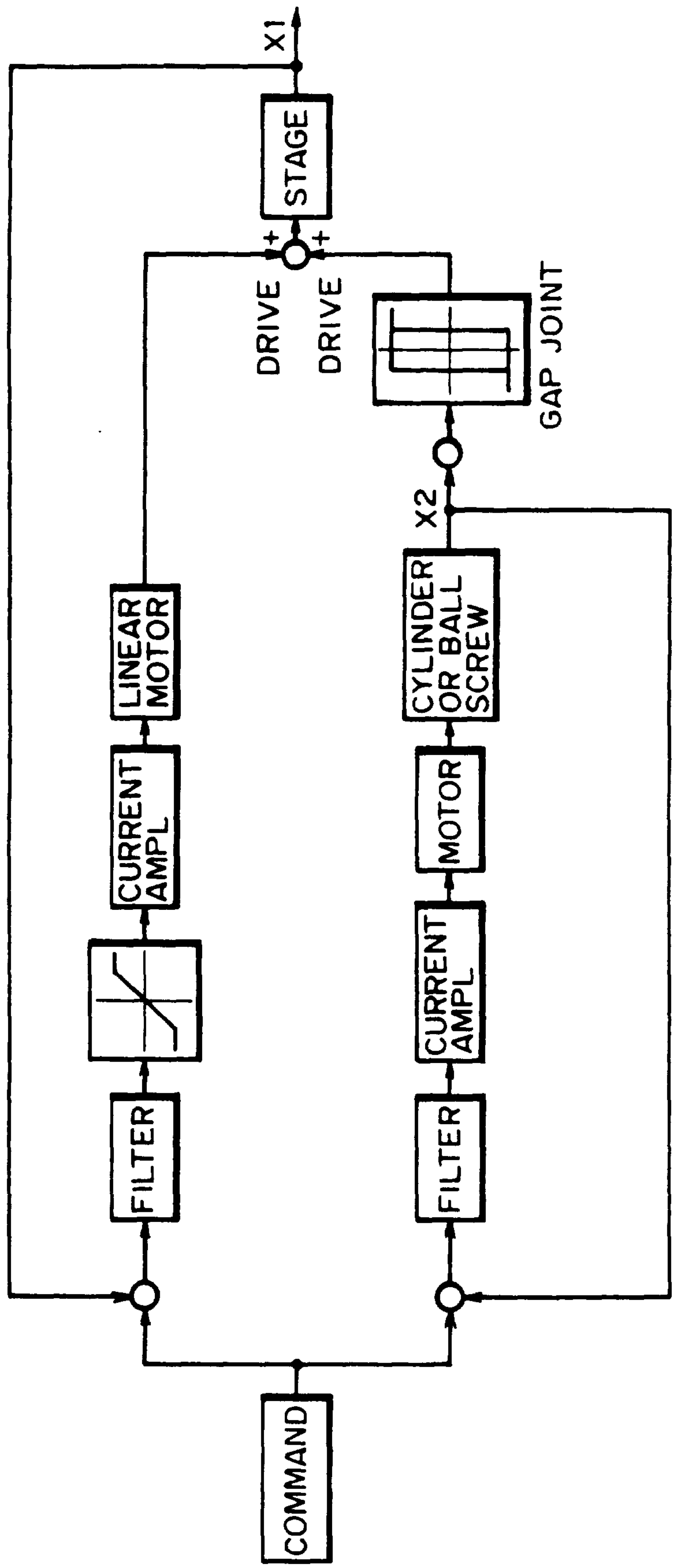
COMMAND
FILTER
CURRENT AMPL
LINEAR MOTOR
DRIVE
+
STAGE
X1
FILTER
CURRENT AMPL
MOTOR
CYLINDER OR BALL SCREW
X2
GAP JOINT
DRIVE
+

FIG. 69

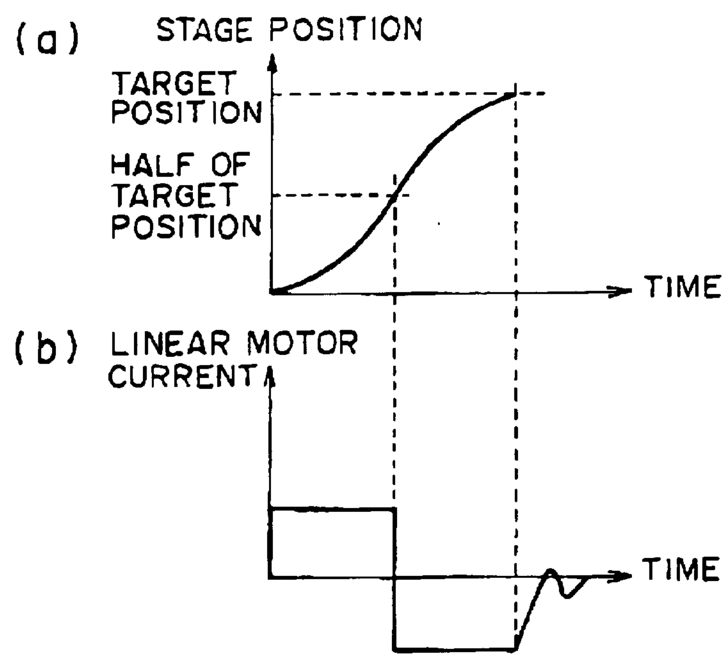
(a)
STAGE POSITION
TARGET POSITION
HALF OF TARGET POSITION
TIME
(b)
LINEAR MOTOR CURRENT
TIME

FIG. 70

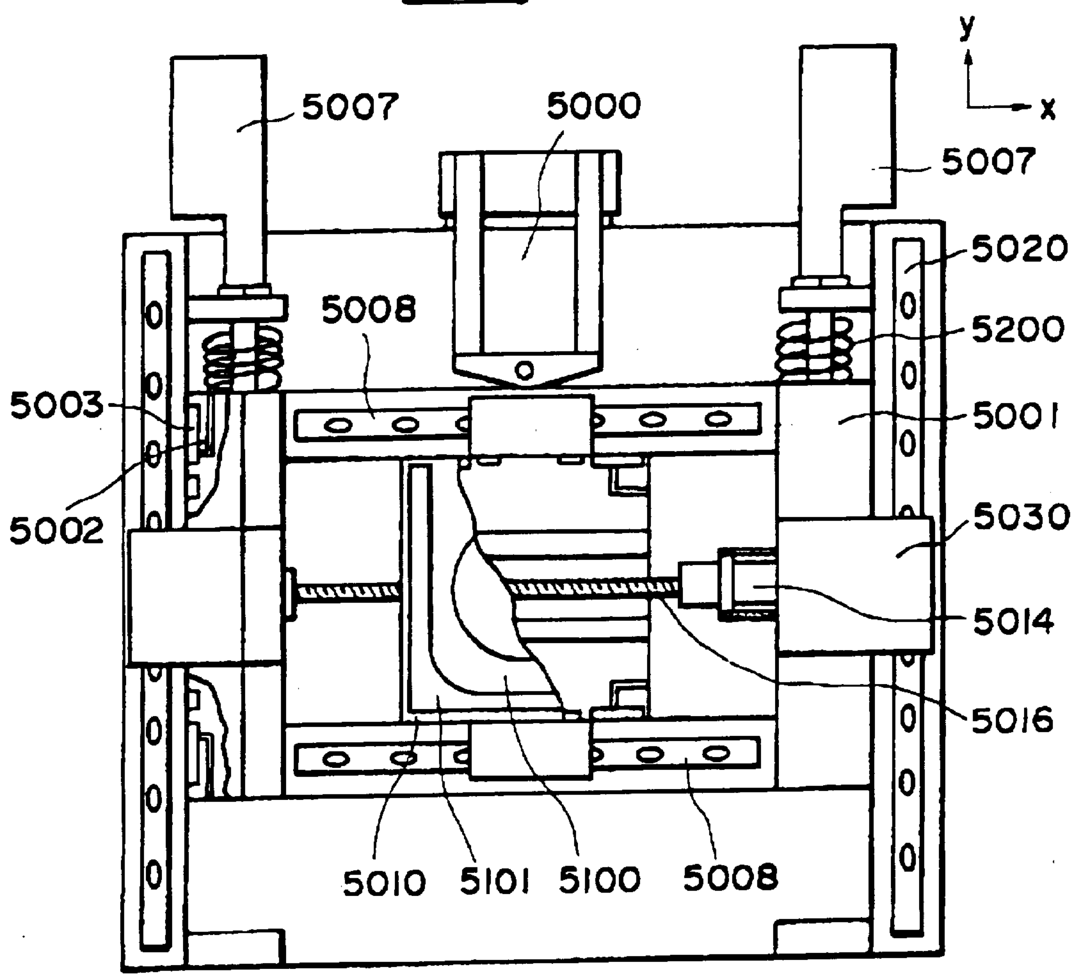
y
x
5007
5000
5007
5020
5008
5200
5003
5001
5002
5030
5014
5016
5010
5101
5100
5008

FIG. 71

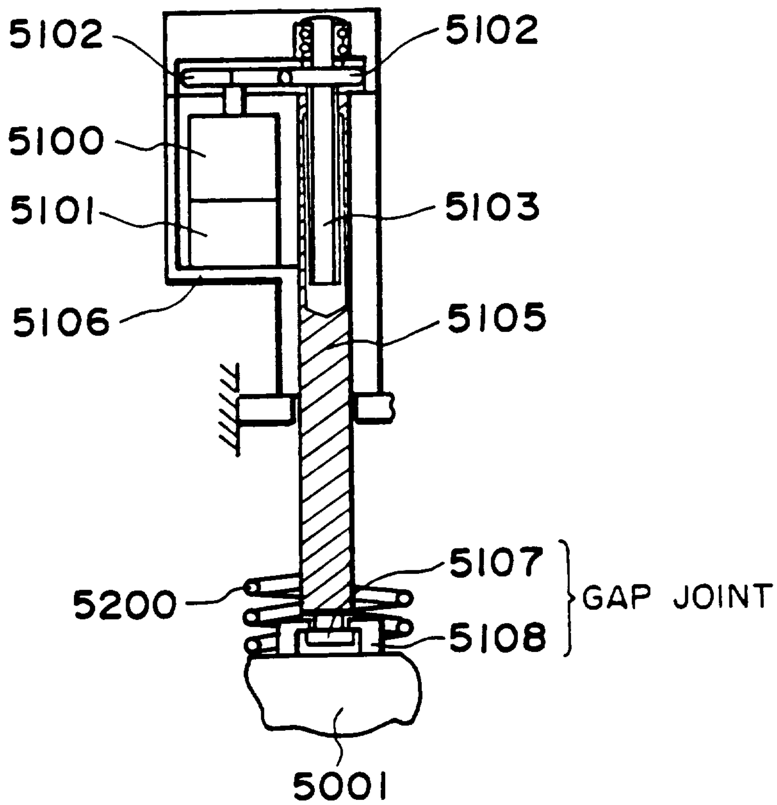
5102
5102
5100
5101
5103
5106
5105
5107
5200
GAP JOINT
5108
5001

FIG. 72

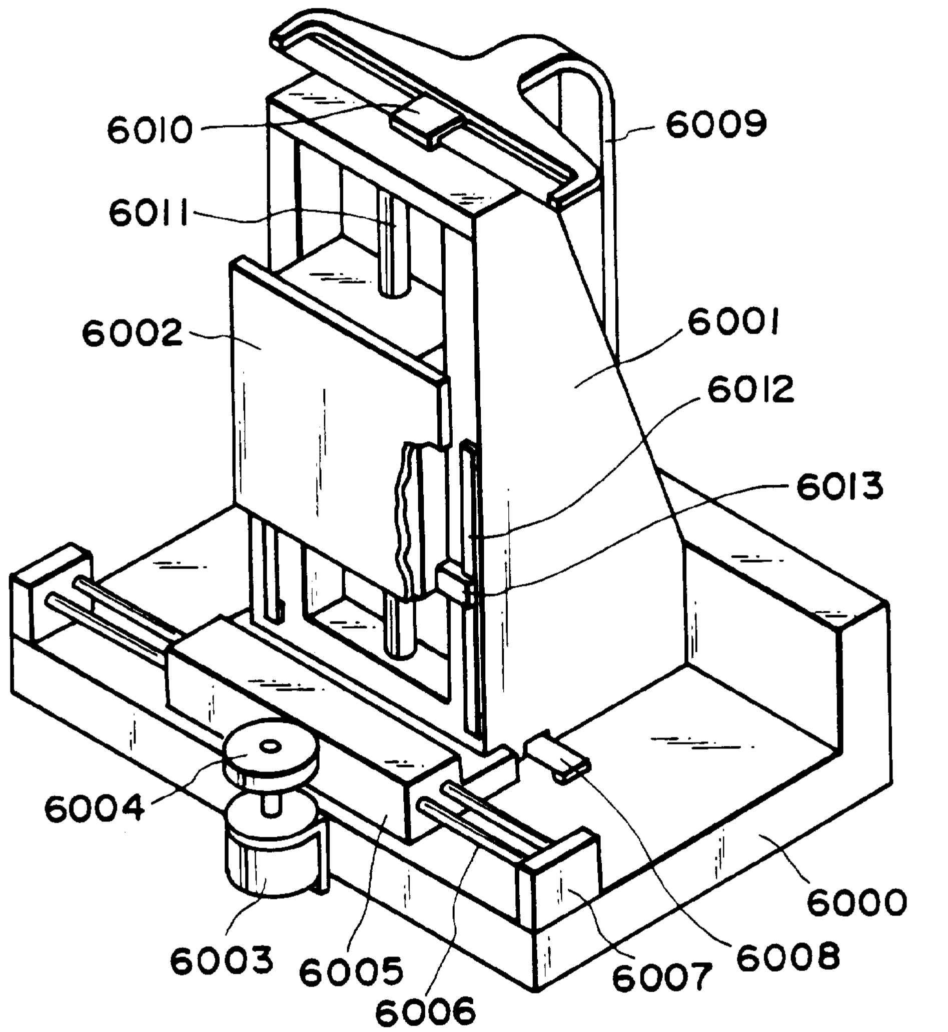
6010
6009
6011
6002
6001
6012
6013
6004
6000
6003
6005
6006
6007
6008

FIG. 73

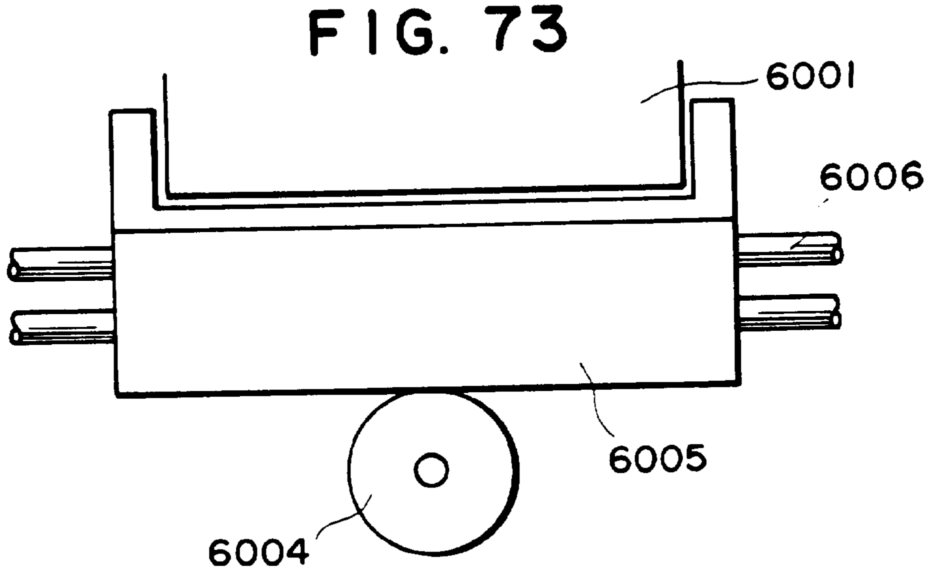
6001
6006
6005
6004

FIG. 74

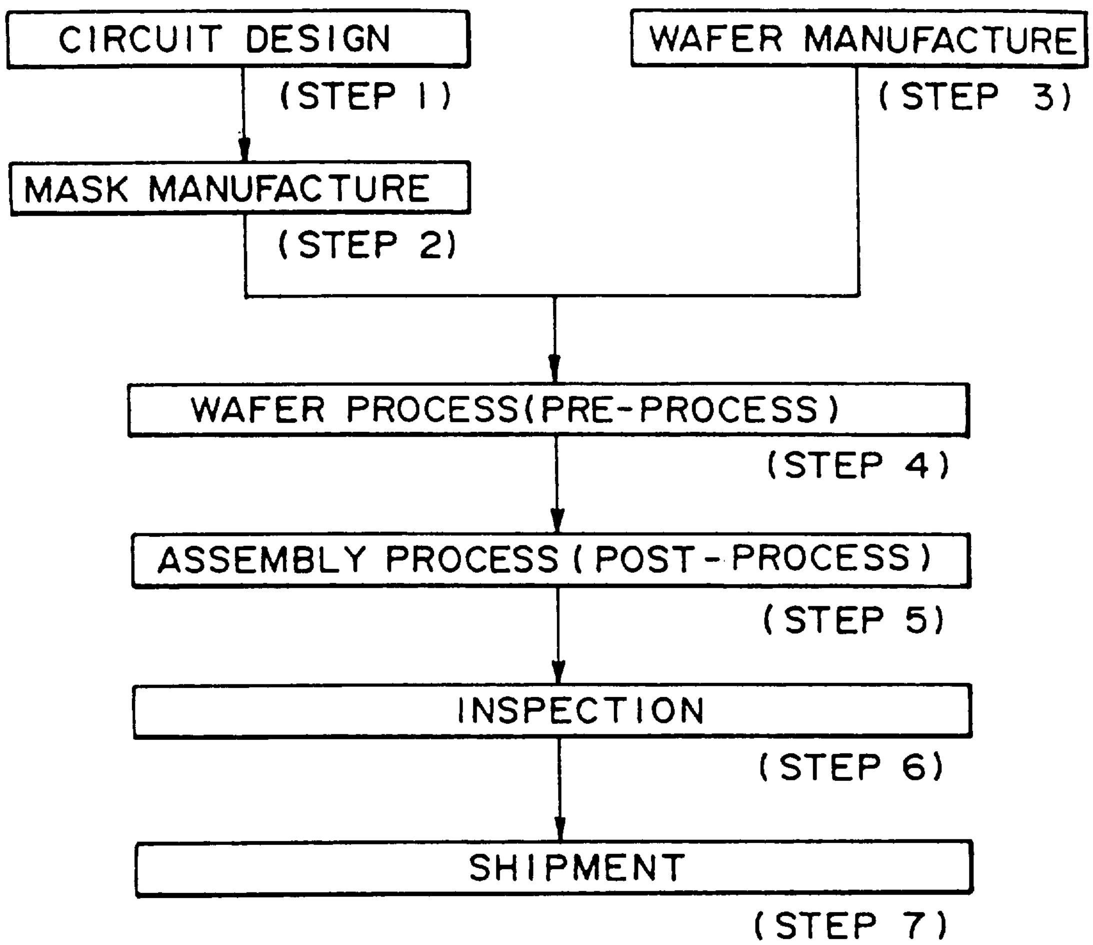
CIRCUIT DESIGN
(STEP 1)
WAFER MANUFACTURE
(STEP 3)
MASK MANUFACTURE
(STEP 2)
WAFER PROCESS(PRE-PROCESS)
(STEP 4)
ASSEMBLY PROCESS (POST-PROCESS)
(STEP 5)
INSPECTION
(STEP 6)
SHIPMENT
(STEP 7)

FIG. 75

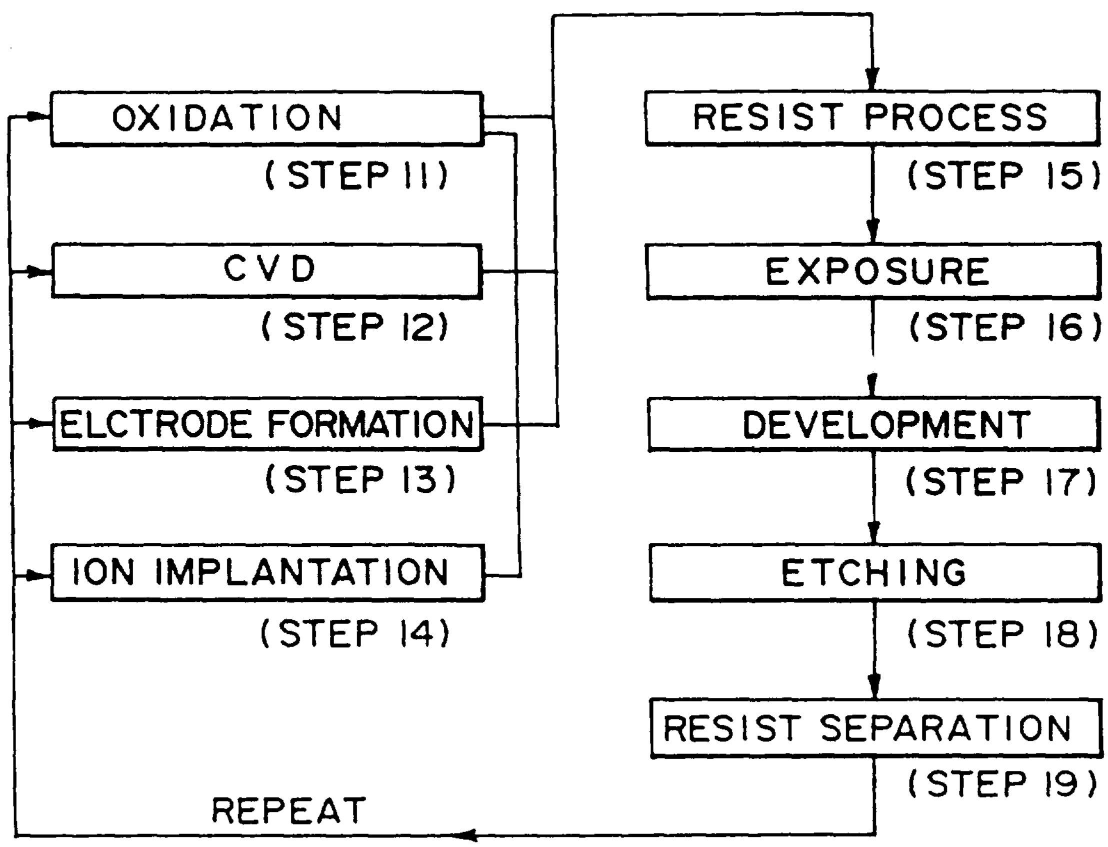
OXIDATION
(STEP 11)
CVD
(STEP 12)
ELCTRODE FORMATION
(STEP 13)
ION IMPLANTATION
(STEP 14)
RESIST PROCESS
(STEP 15)
EXPOSURE
(STEP 16)
DEVELOPMENT
(STEP 17)
ETCHING
(STEP 18)
RESIST SEPARATION
(STEP 19)
REPEAT

FIG. 76